# EUROPEAN PATENT APPLICATION

(11) **EP 3 989 246 A1**
(43) Date of publication of application: **27.04.2022**
(21) Application number: 21188492.9
(22) Date of filing: 29.07.2021
(51) Int. Cl.: H01F 27/28, H01F 27/26, H01F 41/04

(54) **MAGNETIC ELEMENT AND MANUFACTURING METHOD THEREOF**

(30) Priority: 22.10.2020 CN 202011139866
(71) Applicant: Delta Electronics (Shanghai) Co., Ltd., Shanghai 201209 (CN)
(72) Inventor: Hong, Shouyu, Shanghai, 201209 (CN); Chen, Qingdong, Shanghai, 201209 (CN); Fu, Zhiheng, Shanghai, 201209 (CN); Zhou, Ganyu, Shanghai, 201209 (CN); Tong, Yan, Shanghai, 201209 (CN); Han, Wen, Shanghai, 201209 (CN); Zhou, Jinping, Shanghai, 201209 (CN); Ji, Pengkai, Shanghai, 201209 (CN); Ye, Yiqing, Shanghai, 201209 (CN)
(74) Representative: Uexküll & Stolberg

(57) **Abstract**

A magnetic element (1, 1a, 1b, 1c, Id, 1e, If, 1g, 1h, 1i, 1j, 1k, 1m, In, 1o) includes a magnetic core assembly (2) and a winding assembly. The magnetic core assembly (2) includes a first magnetic part (21) and a second magnetic part (22) arranged independently. The winding assembly includes a first winding. The first winding is wound around the first magnetic part (21). Moreover, at least a portion of a substrate (3) is formed as the first winding. The substrate (3) includes a first accommodation space (31), a second accommodation space (32) and a first metal structure (34). Moreover, at least a portion of the first metal structure (34) is formed as at least a portion of the first winding. At least a portion of the first magnetic part (21) and at least a portion of the second magnetic part (22) are disposed within the first accommodation space (31) and the second accommodation space (32), respectively. The substrate (3) has an integral structure.

## Description

### FIELD OF THE INVENTION

The present invention relates to a magnetic element and a method of manufacturing the magnetic element, and more particularly to a magnetic element with low magnetic loss and high precision of dimension and a method of manufacturing the magnetic element.

### BACKGROUND OF THE INVENTION

As the human's demands on smart life are gradually increased, the data processing capability becomes more important. Consequently, it is important to develop a data center with high efficiency and high power density.

Conventionally, the data center uses servers to process data. A main board of the server is usually equipped with central processing units, chipsets, memories, power supplies and the essential peripheral components. As the demands on the data processing capability of the server are increased, the number and the integration of the data processing chips are increased. In other words, the space within the server is almost occupied by the data processing chips, and the power consumption of the server increases. Therefore, the power supply for the data processing chips should be operated with high efficiency and high power density. Moreover, the volume of the power supply should be designed as small as possible. Consequently, the overall volume of the server is reduced, and the power-saving efficacy of the data center is achieved. For meeting the high power density requirement, the switching frequency of the power supply is correspondingly increased.

Consequently, the power supply is operated at a low voltage and a high current according to the higher switching frequency. However, when a magnetic element is applied to the low-voltage and high-current power supply, the power density and the conversion efficiency of the magnetic element are still low. In other words, it is important to develop a magnetic element with high power density and high conversion efficiency in order to be applied to the data center.

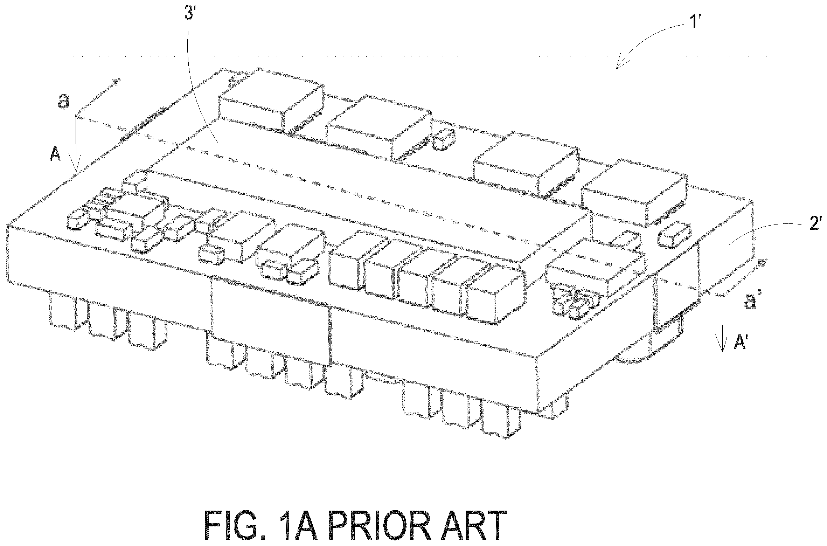

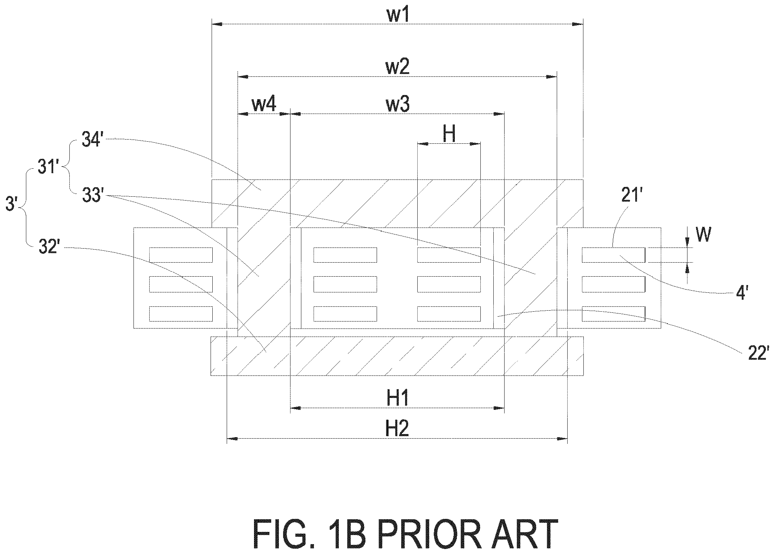

Please refer to FIGS. 1A and 1B. FIG. 1A is a schematic perspective view illustrating the structure of a conventional magnetic element. FIG. 1B is a schematic cross-sectional view illustrating the magnetic element as shown in FIG. 1A and taken along the line A-A'. The conventional magnetic element 1' is formed through a horizontal winding process. The conventional magnetic element 1' includes a substrate 2', a magnetic core 3' and a plurality of windings 4'. The windings 4' are formed in corresponding wiring layers 21' of the substrate 2'. The magnetic core 3' passes through the substrate 2'. The magnetic core 3' and the substrate 2' are perpendicular or nearly perpendicular to each other. That is, the magnetic core 3' and the wiring layer 21' of the substrate 2' are perpendicular or nearly perpendicular to each other. As shown in FIG. 1B, the wiring layer 21' has a thickness W and a width H, wherein the width H is greater than ten times the thickness W (i.e., H>10W). This kind of wiring-layer metal winding is generally referred to as a wiring-layer metal winding with a vertical-winding structure. Generally, the impedance of portions of the winding 4' away from the magnetic core and the impedance of portions of the winding 4' close to the magnetic core are different. Consequently, the current distribution is not uniform.

The magnetic core 3' of the magnetic element 1' includes a U-shaped magnetic part 31' and an I-shaped magnetic part 32'. The U-shaped magnetic part 31' is penetrated through two receiving holes 22' and connected with the I-shaped magnetic part 32'. The U-shaped magnetic part 31' includes two vertical legs 33' and a horizontal leg 34'. The two vertical legs 33' are disposed through the substrate 2'. The horizontal leg 34' is connected between the two vertical legs 33'. The length of the horizontal leg 34' is w1. The distance between the outer sides of the two vertical legs 33' is w2. The distance between the inner sides of the two receiving holes 22' is H1. The distance between the outer sides of the two receiving holes 22' is H2. For increasing the production efficiency, the magnetic core 3' is produced through molds. After the magnetic core 3' is produced, the surfaces of the magnetic core 3' are finely polished to increase the precision of the dimension. Take the U-shaped magnetic part 31' for example. After the U-shaped magnetic part 31' is formed, the surface of the U-shaped magnetic part 31' is polished. For example, the two lateral surfaces of the horizontal leg 34' are polished. However, since the U-shaped magnetic part 31' has an integral structure, the arrangement of the horizontal leg 34' influences the process of finely polishing the outer surfaces of the vertical legs 33'. Consequently, the tolerance is accumulated. Generally, the outer sides of the two vertical legs 33' are retracted relative to the lateral sides of the horizontal leg 34'. Consequently, it is difficult to finely polish the outer sides of the two vertical legs 33'. The lateral sides of the horizontal leg 34' are readily damaged when the outer sides of the two vertical legs 33' are polished. Similarly, it is difficult to finely polish the inner sides of the vertical legs 33'. In other words, the tolerance of the dimension is very large.

Please refer to FIG. 1B again. The distance between the inner sides of the two vertical legs 33' is w3. The width of each vertical leg 33' is w4. In case that the tolerance of the distance w2 between the outer sides of the two vertical legs 33', the tolerance of the distance w3 between the inner sides of the two vertical legs 33' and the tolerance of the width w4 of each vertical leg 33' are all +/-0.2mm, the receiving hole 22' corresponding to the U-shaped magnetic part 31' needs to be large. That is, the distance H2 between the outer sides of the receiving holes 22' needs to be greater than the maximum distance w2 between the outer sides of the two vertical legs 33'. Similarly, the distance H1 between the inner sides of the receiving holes 22' needs to be smaller than the minimum distance w3 between the inner sides of the two vertical legs 33'. During the practical wiring process, the distance H1 between the inner sides of the receiving holes 22' is reduced because of the tolerance of the distance w3. Consequently, the wiring space is reduced, and the wiring flexibility is reduced. Since the winding between the two receiving holes 22' needs to have a certain width, the distance w2 between the outer sides of the two vertical legs 33' needs to be large enough. In other words, the tolerance of the length w1 of the horizontal leg 34' and the tolerance of the distance w2 between the outer sides of the two vertical legs 33' are added to the tolerance of the distance H1 between the inner sides of the receiving holes 22' and the tolerance of the distance H2 between the outer sides of the receiving holes 22'. Consequently, the overall dimension of the substrate 2' is increased, and the power density of the magnetic element 1' is reduced.

Therefore, there is a need of providing a magnetic element and a method of manufacturing magnetic element in order to overcome the drawbacks of the conventional technologies.

### SUMMARY OF THE INVENTION

An object of the present invention provides a magnetic element with low magnetic loss and high dimension precision.

Another object of the present invention provides a method of manufacturing the magnetic element.

In accordance with an aspect of the present invention, a magnetic element is provided. The magnetic element includes a magnetic core assembly and a winding assembly. The magnetic core assembly includes a first magnetic part and a second magnetic part arranged independently. The winding assembly includes a first winding. The first winding is wound around the first magnetic part. Moreover, at least a portion of a substrate is formed as the first winding. The substrate includes a first accommodation space, a second accommodation space and a first metal structure. Moreover, at least a portion of the first metal structure is formed as at least a portion of the first winding. At least a portion of the first magnetic part and at least a portion of the second magnetic part are disposed within the first accommodation space and the second accommodation space, respectively. The substrate has an integral structure.

In accordance with another aspect of the present invention, a method of manufacturing a magnetic element is provided. Firstly, a substrate is provided. The substrate has an integral structure. At least a portion of the substrate is formed as a winding assembly of the magnetic element. The substrate includes a first accommodation space, a second accommodation space and a first metal structure. At least a portion of the first metal structure is formed as at least a portion of a first winding of the winding assembly. Then, a magnetic core assembly with a first magnetic part and a second magnetic part is provided. The first magnetic part and the second magnetic part are arranged independently. At least a portion of the first magnetic part and at least a portion of the second magnetic part are disposed within the first accommodation space and the second accommodation space, respectively. The first winding is wound around the first magnetic part.

From the above descriptions, the present invention provides the magnetic element. The first magnetic part is disposed within the first accommodation space. The second magnetic part is disposed within the second accommodation space. The winding assembly is a three-layered structure. Since the distances between the three layers of the winding assembly and the first magnetic part and the distances between the corresponding layers of the winding assembly and the second magnetic part are nearly equal, the current distribution is more uniform and the overall magnetic loss of the magnetic element is reduced.

The above contents of the present invention will become more readily apparent to those ordinarily skilled in the art after reviewing the following detailed description and accompanying drawings, in which:

### BRIEF DESCRIPTION OF THE DRAWINGS

FIG. 1A is a schematic perspective view illustrating the structure of a conventional magnetic element;
FIG. 1B is a schematic cross-sectional view illustrating the magnetic element as shown in FIG. 1A and taken along the line A-A';
FIG. 2 is a schematic perspective view illustrating a magnetic element according to an embodiment of the present invention;
FIG. 3 is a schematic exploded view illustrating the magnetic element as shown in FIG. 2;
FIG. 4 is a schematic cross-sectional view illustrating the magnetic element as shown in FIG. 2 and taken along the line A-A';
FIG. 5 is a schematic cross-sectional view illustrating the magnetic element as shown in FIG. 2 and taken along the line B-B';
FIG. 6 is a flowchart illustrating a method of fabricating the magnetic element as shown in FIG. 2;
FIG. 7A schematically illustrates a first exemplary method for assembling the substrate and the magnetic core assembly of the magnetic element as shown in FIG. 2;
FIG. 7B schematically illustrates a second exemplary method for assembling the substrate and the magnetic core assembly of the magnetic element as shown in FIG. 2;
FIG. 7C schematically illustrates a third exemplary method for assembling the substrate and the magnetic core assembly of the magnetic element as shown in FIG. 2;
FIG. 7D schematically illustrates a fourth exemplary method for assembling the substrate and the magnetic core assembly of the magnetic element as shown in FIG. 2;
FIG. 7E schematically illustrates a fifth exemplary method for assembling the substrate and the magnetic core assembly of the magnetic element as shown in FIG. 2;
FIG. 7F schematically illustrates a sixth exemplary method for assembling the substrate and the magnetic core assembly of the magnetic element as shown in FIG. 2;
FIGS. 8A to 8G are schematic cross-sectional views illustrating a process of manufacturing a magnetic element according to a first embodiment of the present invention;
FIG. 9A is a schematic cross-sectional view illustrating a first exemplary example of forming the combination of the top plate and the base of the substrate in the step of FIG. 8C;
FIG. 9B is a schematic cross-sectional view illustrating a second exemplary example of forming the combination of the top plate and the base of the substrate in the step of FIG. 8C;
FIG. 9C is a schematic cross-sectional view illustrating a third exemplary example of forming the combination of the top plate and the base of the substrate in the step of FIG. 8C;
FIG. 10 is a schematic cross-sectional view illustrating a magnetic element according to a second embodiment of the present invention;
FIG. 11 is a schematic cross-sectional view illustrating a magnetic element according to a third embodiment of the present invention;
FIGS. 12A to 12G are schematic cross-sectional views illustrating a process of manufacturing a magnetic element according to a fourth embodiment of the present invention;
FIG. 13 is a schematic cross-sectional view illustrating a magnetic element according to a fifth embodiment of the present invention;
FIGS. 14A to 14G are schematic cross-sectional views illustrating a process of manufacturing a magnetic element according to a sixth embodiment of the present invention;
FIGS. 15A to 15G are schematic cross-sectional views illustrating a process of manufacturing a magnetic element according to a seventh embodiment of the present invention;
FIG. 16 is a schematic cross-sectional view illustrating a magnetic element according to an eighth embodiment of the present invention;
FIG. 17 is a schematic cross-sectional view illustrating a magnetic element according to a ninth embodiment of the present invention;
FIGS. 18A to 18F are schematic cross-sectional views illustrating a process of manufacturing a magnetic element according to a tenth embodiment of the present invention;
FIGS. 19A to 19F are schematic cross-sectional views illustrating a process of manufacturing a magnetic element according to an eleventh embodiment of the present invention;
FIGS. 20A to 20E are schematic cross-sectional views illustrating a process of manufacturing a magnetic element according to a twelfth embodiment of the present invention;
FIG. 21A is a schematic top view of the structure as shown in FIG. 20C;
FIG. 21B is a schematic top view of the structure as shown in FIG. 20D;
FIG. 22 is a schematic cross-sectional view illustrating a magnetic element according to a thirteenth embodiment of the present invention;
FIGS. 23A to 23F are schematic cross-sectional views illustrating a process of manufacturing a magnetic element according to a fourteenth embodiment of the present invention;
FIG. 24 is a schematic cross-sectional view illustrating a magnetic element according to a fifteenth embodiment of the present invention;
FIG. 25 is a schematic circuit diagram illustrating a power module with the magnetic element of the present invention;
FIG. 26 is a schematic top view illustrating a top surface of the magnetic element as shown in FIG. 8G;
FIG. 27A schematically illustrates the primary winding and the secondary winding of the magnetic element as shown in FIG. 26 and taken along a viewpoint;
FIG. 27B schematically illustrates the primary winding and the secondary winding of the magnetic element as shown in FIG. 26 and taken along another viewpoint;
FIG. 28 is a schematic cross-sectional view illustrating a first example of the power module as shown in FIG. 25; and
FIG. 29 is a schematic cross-sectional view illustrating a second example of the power module as shown in FIG. 25.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

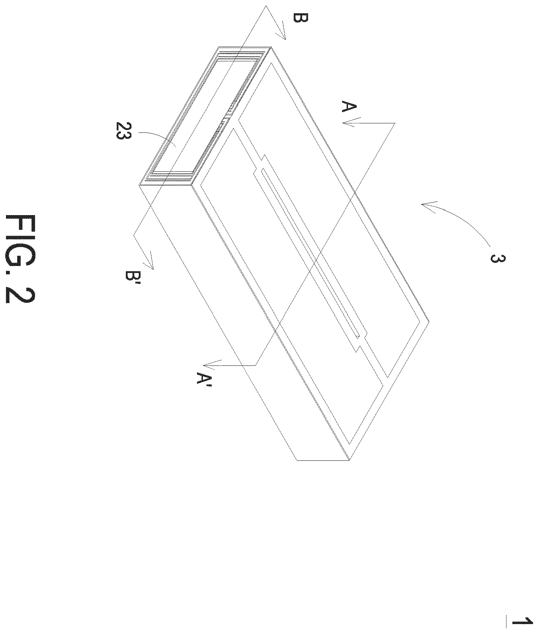

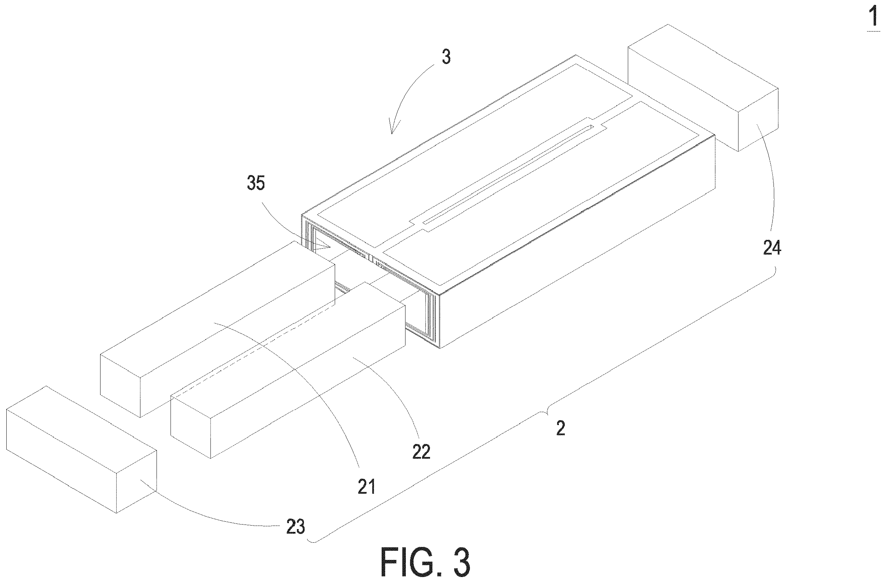

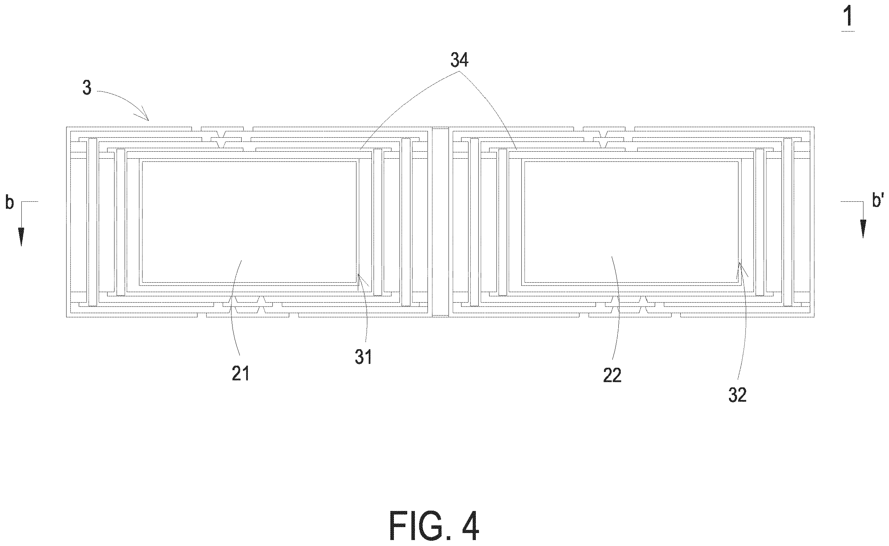

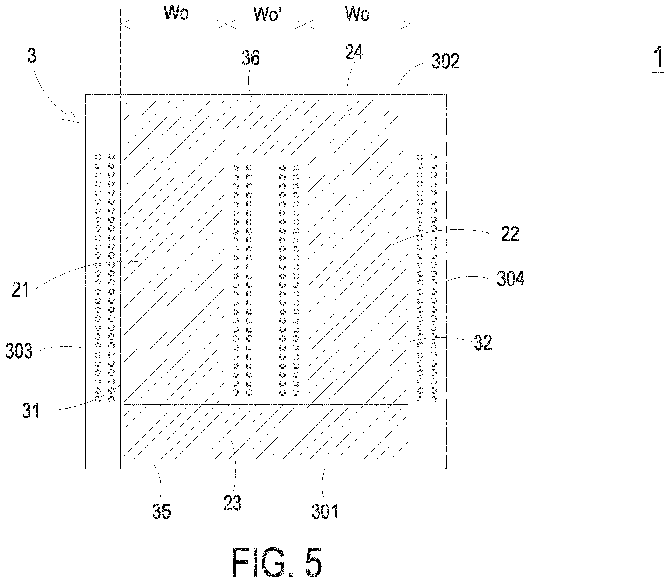

Please refer to FIGS. 2, 3, 4 and 5. FIG. 2 is a schematic perspective view illustrating a magnetic element according to an embodiment of the present invention. FIG. 3 is a schematic exploded view illustrating the magnetic element as shown in FIG. 2. FIG. 4 is a schematic cross-sectional view illustrating the magnetic element as shown in FIG. 2 and taken along the line A-A'. FIG. 5 is a schematic cross-sectional view illustrating the magnetic element as shown in FIG. 2 and taken along the line B-B'.

In an embodiment, the magnetic element 1 includes a magnetic core assembly 2 and a winding assembly. The magnetic core assembly 2 includes a first magnetic part 21 and a second magnetic part 22. The first magnetic part 21 and the second magnetic part 22 are arranged independently. In this embodiment, the first magnetic part 21 and the second magnetic part 22 are located at two opposite sides of the magnetic element 1. The winding assembly is defined by a substrate 3. The substrate 3 is an integral structure. An example of the substrate 3 includes but is not limited to a printed circuit board, a ceramic substrate, or a substrate with manual flat-wound copper foil. The substrate 3 includes a first accommodation space 31, a second accommodation space 32 and a first metal structure 34. The first accommodation space 31 and the second accommodation space 32 are enclosed by the first metal structure 34. The first accommodation space 31 and the second accommodation space 32 are located at two opposite sides of the substrate 3. The first magnetic part 21 is disposed within the first accommodation space 31. The second magnetic part 22 is disposed within the second accommodation space 32 (see FIGS. 4 and 5). In an embodiment, the winding assembly at least includes a first winding. The first metal structure 34 is formed as at least a portion of the first winding of the winding assembly.

In an embodiment, the substrate 3 further includes a first opening 35 and a second opening 36. The first opening 35 is located at a first side 301 of the substrate 3. The second opening 36 is located at a second side 302 of the substrate 3. The first side 301 and the second side 302 of the substrate 3 are opposite to each other. That is, the first opening 35 and the second opening 36 are opposite to each other. The first accommodation space 31 and the second accommodation space 32 are arranged between the first opening 35 and the second opening 36. The first opening 35 is in communication with the first accommodation space 31 and the second accommodation space 32. The second opening 36 is in communication with the first accommodation space 31 and the second accommodation space 32. That is, the first opening 35, the first accommodation space 31, the second opening 36 and the second accommodation 32 are formed as a quadrilateral shape.

The magnetic core assembly 2 further includes a third magnetic part 23 and a fourth magnetic part 24 (see FIGS. 3 and 5). The third magnetic part 23 is disposed within the first opening 35. The fourth magnetic part 24 is disposed within the second opening 36. The first magnetic part 21 and the second magnetic part 22 are arranged between the third magnetic part 23 and the fourth magnetic part 24. The two ends of the third magnetic part 23 are connected with a first end of the first magnetic part 21 and a first end of the second magnetic part 22, respectively. The two ends of the fourth magnetic part 24 are connected with a second end of the first magnetic part 21 and a second end of the second magnetic part 22, respectively. In this embodiment, the first magnetic part 21, the second magnetic part 22, the third magnetic part 23 and the fourth magnetic part 24 are arranged independently from each other. In some embodiments, the first magnetic part 21, the second magnetic part 22, the third magnetic part 23, and the fourth magnetic part 24 are arranged as a quadrilateral of any shape, such as a rectangle shape, a parallelogram shape or a trapezoid shape.

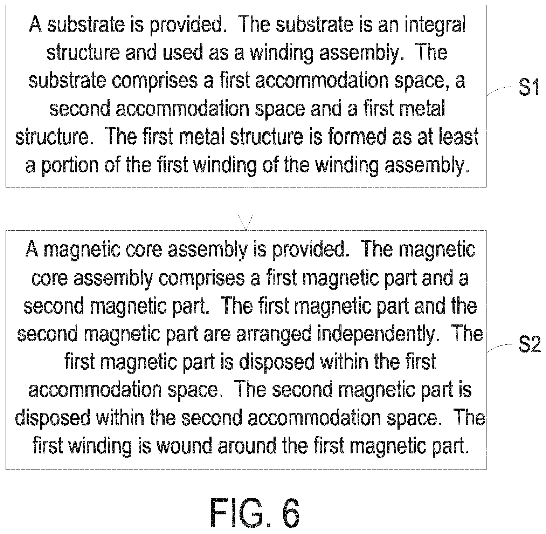

FIG. 6 is a flowchart illustrating a method of fabricating the magnetic element as shown in FIG. 2. Firstly, in a step S1, a substrate 3 is provided. The substrate 3 is an integral structure and used as a winding assembly of the magnetic element 1. The substrate 3 includes a first accommodation space 31, a second accommodation space 32 and a first metal structure 34. The first metal structure 34 is formed as at least a portion of the first winding of the winding assembly. As shown in FIG. 5, the widths of the first accommodation space 31 and the second accommodation space 32 are W0. The distance between the first accommodation space 31 and the second accommodation space 32 is W0'. In practice, the tolerance of the widths of each of the first accommodation space 31 and the second accommodation space 32 can be controlled within +/-50µm. Consequently, the first accommodation space 31 and the second accommodation space 32 have high dimension precision. In a step S2, a magnetic core assembly 2 is provided. The magnetic core assembly 2 includes a first magnetic part 21 and a second magnetic part 22. The first magnetic part 21 and the second magnetic part 22 are arranged independently. The first magnetic part 21 is disposed within the first accommodation space 31. The second magnetic part 22 is disposed within the second accommodation space 32. The first winding is wound around the first magnetic part 21. In an embodiment, the first magnetic part 21 and the second magnetic part 22 of the magnetic core assembly 2 are formed through molds. Consequently, the first magnetic part 21 and the second magnetic part 22 can be machined easily. In another embodiment, the first magnetic part 21 and the second magnetic part 22 are formed by cutting a magnetic core (not shown). Consequently, the dimension precision is enhanced. For achieving the easily-machined purpose and the high dimension precision, the first magnetic part 21 and the second magnetic part 22 of the magnetic core assembly 2 are firstly formed through molds, and then the first magnetic part 21 and the second magnetic part 22 are polished. Consequently, the dimension tolerance is controlled to be in the range between 0µm and 50µm.

As mentioned above, the first magnetic part 21 and the second magnetic part 22 are arranged independently, the first magnetic part 21 is disposed within the first accommodation space 31, and the second magnetic part 22 is disposed within the second accommodation space 32. Consequently, the first magnetic part 21 and the second magnetic part 22 can be polished separately. Moreover, since the first magnetic part 21 and the second magnetic part 22 are respectively positioned in the first accommodation space 31 and the second accommodation space 32 of the substrate 3, the first magnetic part 21 and the second magnetic part 22 are not influenced by each other. After the first magnetic part 21 and the second magnetic part 22 are polished separately, the first magnetic part 21 and the second magnetic part 22 are respectively positioned in the first accommodation space 31 and the second accommodation space 32. In other words, the position precision of the first magnetic part 21 and the position precision of the second magnetic part 22 are not related to each other. The position precision between the first magnetic part 21 and the second magnetic part 22 is determined according to the position precision between the first accommodation space 31 and the second accommodation space 32. Since the dimension precisions and position precisions of the first accommodation space 31 and the second accommodation space 32 in the substrate 3 are very high, the position precision between the first magnetic part 21 and the second magnetic part 22 is very high. Consequently, the size of the magnetic element 1 is smaller than the conventional magnetic element, and the power density is enhanced.

In some embodiments, the magnetic element 1 includes a single magnetic part and a single accommodation space. That is, the magnetic element 1 includes the first magnetic part 21 and the first accommodation space 31.

Hereinafter, some examples of the method for assembling the substrate and the magnetic core assembly of the magnetic element will be illustrated with reference to FIGS. 2 to 6 and FIGS. 7A to 7F.

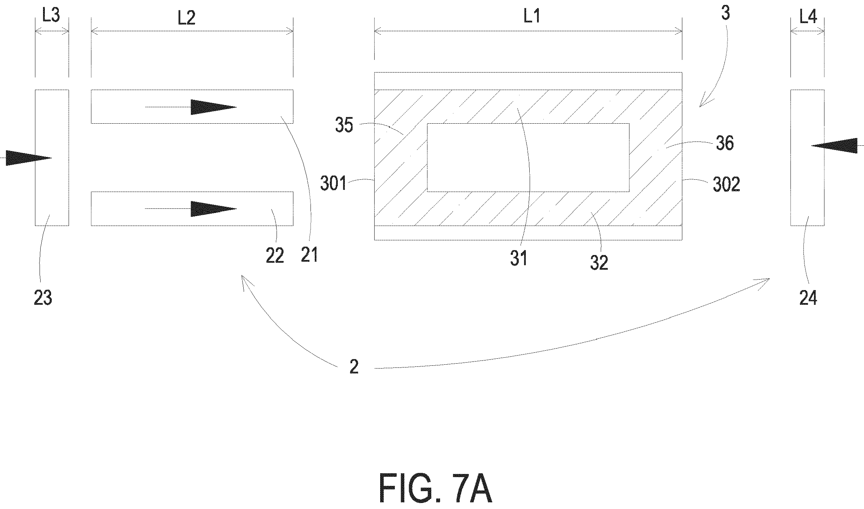

FIG. 7A schematically illustrates a first exemplary method for assembling the substrate and the magnetic core assembly of the magnetic element as shown in FIG. 2. The first magnetic part 21, the second magnetic part 22 and the third magnetic part 23 of the magnetic core assembly 2 are put into the substrate 3 through the first opening 35 at the first side 301 of the substrate 3. The fourth magnetic part 24 of the magnetic core assembly 2 is put into the substrate 3 through the second opening 36 at the second side 302 of the substrate 3. The first magnetic part 21 and the second magnetic part 22 are located beside the two long sides of the substrate 3, respectively. That is, the first magnetic part 21 and the second magnetic part 22 are disposed within the first accommodation space 31 and the second accommodation space 32 of the substrate 3, respectively. The first magnetic part 21 and the second magnetic part 22 are approximately parallel with each other. For example, the angle between the first magnetic part 21 and the second magnetic part 22 is in the range between 0 and 5 degrees. The third magnetic part 23 and the fourth magnetic part 24 are located beside the two short sides of the substrate 3, respectively. That is, the third magnetic part 23 and the fourth magnetic part 24 are disposed within the first opening 35 and the second opening 36 of the substrate 3, respectively. The third magnetic part 23 and the fourth magnetic part 24 are approximately parallel with each other. For example, the angle between the third magnetic part 23 and the fourth magnetic part 24 is in the range between 0 and 5 degrees.

In some embodiments, the two ends of the first magnetic part 21 are respectively connected with the third magnetic part 23 and the fourth magnetic part 24 through insulation material (not shown). The two ends of the second magnetic part 22 are respectively connected with the third magnetic part 23 and the fourth magnetic part 24 through insulation material (not shown). The inductance value of the magnetic element 1 may be adjusted according to the thickness of the insulation material. Since the first magnetic part 21, the second magnetic part 22, the third magnetic part 23 and the fourth magnetic part 24 in this embodiment are all disposed within the substrate 3, the insulation material is also disposed within the substrate 3. For reducing the magnetic loss of the magnetic element 1, the insulation material is not contacted with the substrate 3. Moreover, since the first magnetic part 21, the second magnetic part 22, the third magnetic part 23 and the fourth magnetic part 24 are all disposed within the substrate 3, the areas of the top surface and the bottom surface of the substrate 3 are large enough. As mentioned above, the wiring is limited in conventional magnetic element because the magnetic core is mounted through the substrate. In accordance with the present invention, the wiring is more flexible. Consequently, more components can be disposed on the substrate 3, and the performance of the components can be increased.

In this embodiment, the length L1 of the substrate 3 is equal to the sum of the length L2 of the first magnetic part 21, the width L3 of the third magnetic part 23 and the width L4 of the fourth magnetic part 24 (i.e., L1=L2+L3+L4). That is, the first magnetic part 21 is completely disposed within the first accommodation space 31, the second magnetic part 22 is completely disposed within the second accommodation space 32, the third magnetic part 23 is completely disposed within the first opening 35, and the fourth magnetic part 24 is completely disposed within the second opening 36. In some other embodiments, the length L1 of the substrate 3 is smaller than the sum of the length L2 of the first magnetic part 21, the width L3 of the third magnetic part 23 and the width L4 of the fourth magnetic part 24 (i.e., L1<L2+L3+L4). That is, the first magnetic part 21 is completely disposed within the first accommodation space 31, a portion of the third magnetic part 23 is disposed within the first opening 35, another portion of the third magnetic part 23 is exposed outside the substrate 3, a portion of the fourth magnetic part 24 is disposed within the second opening 36, and another portion of the fourth magnetic part 24 is exposed outside the substrate 3.

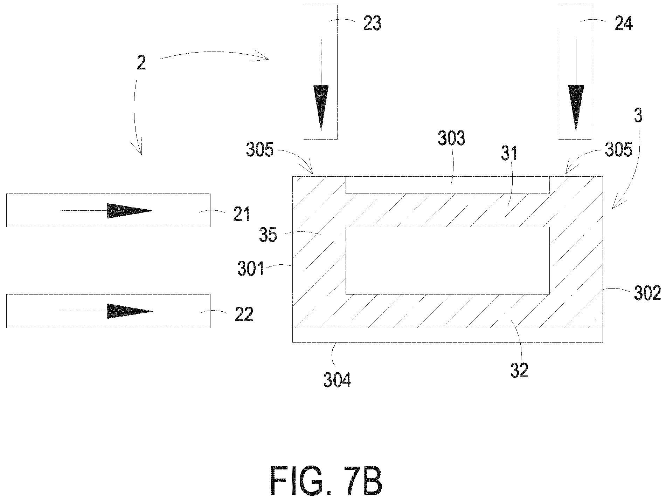

FIG. 7B schematically illustrates a second exemplary method for assembling the substrate and the magnetic core assembly of the magnetic element as shown in FIG. 2. As shown in FIG. 7B, the substrate 3 further has a third side 303 and a fourth side 304. The third side 303 and the fourth side 304 are arranged between the first side 301 and the second side 302. The third side 303 and the fourth side 304 are opposite to each other. In this embodiment, the third side 303 of the substrate 3 has two third openings 305. The first magnetic part 21 and the second magnetic part 22 are put into the substrate 3 through the first opening 35 at the first side 301 of the substrate 3. The third magnetic part 23 and the fourth magnetic part 24 are put into the substrate 3 through the two third openings 305 at the third side 303 of the substrate 3. In this embodiment, the substrate 3 is equipped with the first opening 35 and the third openings 305, but is not equipped with the second opening.

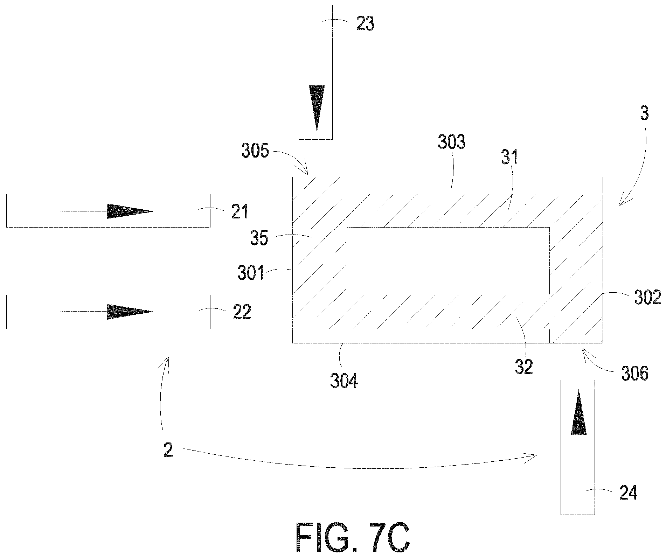

FIG. 7C schematically illustrates a third exemplary method for assembling the substrate and the magnetic core assembly of the magnetic element as shown in FIG. 2. As shown in FIG. 7C, the substrate 3 further has a third side 303 and a fourth side 304. The third side 303 and the fourth side 304 are arranged between the first side 301 and the second side 302. The third side 303 and the fourth side 304 are opposite to each other. In this embodiment, the third side 303 of the substrate 3 has a third opening 305, and the fourth side 304 of the substrate 3 has a fourth opening 306. The first magnetic part 21 and the second magnetic part 22 are put into the substrate 3 through the first opening 35 at the first side 301 of the substrate 3. The third magnetic part 23 is put into the substrate 3 through the third opening 305 at the third side 303 of the substrate 3. The fourth magnetic part 24 is put into the substrate 3 through the fourth opening 306 at the fourth side 304 of the substrate 3. In this embodiment, the substrate 3 is equipped with the first opening 35, the third opening 305 and the fourth opening 306, but is not equipped with the second opening.

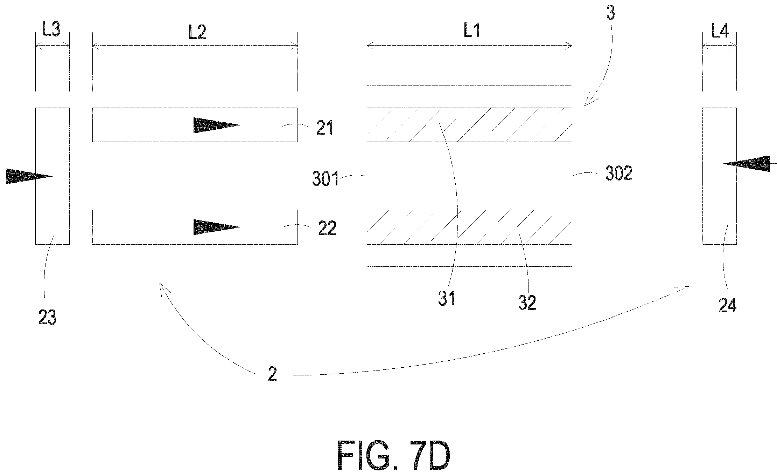

FIG. 7D schematically illustrates a fourth exemplary method for assembling the substrate and the magnetic core assembly of the magnetic element as shown in FIG. 2. In this embodiment, the length L1 of the substrate 3 is equal to the length L2 of the first magnetic part 21. That is, the length L1 of the substrate 3 is equal to the length of the second magnetic part 22. In this embodiment, the two ends of the first magnetic part 21 are respectively located at the first side 301 and the second side 302 of the substrate 3. The two ends of the second magnetic part 22 are respectively located at the first side 301 and the second side 302 of the substrate 3. Consequently, the third magnetic part 23 and the fourth magnetic part 24 are located outside the substrate 3. In some embodiments, the two ends of the first magnetic part 21 are respectively connected with the third magnetic part 23 and the fourth magnetic part 24 through insulation material (not shown). The two ends of the second magnetic part 22 are respectively connected with the third magnetic part 23 and the fourth magnetic part 24 through insulation material (not shown). The inductance value of the magnetic element 1 may be adjusted according to the thickness of the insulation material. Since the third magnetic part 23 and the fourth magnetic part 24 are located outside the substrate 3, the insulation material is also located outside the substrate 3. In other words, since it is not necessary to additionally control the amount of the insulation material, the production process is more flexible. As mentioned above, the third magnetic part 23 and the fourth magnetic part 24 are located outside the substrate 3. Consequently, after the first magnetic part 21 and the second magnetic part 22 are finely polished, the first magnetic part 21 and the second magnetic part 22 can be precisely disposed within the first accommodation space 31 and the second accommodation space 32, respectively.

In some other embodiments, the length L1 of the substrate 3 is smaller than the length of the first magnetic part 21. A portion of the first magnetic part 21 is disposed within the first accommodation space 31, and another portion of the first magnetic part 21 is located outside the first accommodation space 31. A portion of the second magnetic part 22 is disposed within the second accommodation space 32, and another portion of the second magnetic part 22 is located outside the second accommodation space 32.

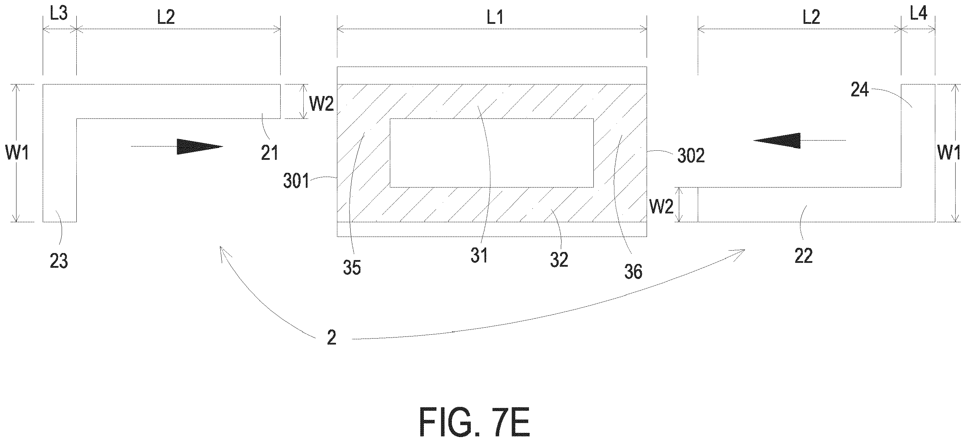

FIG. 7E schematically illustrates a fifth exemplary method for assembling the substrate and the magnetic core assembly of the magnetic element as shown in FIG. 2. In this embodiment, the first magnetic part 21 and the third magnetic part 23 are integrally formed as an L-shaped structure, and the second magnetic part 22 and the fourth magnetic part 24 are integrally formed as another L-shaped structure. The dimensions of the first magnetic part 21 and the second magnetic part 22 need to match the dimensions of the first accommodation space 31 and the second accommodation space 32, respectively. After the L-shaped structure of the first magnetic part 21 and the third magnetic part 23 is processed through the mold, the length L2 of the first magnetic part 21 and the width L3 of the third magnetic part 23 (i.e., the long side of the L-shaped structure) need to be precisely controlled, and the length W1 of the third magnetic part 23 and the width W2 of the first magnetic part 21 need to be precisely controlled. For example, a machine tool is used to polish all sides. Consequently, the length L2 of the first magnetic part 21 and the width L3 of the third magnetic part 23 (i.e., the long side of the L-shaped structure) and the length W1 of the third magnetic part 23 are controlled to be in the acceptable range. Moreover, after the length L2 of the first magnetic part 21 is precisely polished, the width W2 of the first magnetic part 21 is controlled to be in the acceptable range. Consequently, the L-shaped structure of the first magnetic part 21 and the third magnetic part 23 can be completely disposed within the substrate 3. Similarly, after the L-shaped structure of the second magnetic part 22 and the fourth magnetic part 24 is processed through the mold, the length L2 of the second magnetic part 22 and the width L4 of the fourth magnetic part 24 (i.e., the long side of the L-shaped structure) are precisely controlled, and the length W1 of the fourth magnetic part 24 and the width W2 of the second magnetic part 22 are precisely controlled. Consequently, the L-shaped structure of the second magnetic part 22 and the fourth magnetic part 24 can be completely disposed within the substrate 3.

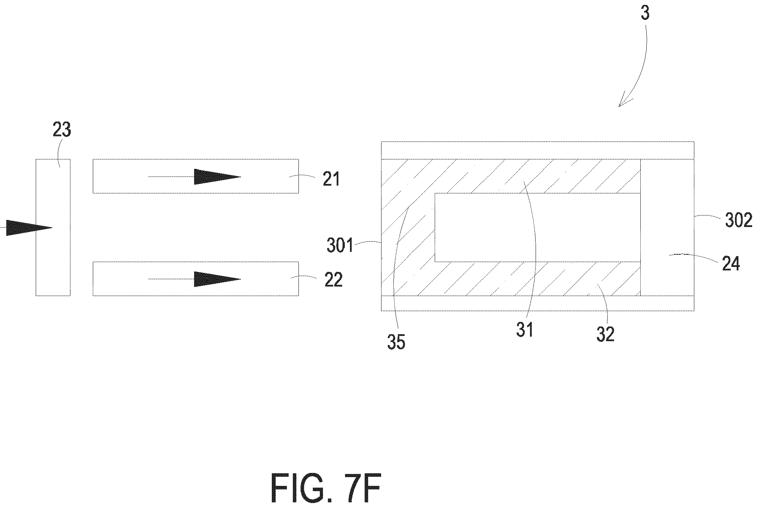

FIG. 7F schematically illustrates a sixth exemplary method for assembling the substrate and the magnetic core assembly of the magnetic element as shown in FIG. 2. In this embodiment, the second side 302 of the substrate 3 has no opening. For example, the fourth magnetic part 24 is pre-embedded in the substrate 3. The fourth magnetic part 24 is located at the second side 302 of the substrate 3. The first magnetic part 21, the second magnetic part 22 and the third magnetic part 23 are put into the substrate 3 through the first opening 35 at the first side 301 of the substrate 3.

According to the above embodiments of the magnetic element 1, the independent magnetic parts with high precision are produced. That is, the first magnetic part 21, the second magnetic part 22, the third magnetic part 23 and the fourth magnetic part 24 with high precision are individually disposed. For assembling the magnetic element 1, only the assembly precision between the first magnetic part 21, the second magnetic part 22, the third magnetic part 23 and the fourth magnetic part 24 and its corresponding accommodation space needs to be satisfied. After the first magnetic part 21, the second magnetic part 22, the third magnetic part 23 and the fourth magnetic part 24 are assembled with the substrate 3, the position tolerance between the first magnetic part 21 and the second magnetic part 22 is completely determined according to the first accommodation space 31 and the second accommodation space 32. In other words, the positions of the first accommodation space 31 and the second accommodation space 32 of the substrate 3 are determined according to the method of installing the first magnetic part 21 and the second magnetic part 22 in the first accommodation space 31 and the second accommodation space 32. Since the dimension precisions and the position precisions of the first accommodation space 31 and the second accommodation space 32 in the substrate 3 are very high, the tolerance of the relative position between the first magnetic part 21 and the second magnetic part 22 is very small. Consequently, when compared with the conventional technologies, the size of the magnetic element 1 of the present invention is reduced and the power density of the module is enhanced. In case that the size of the module is not changed, the cross-section area of the magnetic core can be increased and thus the magnetic loss will be effectively reduced.

In an embodiment, the first magnetic part 21, the second magnetic part 22, the third magnetic part 23 and the fourth magnetic part 24 of the magnetic core assembly 2 are made of stress-sensitive material. In addition, there is a certain gap between the magnetic core assembly 2 and the substrate 3. Consequently, during the fabricating process or the using process of the magnetic element 1, the interaction force between the substrate 3 and the magnetic core assembly 2 is reduced. Therefore, the magnetic loss of the magnetic core assembly 2 is reduced, the performance of the power module with the magnetic element 1 is enhanced.

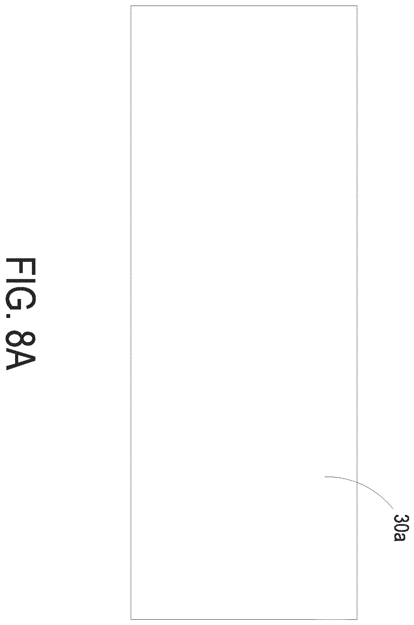

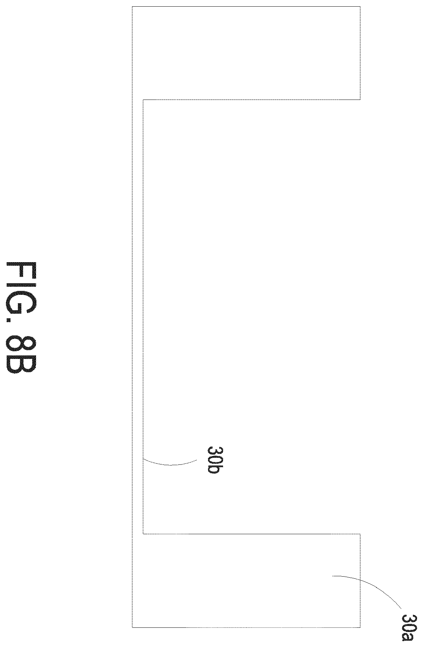

A manufacturing method of the substrate 3 will be described as follows. For succinctness, only the process of manufacturing the portion of the substrate 3 for accommodating the first magnetic part 21 will be described. The process of manufacturing the portion of the substrate 3 for accommodating the second magnetic part 22 is similar, and not redundantly described herein. FIGS. 8A to 8G are schematic cross-sectional views illustrating a process of manufacturing a magnetic element according to a first embodiment of the present invention.

Please refer to FG. 8A. Firstly, a base 30a is provided. For example, the base 30a is a printed circuit board.

Please refer to FG. 8B. Then, a recess 30b is formed in the base 30a. For example, the recess 30b is formed through a machining process or a laser drilling process.

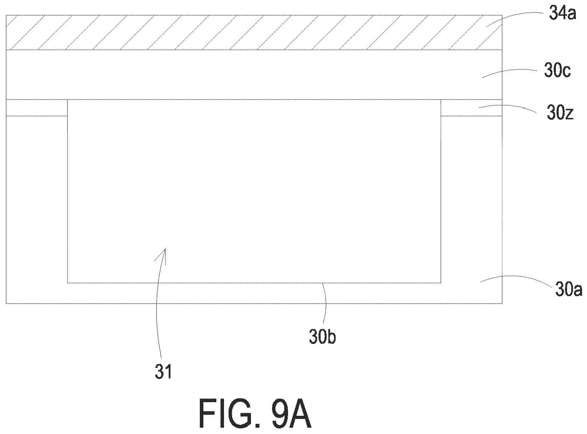

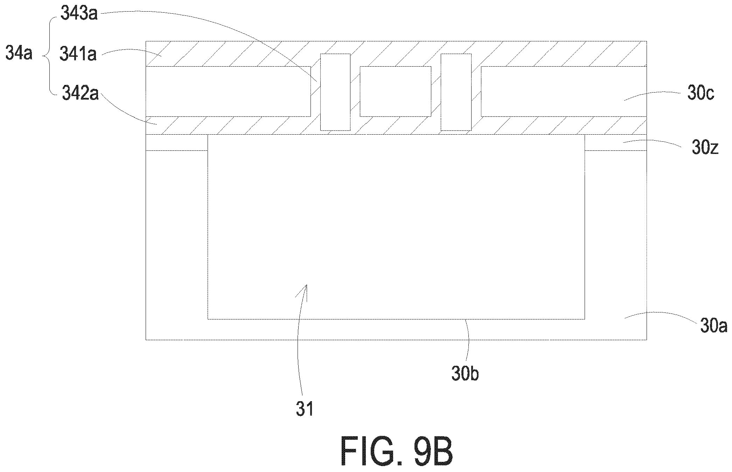

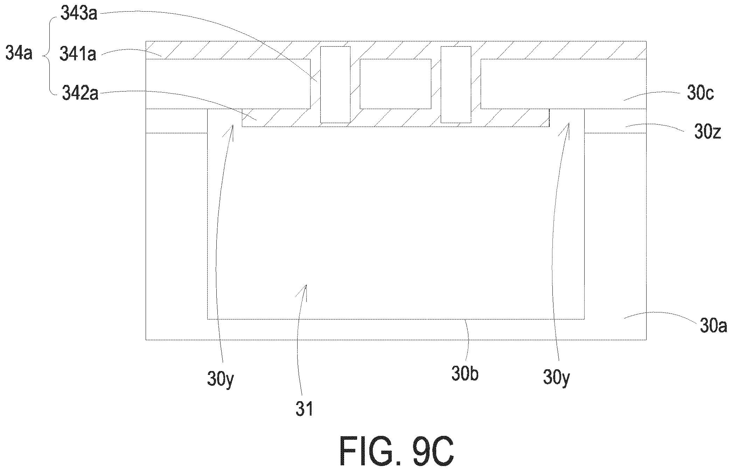

Please refer to FG. 8C. Then, a top plate 30c is laminated on the base 30a to cover the recess 30b, and a first horizontal copper foil 34a is formed on the top plate 30c. A first accommodation space 31 is defined by the base 30a and the top plate 30c collaboratively. The top plate 30c is made of insulation material. In an embodiment, the top plate 30c is placed on the base 30a through insulation glue. At a high temperature, the top plate 30c is adhered on the base 30a through a cross-linking reaction of the insulation glue. The way of adhering the top plate 30c on the base 30a through the insulation glue will be described with reference to FIGS. 9A, 9B and 9C. In an embodiment, the top plate 30c, the insulating glue and the base 30a are all made of fiber-reinforced composite material.

Alternatively, the top plate 30c and the base 30a are made of fiber-reinforced composite material, and the insulating glue is made of epoxy resin.

The cross-section area of the first accommodation space 31 is determined according to the cross-section area of the first magnetic part 21. That is, there is a specified relationship between the cross-section area of the first accommodation space 31 and the cross-section area of the first magnetic part 21. For example, the cross-section area of the first accommodation space 31 is substantially equal to the cross-section area of the first magnetic part 21. When the tolerance is taken into consideration, the cross-section area of the first accommodation space 31 is slightly greater than the cross-section area of the first magnetic part 21. Consequently, the first magnetic part 21 can be completely disposed in the first accommodation space 31 while saving the installation space of the substrate 3.

Generally, if the lamination of the top plate 30c and the base 30a is subjected to curvy deformation, the volume of the first accommodation space 31 may be shrunken. For solving this problem, the overall thickness of the top plate 30c and the first horizontal copper foil 34a needs to be greater than or equal to a specified thickness (e.g., 0.2 mm). In some situations, original material forming the top plate 30c and the first horizontal copper foil 34a are too thin to meet the requirement of the current flow capacity. Under this circumstance, it is necessary to pretreat the top plate 30c before the top plate 30c and the base 30a are adhered to each other. There are three methods of pretreating the top plate 30c described later.

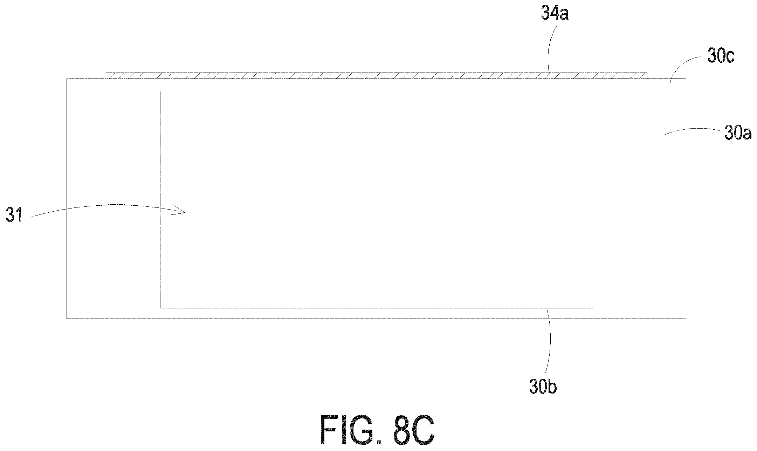

FIG. 9A is a schematic cross-sectional view illustrating a first exemplary example of forming the combination of the top plate and the base of the substrate in the step of FIG. 8C. As shown in FIG. 9A, after the top plate 30c is laminated on the base 30a through insulation glue 30z, the top plate 30c and the base 30a are combined together. Then, copper foil is continuously grown on the top plate 30c through a metallization process, so that the first horizontal copper foil 34a is formed. The thickness of the first horizontal copper foil 34a is 0.07 mm, and the thickness of the top plate 30c is 0.13 mm. Consequently, the overall thickness of the top plate 30c and the first horizontal copper foil 34a is 0.2 mm. Consequently, the requirement of the laminating process and the current flow capacity can be met.

FIG. 9B is a schematic cross-sectional view illustrating a second exemplary example of forming the combination of the top plate and the base of the substrate in the step of FIG. 8C. As shown in FIG. 9B, the first horizontal copper foil 34a includes a first upper horizontal conductor part 341a, a first lower horizontal conductor part 342a and a first vertical conductor part 343a. The first upper horizontal conductor part 341a is formed on an upper side of the top plate 30c. The first lower horizontal conductor part 342a is formed on a lower side of the top plate 30c. The first lower horizontal conductor part 342a is laminated on the base 30a through insulation glue 30z. The first vertical conductor part 343a is penetrated through the top plate 30c. In addition, the first vertical conductor part 343a is connected between the first upper horizontal conductor part 341a and the first lower horizontal conductor part 342a. The first upper horizontal conductor part 341a and the first lower horizontal conductor part 342a are parallel. For example, in case that the thickness of the first upper horizontal conductor part 341a is 1oz and the thickness of the first lower horizontal conductor part 342 is 1oz, the current flow capacity corresponding to 2oz can be achieved.

FIG. 9C is a schematic cross-sectional view illustrating a third exemplary example of forming the combination of the top plate and the base of the substrate in the step of FIG. 8C. In comparison with the embodiment of FIG. 9B, the top plate 30c of the embodiment of FIG. 9C is laminated on the base 30a through insulation glue 30z, and there is a gap 30y between the lateral side of the first lower horizontal conductor part 342a and the insulation glue 30z. The gap 30y is a space allowing the insulation glue 30z to flow therein. While the top plate 30c is laminated on the base 30a, the insulation glue 30z will not overflow to the first accommodation space 31. In other words, the available space of the first accommodation space 31 is not shrunken. The assembling of the magnetic element is easier.

The above metallization process includes an electroplating process or an electroless plating process. In case that the required thickness of the first metal structure 34 is small, the electroless plating process is feasible. In this situation, the current flow capacity is low. In case that the required current flow capacity is high, the electroplating process is needed. Optionally, before the electroplating process is performed, a seed layer is provided through an electroless plating process, a sputtering process or an evaporation process. Consequently, the functions of providing the surface conductivity and increasing the bonding force are achieved.

In case that the terminal load requires a lower voltage and a larger current, the demands on the high current flow capacity of the power supply module increase. Consequently, the thickness of the electroplated copper needs to be higher than or equal to a specified thickness (e.g., 70 µm). There are several approaches of forming the combination of the top plate and the base of the substrate as shown in FIGS. 9B and 9C. In accordance with the first approach, the first upper horizontal conductor part 341a and the first vertical conductor part 343a are formed by a single electroplating process. Generally, the surface electroplating rate is faster than the lateral electroplating rate. That is, the electroplating rate of the first upper horizontal conductor part 341a is faster than the electroplating rate of the first vertical conductor part 343a. Consequently, when the thickness of the first vertical conductor part 343a reaches 70 µm, the thickness of the first upper horizontal conductor part 341a is greater than 70 µm. The thickness of the substrate will be increased.

In accordance with a second approach, a leak hole electroplating technology is employed. Since the surface electroplating rate is faster than the lateral electroplating rate, the first upper horizontal conductor part 341a is usually much thicker than the first vertical conductor part 343a. The use of the leak hole electroplating technology can overcome the above problem. After a first electroplating process, the thickness of the first upper horizontal conductor part 341a and the thickness of the first vertical conductor part 343a are smaller than 70 µm. For example, the thickness of the first upper horizontal conductor part 341a is 40 µm, and the thickness of the first vertical conductor part 343a is smaller than 40µm. Then, a covering film is placed on the surface of the first upper horizontal conductor part 341a, wherein a hollow region corresponding to the first vertical conductor part 343a is exposed. Then, the copper foil is continuously grown on the hollow region through a metallization process until the thickness of the first vertical conductor part 343a reaches 70µm. Then, the covering film is removed. Then, the thickness of the first upper horizontal conductor part 341a reaches 70 µm by a second electroplating process. This approach can effectively control the thickness of the electroplated copper.

In accordance with a third approach, a hole-filling electroplating technology is employed. The electroplating rate of the first upper horizontal conductor part 341a is faster than the electroplating rate of the first vertical conductor part 343a. The copper foil is continuously grown on a hollow region corresponding to the first vertical conductor part 343a through a metallization process until the thickness of the first vertical conductor part 343a reaches 70µm. Then, the first upper horizontal conductor part 341a is subjected to an electroplating process until the thickness of the first upper horizontal conductor part 341a reaches 70 µm.

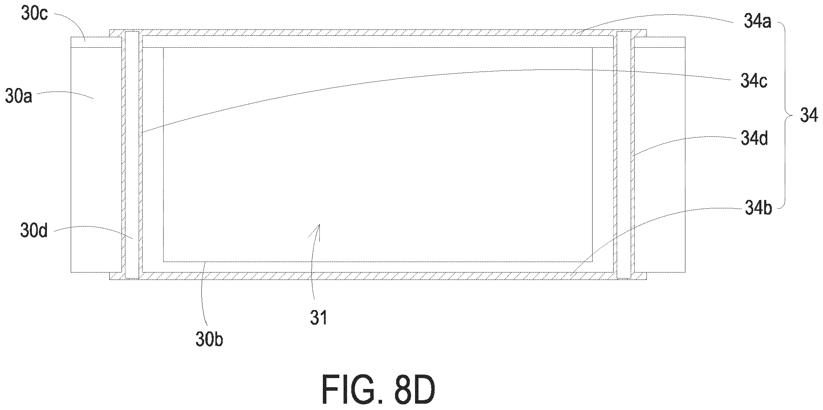

Please refer to FIG. 8D. A second horizontal copper foil 34b is formed on a bottom side of the base 30a. The first horizontal copper foil 34a and the second horizontal copper foil 34b are opposite to each other with respect to the first accommodation space 31. The base 30a further includes a plurality of first through holes 30d. The first through holes 30d run through the top plate 30c and the base 30a. In addition, the first through holes 30d are arranged between the first horizontal copper foil 34a and the second horizontal copper foil 34b. For succinctness, only two first through holes 30d are shown. Moreover, a first connection copper foil 34c and a second connection copper foil 34d are formed in the inner walls of the corresponding first through holes 30d and penetrated through the top plate 30c and the base 30a. The first connection copper foil 34c is connected with a first end of the first horizontal copper foil 34a and a first end of the second horizontal copper foil 34b. The second connection copper foil 34d is connected with a second end of the first horizontal copper foil 34a and a second end of the second horizontal copper foil 34b. The first connection copper foil 34c, the second connection copper foil 34d, the first horizontal copper foil 34a and the second horizontal copper foil 34b are collaboratively defined as a first metal structure 34. The portions of the base 30a and the top plate 30c that are covered by the first metal structure 34 are collaboratively formed as a first insulation structure. In this embodiment, for achieving the stability and maintaining the distance between the first through hole 30d and the first accommodation space 31, the shortest distance between the first through hole 30d and the first accommodation space 31 is greater than 0.2mm. Consequently, when the first through holes 30d are drilled, glass fibers of the insulation material will not affect the magnetic part located within the first accommodation space 31 along the drilling direction. Therefore, the magnetic part will not be disrupted and the tolerance of the drilling process will be reduced.

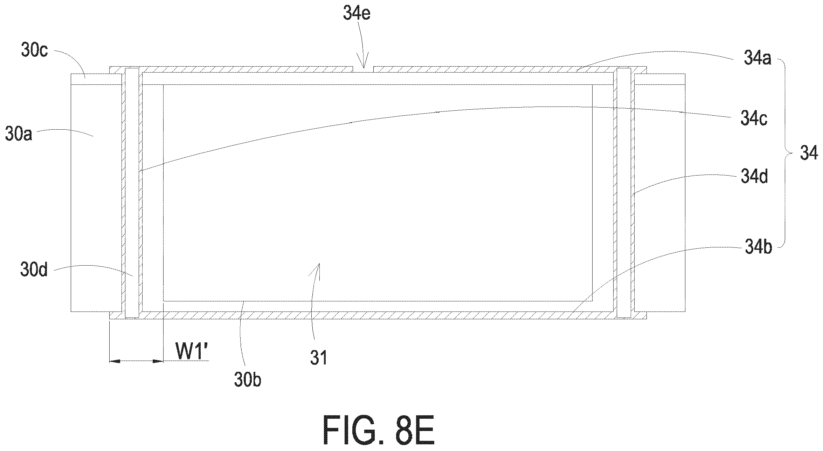

Please refer to FIG. 8E. Then, a chemical etching process is performed to form an etch hole 34e in the first horizontal copper foil 34a.

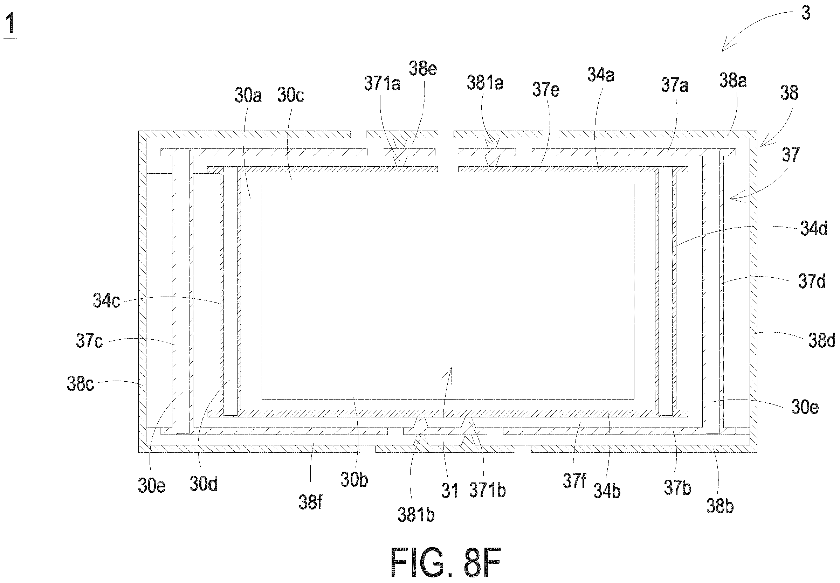

Please refer to FIG. 8F. Then, a first insulation layer 37e and a third horizontal copper foil 37a are sequentially formed on the first horizontal copper foil 34a. The first insulation layer 37e is arranged between the third horizontal copper foil 37a and the first horizontal copper foil 34a. In addition, a second insulation layer 37f and a fourth horizontal copper foil 37b are sequentially formed on the second horizontal copper foil 34b. The second insulation layer 37f is arranged between the fourth horizontal copper foil 37b and the second horizontal copper foil 34b. In this embodiment, the third horizontal copper foil 37a and the fourth horizontal copper foil 37b are opposite to each other with respect to the first accommodation space 31.

The base 30a further includes a plurality of second through holes 30e. The second through holes 30e run through the top plate 30c and the base 30a. In addition, the second through holes 30e are arranged between the third horizontal copper foil 37a and the fourth horizontal copper foil 37b. For succinctness, only two second through holes 30e are shown. Moreover, a third connection copper foil 37c and a fourth connection copper foil 37d are formed in the inner walls of the corresponding second through holes 30e and penetrated through the top plate 30c and the base 30a. The third connection copper foil 37c is connected with a first end of the third horizontal copper foil 37a and a first end of the fourth horizontal copper foil 37b. The fourth connection copper foil 37d is connected with a second end of the third horizontal copper foil 37a and a second end of the fourth horizontal copper foil 37b. The third connection copper foil 37c, the fourth connection copper foil 37d, the third horizontal copper foil 37a and the fourth horizontal copper foil 37b are collaboratively defined as a second metal structure 37. The portions of the first insulation layer 37e, the second insulation layer 37f, the base 30a and the top plate 30c that are covered by the second metal structure 37 are collaboratively formed as a second insulation structure. That is, the second insulation structure is arranged between the first metal structure 34 and the second metal structure 37.

As shown in FIG. 8F, a plurality of conductive posts 371a are connected between the third horizontal copper foil 37a and the first horizontal copper foil 34a. The conductive posts 371a also run through the first insulation layer 37e to connect the first horizontal copper foil 34a. Moreover, a plurality of conductive posts 371b are connected between the fourth horizontal copper foil 37b and the second horizontal copper foil 34b. The conductive posts 371b also run through the second insulation layer 37f to connect the second horizontal copper foil 34b.

Then, a fifth horizontal copper foil 38a, a sixth horizontal copper foil 38b, a fifth connection copper foil 38c, a sixth connection copper foil 38d, a third insulation layer 38e and a fourth insulation layer 38f are disposed on the outside of the second metal structure 37. The third insulation layer 38e is arranged between the fifth horizontal copper foil 38a and the third horizontal copper foil 37a. The fourth insulation layer 38f is arranged between the sixth horizontal copper foil 38b and the fourth horizontal copper foil 37b. The fifth connection copper foil 38c is connected between a first end of the fifth horizontal copper foil 38a and a first end of the sixth horizontal copper foil 38b. The sixth connection copper foil 38d is connected between a second end of the fifth horizontal copper foil 38a and a second end of the sixth horizontal copper foil 38b. The fifth horizontal copper foil 38a, the sixth horizontal copper foil 38b, the fifth connection copper foil 38c and the sixth connection copper foil 38d are collaboratively formed as a third metal structure 38. The portions of the third insulation layer 38e, the fourth insulation layer 38f, the base 30a and the top plate 30c that are covered by the third metal structure 38 are collaboratively formed as a third insulation structure. That is, the third insulation structure is arranged between the third metal structure 38 and the second metal structure 37.

As shown in FIG. 8F, a plurality of conductive posts 381a are connected between the fifth horizontal copper foil 38a and the third horizontal copper foil 37a. The conductive posts 381a also run through the third insulation layer 38e to connect the third horizontal copper foil 37a. Moreover, a plurality of conductive posts 381b are connected between the sixth horizontal copper foil 38b and the fourth horizontal copper foil 37b. The conductive posts 381b also run through the fourth insulation layer 38f to connect the fourth horizontal copper foil 37b.

The resulting structure of FIG. 8F is the substrate 3.

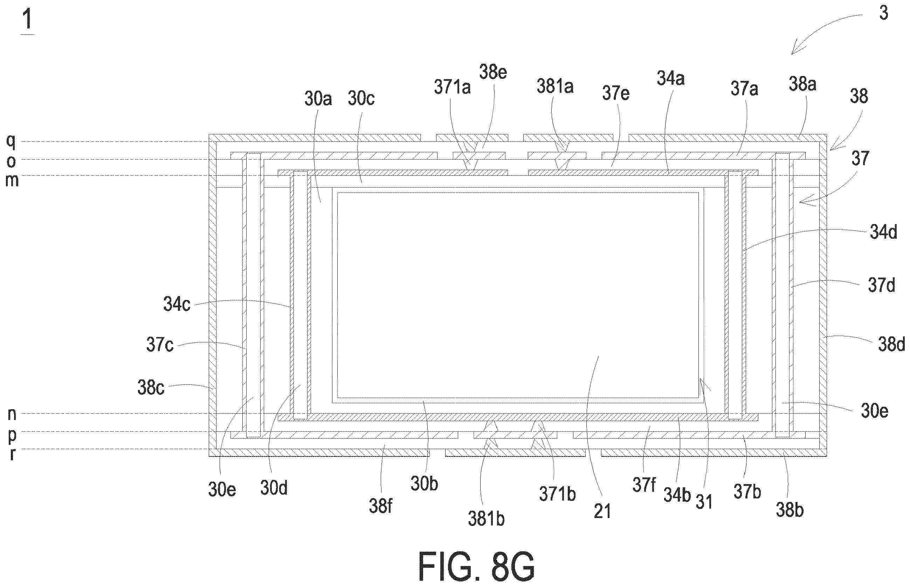

Please refer to FIG. 8G. Then, a first magnetic part 21 is disposed within the first accommodation space 31 of the substrate 3. Consequently, a portion of the magnetic element 1 is produced. The first magnetic part 21 is enclosed by the first horizontal copper foil 34a, the first connection copper foil 34c, the second horizontal copper foil 34b and the second connection copper foil 34d.

Please refer to FIG. 8G again. The first horizontal copper foil 34a is formed in a first horizontal wiring layer m. The second horizontal copper foil 34b is formed in a second horizontal wiring layer n. The first horizontal wiring layer m and the second horizontal wiring layer n are opposite to each other with respect to the first magnetic part 21. The third horizontal copper foil 37a is formed in a third horizontal wiring layer o. The fourth horizontal copper foil 37b is formed in a fourth horizontal wiring layer p. The third horizontal wiring layer o and the fourth horizontal wiring layer p are opposite to each other with respect to the first magnetic part 21. Moreover, the third horizontal wiring layer o is located at the side of the first horizontal wiring layer m away from the first accommodation space 31. The fourth horizontal wiring layer p is located at the side of the second horizontal wiring layer n away from the first accommodation space 31. The fifth horizontal copper foil 38a is formed in a fifth horizontal wiring layer q. The sixth horizontal copper foil 38b is formed in a sixth horizontal wiring layer r. The fifth horizontal wiring layer q and the sixth horizontal wiring layer r are opposite to each other with respect to the first magnetic part 21. The fifth horizontal wiring layer q is located at the side of the third horizontal wiring layer o away from the first accommodation space 31. The sixth horizontal wiring layer r is located at the side of the fourth horizontal wiring layer p away from the first accommodation space 31.

In this embodiment, a portion of the fifth horizontal copper foil 38a, the fifth connection copper foil 38c, a portion of the sixth horizontal copper foil 38b, the conductive posts 381a, a portion of the third horizontal copper foil 37a, the conductive posts 371a, a portion of the first horizontal copper foil 34a, the second connection copper foil 34d, a portion of the second horizontal copper foil 34b, the conductive posts 371b, a portion of the fourth horizontal copper foil 37b and the conductive posts 381b are collaboratively defined as a first winding of the magnetic element 1. Moreover, a portion of the third horizontal copper foil 37a, the third connection copper foil 37c, a portion of the fourth horizontal copper foil 37b and the fourth connection copper foil 37d are collaboratively defined as a second winding of the magnetic element. The connection relationships between the constituents of the third winding are similar to the connection relationships between the constituents of the first winding. In some embodiments, the second winding is arranged between the first winding and the third winding. Consequently, the second horizontal wiring layer n is connected with the third horizontal wiring layer o through conductive posts, i.e., connected to the solder pads (not shown) on the surface of the magnetic element 1. The connection between the copper foil segments of each winding will be described later.

In an embodiment, the first metal structure 34 is formed as the first winding, the second metal structure 37 is formed as the second winding, and the third metal structure 38 is formed as the third winding. In another embodiment, the magnetic element 1 includes the first winding only, or the magnetic element 1 includes the first winding and the second winding only. In another embodiment, a first portion of the first metal structure 34 and a first portion of the second metal structure 37 are formed as the first winding, and a second portion of the first metal structure 34 and a second portion of the second metal structure 37 are formed as the second winding. Moreover, the second winding and the third winding are wound around the first magnetic part 21. In another embodiment, a first portion of the first metal structure 34 and a first portion of the third metal structure 38 are formed as the first winding, and a second portion of the first metal structure 34 and a second portion of the third metal structure 38 are formed as the third winding. The first portion of the first metal structure 34 and the first portion of the third metal structure 38 are connected with each other through a conductive post. The second portion of the first metal structure 34 and the second portion of the third metal structure 38 are connected with each other through another conductive post.

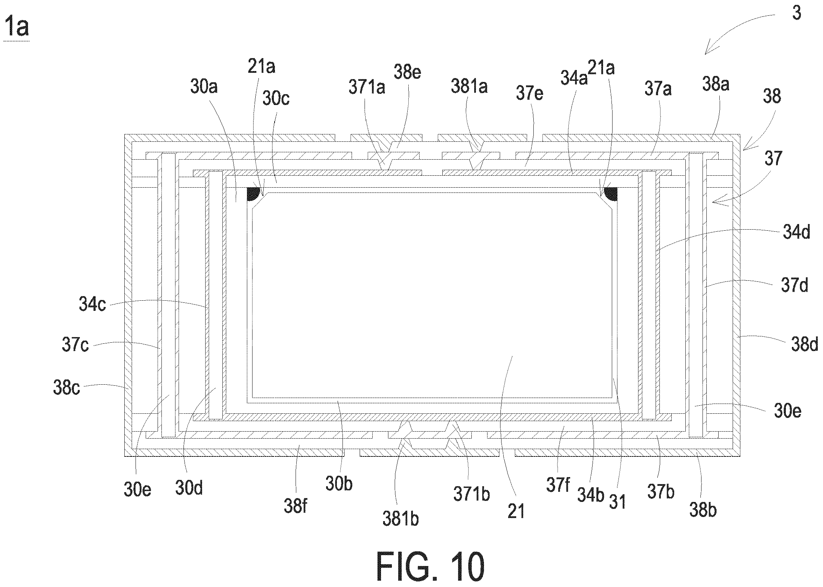

FIG. 10 is a schematic cross-sectional view illustrating a magnetic element according to a second embodiment of the present invention. In comparison with the magnetic element of FIG. 8G, at least one edge of the first magnetic part 21 is provided with a chamfer 21a, and the chamfer 21a is located beside the corner of the first metal structure 34. When the top plate 30c is laminated on the base 30a through the insulation glue, a portion of the insulation glue (e.g., the two quarter black circles as shown in FIG. 10) may flow into the first accommodation space 31. Due to the chamfer 21a, the insulation glue is not contacted with the first magnetic part 21.

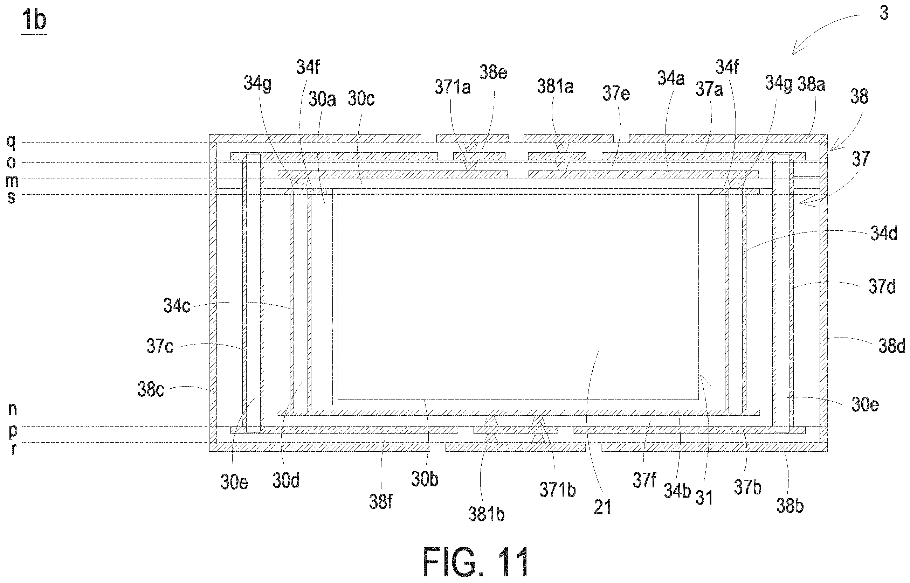

However, in some situations, the machine drilling process may result in the deformation of the first accommodation space 31. Because of the deformation of the first accommodation space 31, the dimension tolerance of the first accommodation space 31 is larger. For solving these drawbacks, a plurality of horizontal transition structures and a plurality of conductive posts to be connected with the first connection copper foil 34c and the second connection copper foil 34d are previously formed on the base 30a. Consequently, the possibility of causing the deformation from the machine drilling process is reduced. FIG. 11 is a schematic cross-sectional view illustrating a magnetic element according to a third embodiment of the present invention. In comparison with the magnetic element of FIG. 8G, the substrate 3 of this embodiment further includes a seventh horizontal wiring layer s. The seventh horizontal wiring layer s is arranged between the first horizontal wiring layer m and the second horizontal wiring layer n. The seventh horizontal wiring layer s is located beside the top plate 30c. The first metal structure 34 also includes the first horizontal copper foil 34a, the second horizontal copper foil 34b, the first connection copper foil 34c and the second connection copper foil 34d. Moreover, the first metal structure 34 further includes two first horizontal transition structures 34f. The two first horizontal transition structures 34f are formed in the seventh horizontal wiring layer s. Moreover, the two first horizontal transition structures 34f are arranged between the base 30a and the top plate 30c. In some embodiments, the two horizontal transition structures 34f are located at two sides of the first magnetic part 21. The two horizontal transition structures 34f are respectively connected with two ends of the first horizontal copper foil 34a through the corresponding first conductive posts 34g. Moreover, the two first horizontal transition structures 34f are connected with the first connection copper foil 34c and the second connection copper foil 34d, respectively.

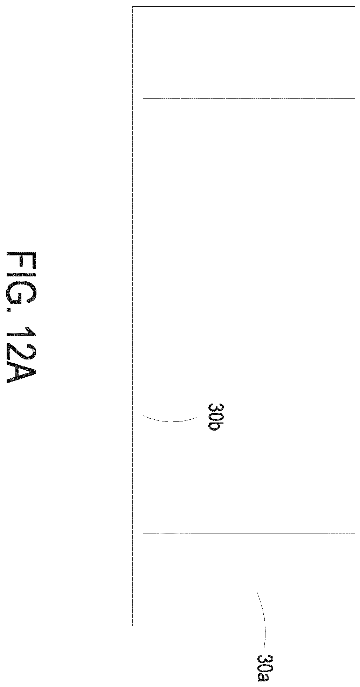

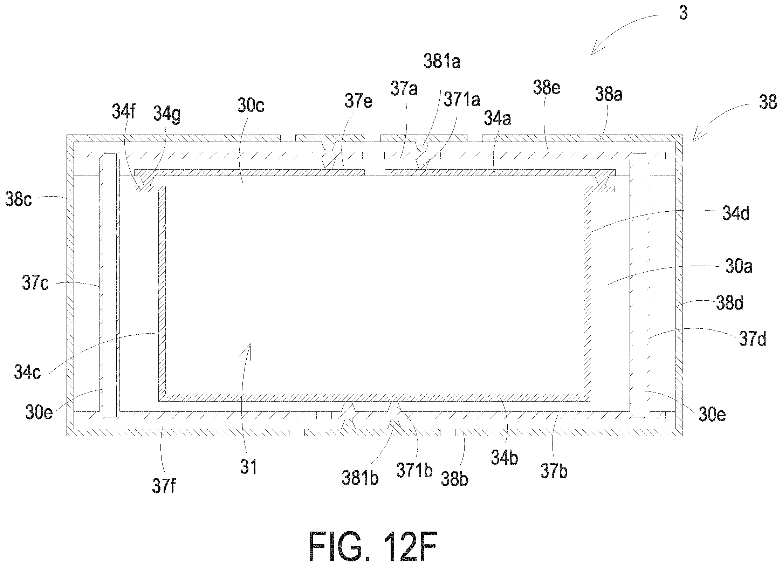

FIGS. 12A to 12G are schematic cross-sectional views illustrating a process of manufacturing a magnetic element according to a fourth embodiment of the present invention.

Please refer to FG. 12A. Firstly, a base 30a with a recess 30b is provided. For example, the base 30a is a printed circuit board, and the recess 30b is formed through a machining process or a laser drilling process. In an embodiment, the recess 30b is formed by a controlled-depth drilling process, and the aspect ratio of the recess 30b is smaller than 1. Consequently, the copper plating quality and the copper thickness are satisfied.

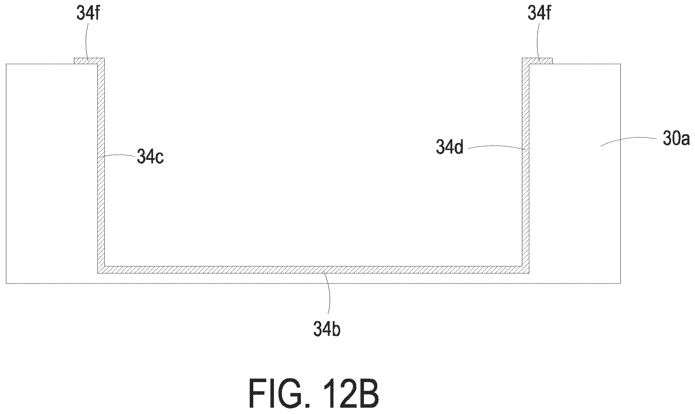

Please refer to FIG. 12B. Then, a second horizontal copper foil 34b, a first connection copper foil 34c and a second connection copper foil 34d are formed on an inner wall of the recess 30b. In an embodiment, the second horizontal copper foil 34b, the first connection copper foil 34c and the second connection copper foil 34d are disposed on a plurality of lateral surfaces of the inner wall of the recess 30b. The two ends of the second horizontal copper foil 34b are connected with a first end of the first connection copper foil 34c and a first end of the second connection copper foil 34d, respectively. Moreover, two first horizontal transition structures 34f are disposed on a top side of the base 30a, i.e., outside the recess 30b. One of the two first horizontal transition structures 34f is connected with a second end of the first connection copper foil 34c. The other first horizontal transition structure 34f is connected with a second end of the second connection copper foil 34d.

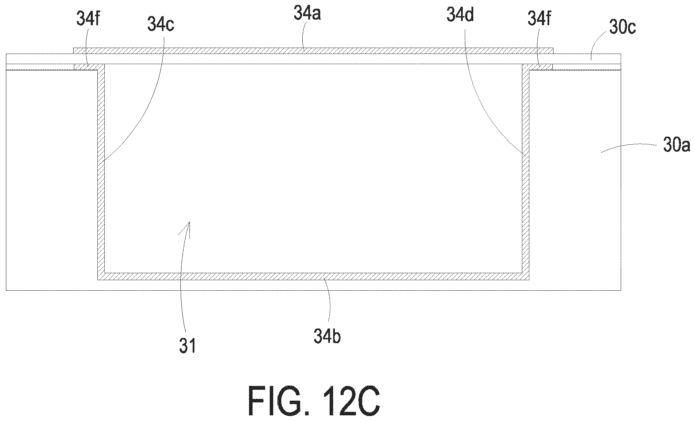

Please refer to FIG. 12C. Then, a top plate 30c is laminated on the base 30a to cover the recess 30b. Consequently, the two first horizontal transition structures 34f are arranged between the top plate 30c and the base 30a. A first accommodation space 31 is defined by the base 30a and the top plate 30c collaboratively. The second horizontal copper foil 34b, the first connection copper foil 34c and the second connection copper foil 34d are formed on the inner wall of the first accommodation space 31. Then, a first horizontal copper foil 34a is formed on the top plate 30c. In other words, the first horizontal copper foil 34a, the second horizontal copper foil 34b, the first connection copper foil 34c and the second connection copper foil 34d are disposed on a plurality of lateral surfaces of the inner wall of the first accommodation space 31.

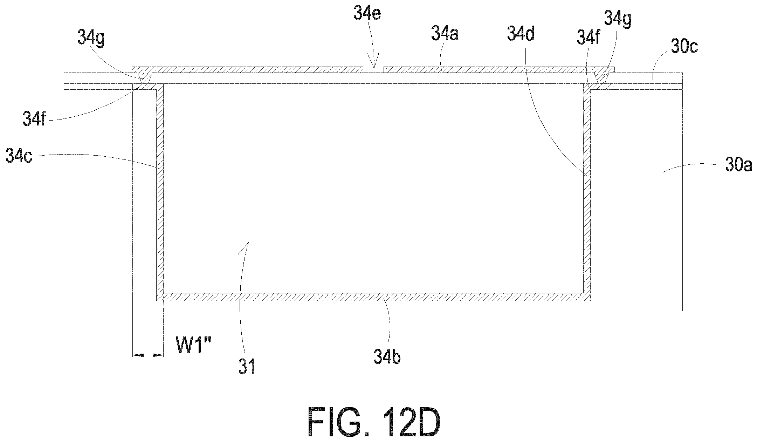

Please refer to FIG. 12D. The two ends of the first horizontal copper foil 34a are respectively connected with the corresponding first horizontal transition structures 34f through the corresponding first conductive posts 34g. The first connection copper foil 34c, the second connection copper foil 34d, the second horizontal copper foil 34b, the two first horizontal transition structures 34f, the first horizontal copper foil 34a and the two first conductive posts 34g are collaboratively defined as a first metal structure 34. In addition, only a portion of the first metal structure 34 is disposed on the inner wall of the first accommodation space 31, especially on the plurality of lateral surfaces of the inner wall of the first accommodation space 31. Then, a chemical etching process is performed to form an etch hole 34e in the first horizontal copper foil 34a.

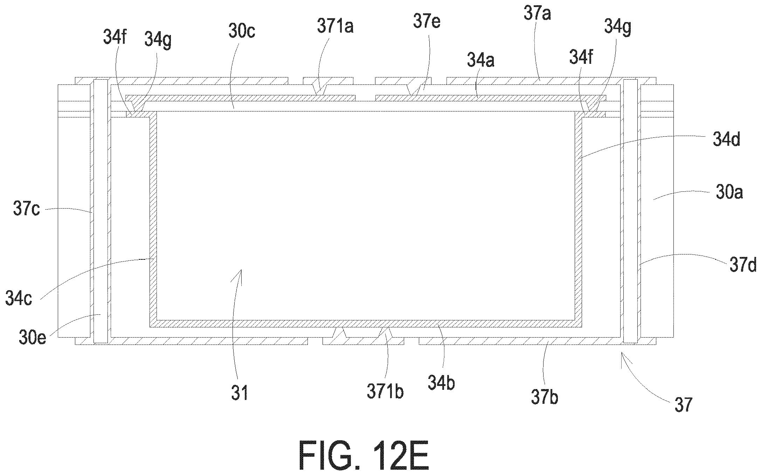

The steps of FIGS. 12E to 12G are similar to the steps of FIG. 8F to 8G, and not redundantly described herein.

In the magnetic element 1 as shown in FIG. 8E, the width of the first metal structure 34 beside the first accommodation space 31 is W1'. In the magnetic element 1c of this embodiment, the first connection copper foil 34c and the second connection copper foil 34d are directly formed on the inner wall of the first accommodation space 31. As shown in FIG. 12D, the width of the first metal structure 34 beside the first accommodation space 31 is W1". W1' is the required width through the mechanical drilling process. W1" is the required width through laser blind hole process. Since the dimension of the laser blind hole is smaller than the mechanical hole and the precision of the blind hole is higher than the precision of the mechanical hole, W" is smaller than W'. Similarly, the width of the first metal structure 34 on another side of the first accommodation space 31 is correspondingly reduced. Consequently, the dimension of the overall module is reduced, and the power density of the magnetic element 1c is enhanced. Since the width of the magnetic element 1c is reduced, the current path is shortened, the magnetic loss is reduced, and the efficiency is enhanced.

In this embodiment, the second horizontal copper foil 34b, the first connection copper foil 34c and the second connection copper foil 34d are disposed on the inner wall of the first accommodation space 31. In other words, only a portion of the first metal structure 34 is disposed on the inner wall of the first accommodation space 31. In some embodiments, only portions of the second horizontal copper foil 34b, the first connection copper foil 34c and the second connection copper foil 34d are disposed on the inner wall of the first accommodation space 31. For example, only the first connection copper foil 34c and the second connection copper foil 34d are disposed on the inner wall of the first accommodation space 31. Alternatively, only a portion of the first connection copper foil 34c is disposed on the inner wall of the first accommodation space 31.

In some embodiments, a thin insulation layer (not shown) is formed on the surface of the first metal structure 34 through a spraying process, a dipping process, an electrophoresis process, an electrostatic spraying process, a chemical vapor deposition process, a physical vapor deposition process, a sputtering process, an evaporation process or a printing process. The thickness of the thin insulation layer is smaller than a half of the thickness of the second insulation structure. Similarly, the portions of the first insulation layer 37e, the second insulation layer 37f, the base 30a and the top plate 30c that are covered by the second metal structure 37 are collaboratively formed as the second insulation structure. Due to the thin insulation layer, the possibility of causing the oxidation of the first metal structure 34 is minimized and the insulation between the first metal structure 34 and the first magnetic part 21 is enhanced.

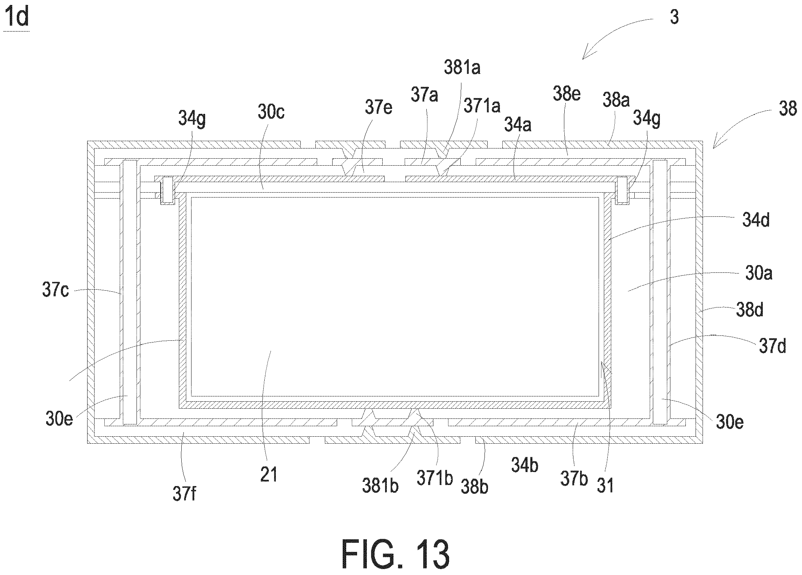

FIG. 13 is a schematic cross-sectional view illustrating a magnetic element according to a fifth embodiment of the present invention. In comparison with the magnetic element 1c of the fourth embodiment, the holes for accommodating the first conductive posts 34g in the magnetic element 1d of this embodiment are blind holes that are formed by using a machined process. For example, the machined process is a depth-controlled drilling process or a depth-controlled milling process. After the blind holes are formed, the first conductive posts 34g are formed through a metallization process.

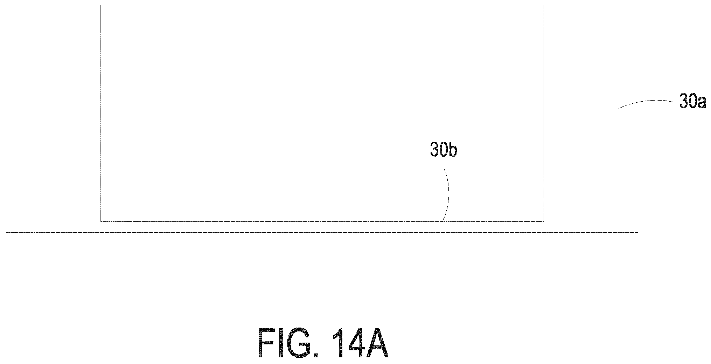

FIGS. 14A to 14G are schematic cross-sectional views illustrating a process of manufacturing a magnetic element according to a sixth embodiment of the present invention.

Please refer to FG. 14A. Firstly, a base 30a with a recess 30b is provided. The step of FIG. 14A is similar to the step of FIG. 12A.

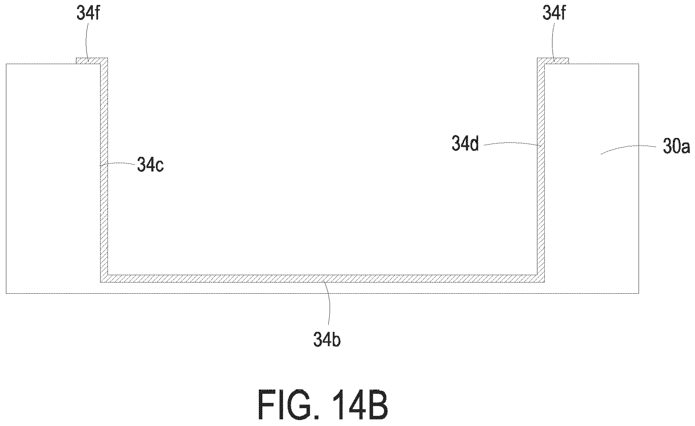

Please refer to FIG. 14B. Then, a second horizontal copper foil 34b, a first connection copper foil 34c and a second connection copper foil 34d are formed on an inner wall of the recess 30b. Moreover, two first horizontal transition structures 34f are disposed on a top side of the base 30a, i.e., outside the recess 30b. The step of FIG. 14B is similar to the step of FIG. 12B.

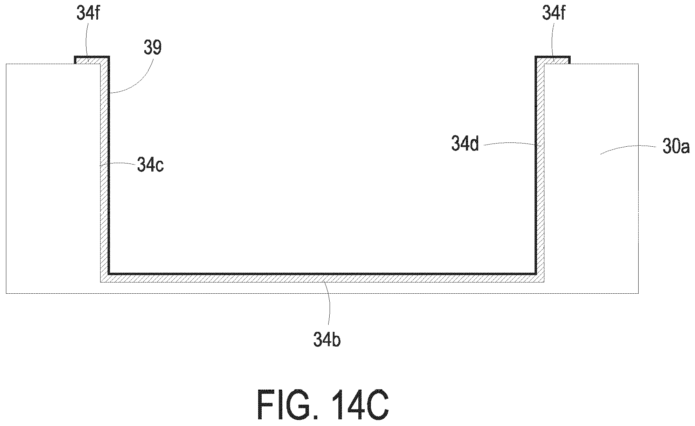

Please refer to FIG. 14C. Then, a metallic protective layer 39 is formed on the second horizontal copper foil 34b, the first connection copper foil 34c, the second connection copper foil 34d and the two first horizontal transition structures 34f. In an embodiment, the metallic protective layer 39 is made of tin because tin has a very slow reaction rate in the strong oxidizing solvent and has an excellent protection effect. Alternatively, the metallic protective layer 39 is made of tin alloy, gold or gold alloy. For patterning the following patterned structure of the first metal structure 34 around the first accommodation space 31, the metallic protective layer 39 is formed through an electroplating process or an electroless plating process. Consequently, the metallic protective layer 39 has a better surface covering ability, the bubble generated by using the organic material is avoided, and it is not necessary to clean the organic material. The thickness of the metallic protective layer 39 may be determined according to the protective capacity of the material. For example, in case that the metallic protective layer 39 is made of tin or tin alloy, the thickness of the metallic protective layer 39 is in the range between 1 µm and 20 µm. In case that the metallic protective layer 39 is made of gold or gold alloy, the thickness of the metallic protective layer 39 is in the range between 0.1 µm and 2 µm.

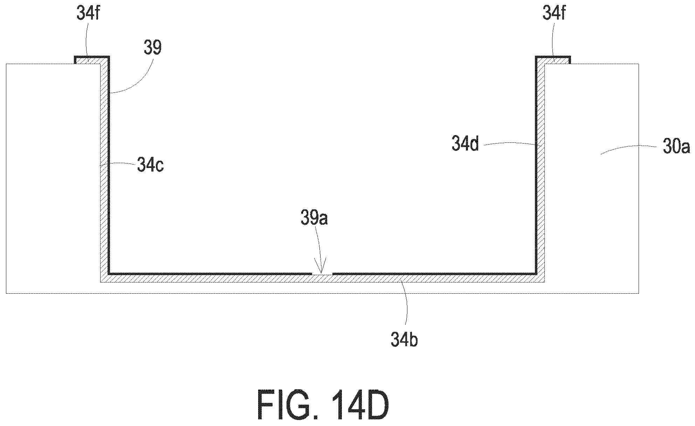

Please refer to FIG. 14D. Then, a direct writing technology is used to remove a portion of the metallic protective layer 39 to define a surface pattern 39a. Consequently, a portion of the second horizontal copper foil 34b of the first metal structure 34 is exposed. For example, the direct writing technology is a laser direct writing technology. The laser direct writing technology uses focused beams, electron beams or ion beams to directly define the patterns without the need of using masks. Consequently, the production flexibility is enhanced. Moreover, serialized products can be produced according to different application requirements, and the marketability of products will be increased. Moreover, before the direct writing technology is performed, an optical recognition technology is performed to accurately locate the sample and the surface state of the sample. Consequently, the direct writing path of each sample can be optimized separately to increase the yield, reduce the requirements for the previous process and increase the product competitiveness. Since the metallic protective layer 39 is formed on the first metal structure 34, the first metal structure 34 has a good thermal isolation effect during the laser direct writing process. Consequently, the influence of the heat on the first magnetic part is reduced.

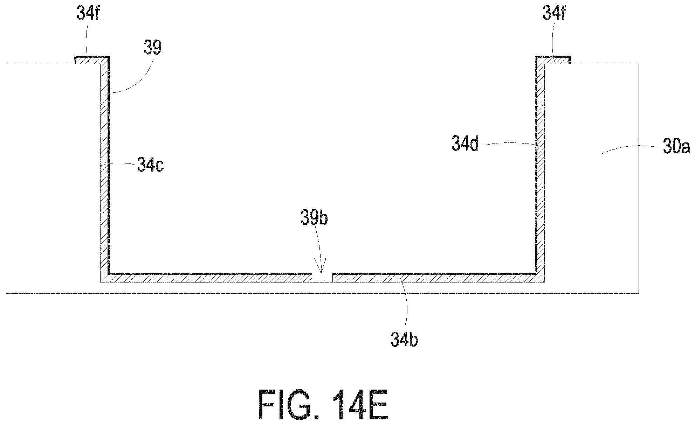

Please refer to FIG. 14E. Then, the exposed portion of the second horizontal copper foil 34b of the first metal structure 34 corresponding to the surface pattern 39a is etched. Consequently, a patterned structure 39b is formed, and a portion of the base 30a is exposed. The second horizontal copper foil 34b of the first metal structure 34 is divided into two segments by the patterned structure 39b. That is, the portion of the first metal structure 34 on the inner wall of the first accommodation space 31 is divided into a plurality of segments.

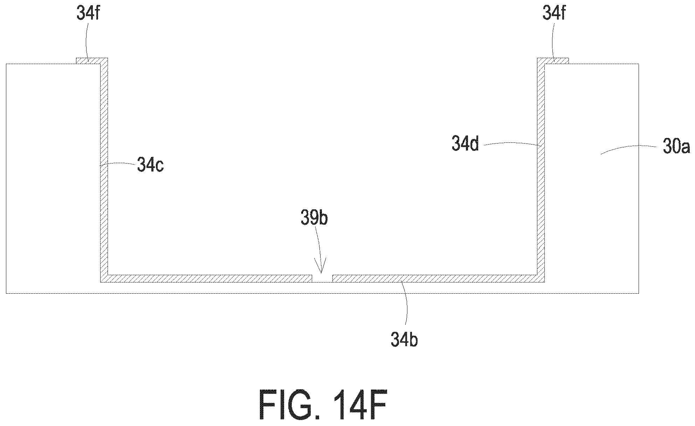

Please refer to FIG. 14F. Then, the remaining metallic protective layer 39 is removed. However, the step of removing the metallic protective layer 39 may be selectively done according to the material of the metallic protective layer 39. For example, if the metallic protective layer 39 is made of tin, the metallic protective layer 39 may be removed through an etching solution according to the demands after the pattern on the first metal structure 34 is etched. If the metallic protective layer 39 is made of gold, the metallic protective layer 39 may be retained. The metallic protective layer 39 made of gold is very thin. Optionally, the periphery region of the metallic protective layer 39 may be removed through a water jet process, a sandblasting process or an ultrasound process. In the other embodiment, the first metal structure 34 is divided through a mechanical process.

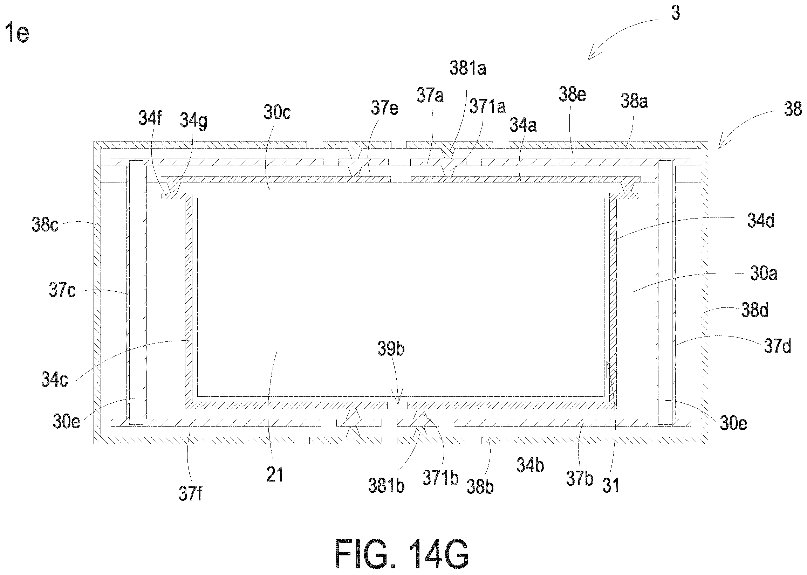

The step of FIG. 14G is similar to the steps of FIG. 12C to 12G, and not redundantly described herein.

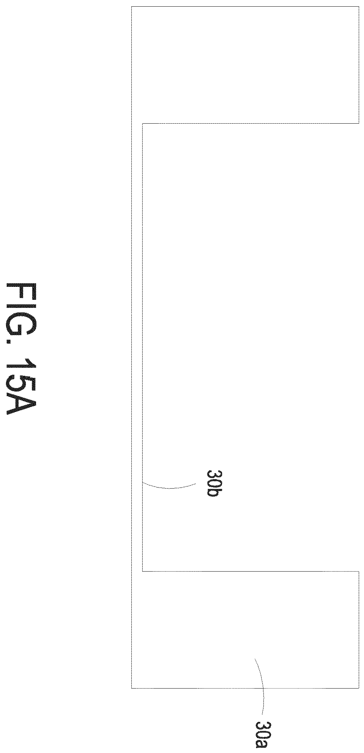

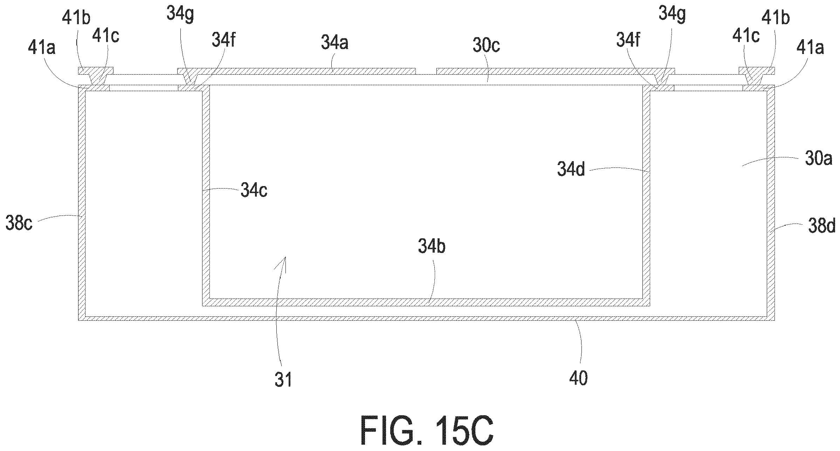

FIGS. 15A to 15G are schematic cross-sectional views illustrating a process of manufacturing a magnetic element according to a seventh embodiment of the present invention.

Please refer to FG. 15A. Firstly, a base 30a with a recess 30b is provided. The step of FIG. 15A is similar to the step of FIG. 12A.

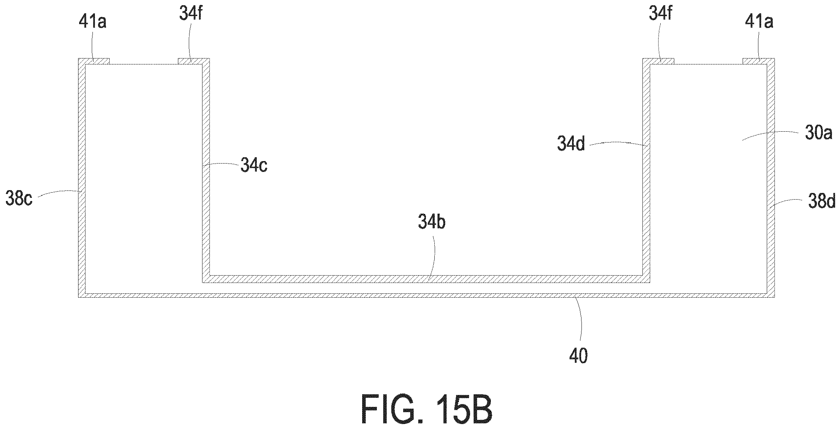

Please refer to FIG. 15B. Then, a second horizontal copper foil 34b, a first connection copper foil 34c and a second connection copper foil 34d are formed on an inner wall of the recess 30b. The two ends of the second horizontal copper foil 34b are connected with a first end of the first connection copper foil 34c and a first end of the second connection copper foil 34d. Moreover, two first horizontal transition structures 34f are disposed on a top side of the base 30a, i.e., outside the recess 30b. One of the two first horizontal transition structures 34f is connected with a second end of the first connection copper foil 34c. The other first horizontal transition structure 34f is connected with a second end of the second connection copper foil 34d. Moreover, a fifth connection copper foil 38c, a sixth connection copper foil 38d, a seventh horizontal copper foil 40 and two second horizontal transition structures 41a are formed on the outer side of the base 30a. The fifth connection copper foil 38c and the sixth connection copper foil 38d are opposite to each other with respect to the base 30a. The two ends of the seventh horizontal copper foil 40 are connected with a first end of the fifth connection copper foil 38c and a first end of the sixth connection copper foil 38d. One of the two second horizontal transition structures 41a is connected with a second end of the fifth connection copper foil 38c. The other second horizontal transition structure 41a is connected with a second end of the sixth connection copper foil 38d.

In the step of FIG. 15B, a covering film is formed on the top surface of the base 30a (i.e., between the second horizontal transition structures 41a and the corresponding first horizontal transition structures 34f), and a metallic wiring layer is formed on the lateral surface of the base 30a, the bottom surface of the base 30a and the inner lateral wall of the recess 30b through a metallization process. As setting a covering film on the bottom surface of the base 30a, the copper foil would not be formed on the bottom surface of the base, i.e., only the base copper foil is reserved. After an etching process, the fifth connection copper foil 38c, the sixth connection copper foil 38d, the seventh horizontal copper foil 40 and the second horizontal transition structures 41a are formed.

Please refer to FG. 15C. Then, a top plate 30c is laminated on the base 30a to cover the recess 30b. Consequently, the two first horizontal transition structures 34f and the two second horizontal transition structures 41a are also covered by the top plate 30c. A first accommodation space 31 is defined by the base 30a and the top plate 30c collaboratively. Then, a first horizontal copper foil 34a is formed on the top plate 30c. The two ends of the first horizontal copper foil 34a are connected with the corresponding horizontal transition structures 34f through the corresponding first conductive posts 34g. The first connection copper foil 34c, the second connection copper foil 34d, the second horizontal copper foil 34b, the two first horizontal transition structures 34f, the first horizontal copper foil 34a and the two first conductive posts 34g are collaboratively defined as a first metal structure 34. Then, two third horizontal transition structures 41b are formed on the top plate 30c. The two third horizontal transition structures 41b are connected with the corresponding second horizontal transition structures 41a through corresponding second conductive posts 41c. The second horizontal copper foil 34b, the first connection copper foil 34c and the second connection copper foil 34d are formed on the inner wall of the first accommodation space 31.

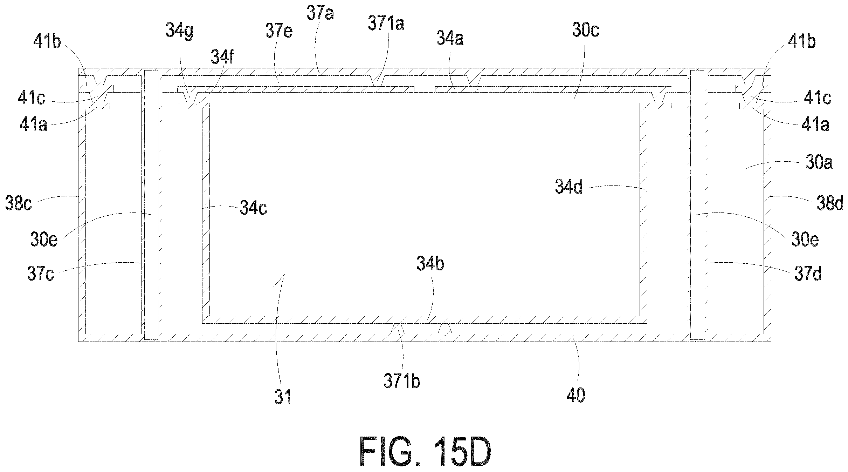

Please refer to FIG. 15D. Then, a first insulation layer 37e and a third horizontal copper foil 37a are sequentially formed on the first horizontal copper foil 34a. The first insulation layer 37e is arranged between the third horizontal copper foil 37a and the first horizontal copper foil 34a. The base 30a further includes a plurality of second through holes 30e. The second through holes 30e run through the top plate 30c and the base 30a. In addition, the second through holes 30e are arranged between the third horizontal copper foil 37a and the seventh horizontal copper foil 40. For succinctness, only two second through holes 30e are shown. Moreover, a third connection copper foil 37c and a fourth connection copper foil 37d are formed on the inner walls of the corresponding second through holes 30e and penetrated through the top plate 30c and the base 30a. The third connection copper foil 37c is connected with a first end of the third horizontal copper foil 37a and a first end of the seventh horizontal copper foil 40. The fourth connection copper foil 37d is connected with a second end of the third horizontal copper foil 37a and a second end of the seventh horizontal copper foil 40. Moreover, a plurality of conductive posts 371a are connected between the third horizontal copper foil 37a and the first horizontal copper foil 34a. The conductive posts 371a also run through the first insulation layer 37e to connect the first horizontal copper foil 34a. Moreover, a plurality of conductive posts 371b are connected between the fourth horizontal copper foil 37b and the second horizontal copper foil 34b. The conductive posts 371b also run through the second insulation layer 37f to connect the second horizontal copper foil 34b.

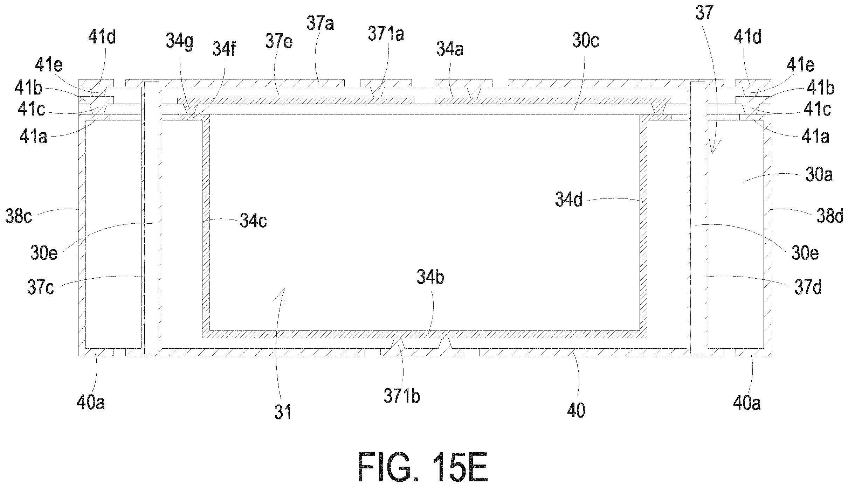

Please refer to FIG. 15E. Then, the two ends of the third horizontal copper foil 37a are cut off through an etching process. Consequently, two fourth horizontal transition structures 41d are formed on the two ends of the third horizontal copper foil 37a. The two fourth horizontal transition structures 41d are connected with the corresponding third horizontal transition structures 41b through corresponding third conductive posts 41e. Moreover, the seventh horizontal copper foil 40 is divided into a fourth horizontal copper foil 37b and two fifth horizontal transition structures 40a. One of the two fifth horizontal transition structures 40a is connected with the fifth connection copper foil 38c. The other fifth horizontal transition structure 40a is connected with the sixth connection copper foil 38d. The fourth horizontal copper foil 37b is arranged between the two fifth horizontal transition structures 40a. The third connection copper foil 37c, the fourth connection copper foil 37d, the third horizontal copper foil 37a and the fourth horizontal copper foil 37b are collaboratively defined as a second metal structure 37.

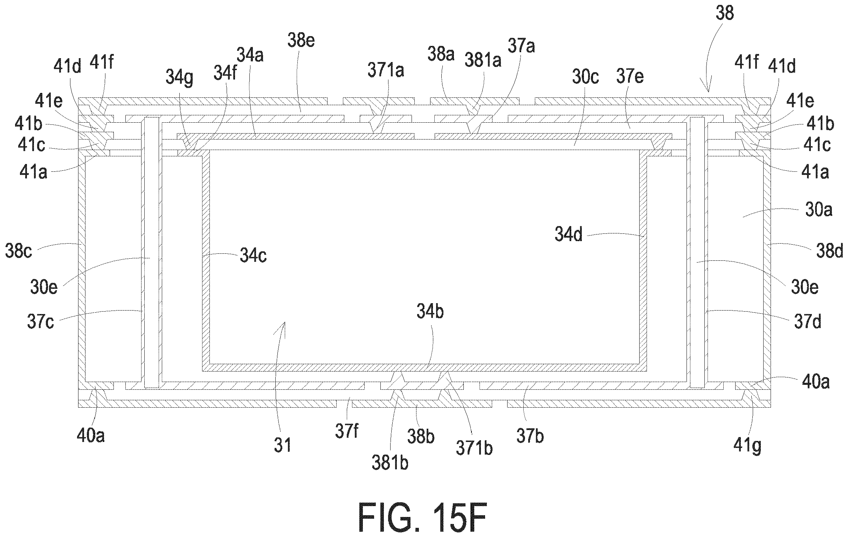

Please refer to FIG. 15F. Then, a fifth horizontal copper foil 38a and a third insulation layer 38e are formed on the third horizontal copper foil 37a and the two fourth horizontal transition structures 41d. A portion of the third insulation layer 38e is arranged between the fifth horizontal copper foil 38a and the third horizontal copper foil 37a. Another portion of the third insulation layer 38e is arranged between the fifth horizontal copper foil 38a and the two fourth horizontal transition structures 41d. The fifth horizontal copper foil 38a is connected with the corresponding fourth horizontal transition structures 41d through two fourth conductive posts 41f. Moreover, a sixth horizontal copper foil 38b and a second insulation layer 37f are formed on the fourth horizontal copper foil 37b and the two fifth horizontal transition structures 40a. A portion of the second insulation layer 37f is arranged between the sixth horizontal copper foil 38b and the fourth horizontal copper foil 37b. Another portion of the second insulation layer 37f is arranged between the sixth horizontal copper foil 38b and the two fifth horizontal transition structures 40a. The sixth horizontal copper foil 38b is connected with the corresponding fifth horizontal transition structures 40a through corresponding fifth conductive posts 41g. The fifth horizontal copper foil 38a, the sixth horizontal copper foil 38b, the fifth connection copper foil 38c, the sixth connection copper foil 38d, the two fifth horizontal transition structures 40a, the two second horizontal transition structures 41a, the two third horizontal transition structures 41b, the two second conductive posts 41c, the two fourth horizontal transition structures 41d, the two third conductive posts 41e, the two fourth conductive posts 41f and the two fifth conductive posts 41g are collaboratively formed as a third metal structure 38. In this embodiment, a portion of the first metal structure 34 and a portion of the third metal structure 38 are simultaneously formed by using a single electroplating process. Consequently, the fabricating time and the fabricating cost are reduced.

In other words, one of the two second horizontal transition structures 41a, one of the two third horizontal transition structures 41b, one of the two fourth horizontal transition structures 41d and one end of the fifth horizontal copper foil 38a are connected with each other through a first conductive part. One of the two second conductive posts 41c, one of the two third conductive posts 41e and one of the two fourth conductive posts 41f are formed as the first conductive part. One of the two fifth horizontal transition structures 40a and the sixth horizontal copper foil 38b are connected with each other through a second conductive part. One of the two fifth conductive posts 41g is formed as the second conductive part. The other second horizontal transition structure 41a, the other third horizontal transition structure 41b, the other fourth horizontal transition structure 41d, the other end of the fifth horizontal copper foil 38a are connected with each other through a third conductive part. The other second conductive post 41c, the other third conductive post 41e and the other fourth conductive post 41f are formed as the third conductive part. The other fifth horizontal transition structure 40a and the sixth horizontal copper foil 38b are connected with each other through a fourth conductive part. The other fifth conductive post 41g is formed as the fourth conductive part.

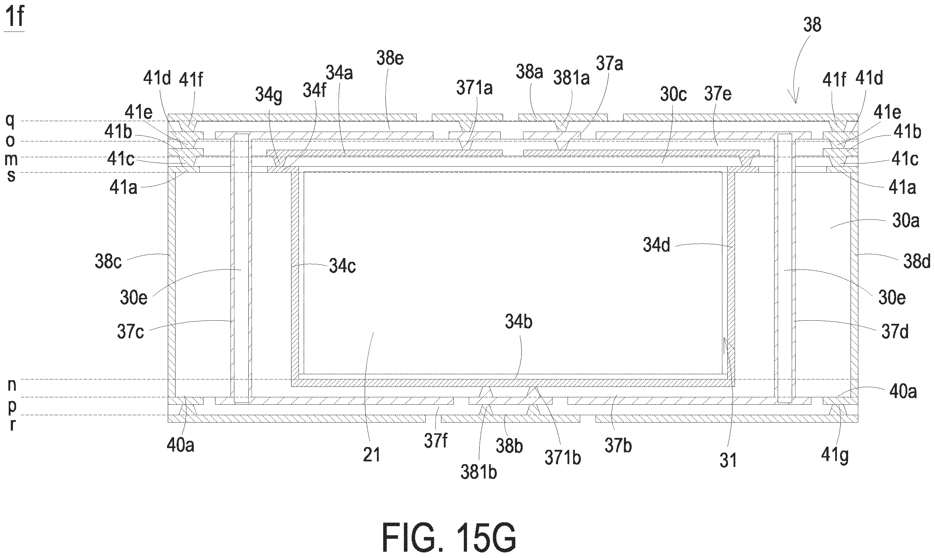

Please refer to FIG. 15G. Then, a first magnetic part 21 is disposed within the first accommodation space 31 of the substrate 3. Consequently, a portion of the magnetic element 1f is produced.

The first horizontal copper foil 34a and the two third horizontal transition structures 41b are formed in a first horizontal wiring layer m. Moreover, the first horizontal copper foil 34a is arranged between the two third horizontal transition structures 41b. The second horizontal copper foil 34b is formed in a second horizontal wiring layer n. The first horizontal wiring layer m and the second horizontal wiring layer n are opposite to each other with respect to the first magnetic part 21. The third horizontal copper foil 37a and the two fourth horizontal transition structures 41d are formed in a third horizontal wiring layer o. Moreover, the third horizontal copper foil 37a is arranged between the two fourth horizontal transition structures 41d. The fourth horizontal copper foil 37b and the two fifth horizontal transition structures 40a are formed in a fourth horizontal wiring layer p. Moreover, the fourth horizontal copper foil 37b is arranged between the two fifth horizontal transition structures 40a. The third horizontal wiring layer o and the fourth horizontal wiring layer p are opposite to each other with respect to the first magnetic part 21. Moreover, the third horizontal wiring layer o is located at the side of the first horizontal wiring layer m away from the first accommodation space 31. The fourth horizontal wiring layer p is located at the outer side of the second horizontal wiring layer n. The fifth horizontal copper foil 38a is formed in a fifth horizontal wiring layer q. The sixth horizontal copper foil 38b is formed in a sixth horizontal wiring layer r. The fifth horizontal wiring layer q and the sixth horizontal wiring layer r are opposite to each other with respect to the first magnetic part 21. The fifth horizontal wiring layer q is located at the outer side of the third horizontal wiring layer o. The sixth horizontal wiring layer r is located at the side of the fourth horizontal wiring layer p away from the first accommodation space 31. The two second horizontal transition structures 41a and the two first horizontal transition structures 34f are formed in a seventh horizontal wiring layer s. The seventh horizontal wiring layer s is arranged between the first horizontal wiring layer m and the second horizontal wiring layer n. The seventh horizontal wiring layer s is located beside the top plate 30c. Moreover, the two first horizontal transition structures 34f are arranged between the two second horizontal transition structures 41a.

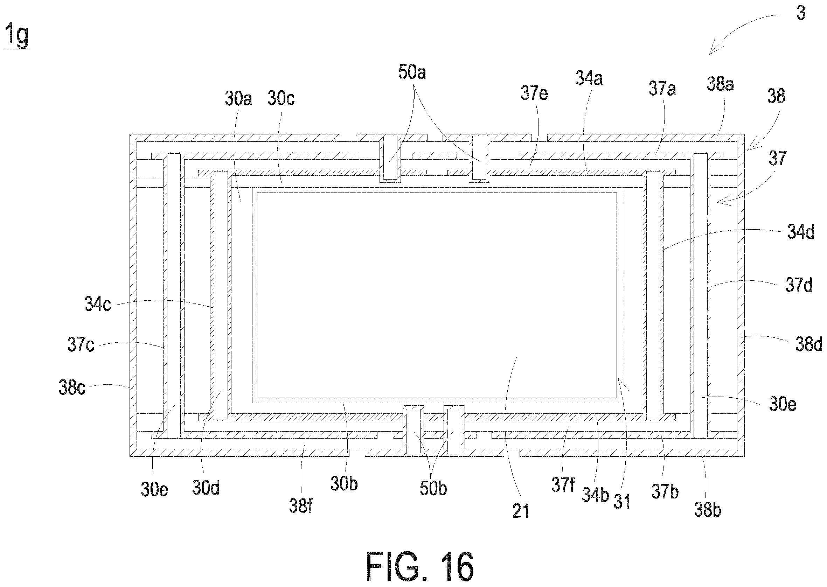

FIG. 16 is a schematic cross-sectional view illustrating a magnetic element according to an eighth embodiment of the present invention. In comparison with the magnetic element 1 of FIG. 8G, the substrate 3 of the magnetic element 1g of this embodiment includes first mechanical blind holes 50a and second mechanical blind holes 50b. The fifth horizontal copper foil 38a and the first horizontal copper foil 34a are connected with each other through the first mechanical blind holes 50a. The sixth horizontal copper foil 38b and the second horizontal copper foil 34b are connected with each other through the second mechanical blind holes 50b. Due to the arrangement of the mechanical blind holes, the allowable thickness of the substrate 3 is increased. Consequently, the applications are expanded.

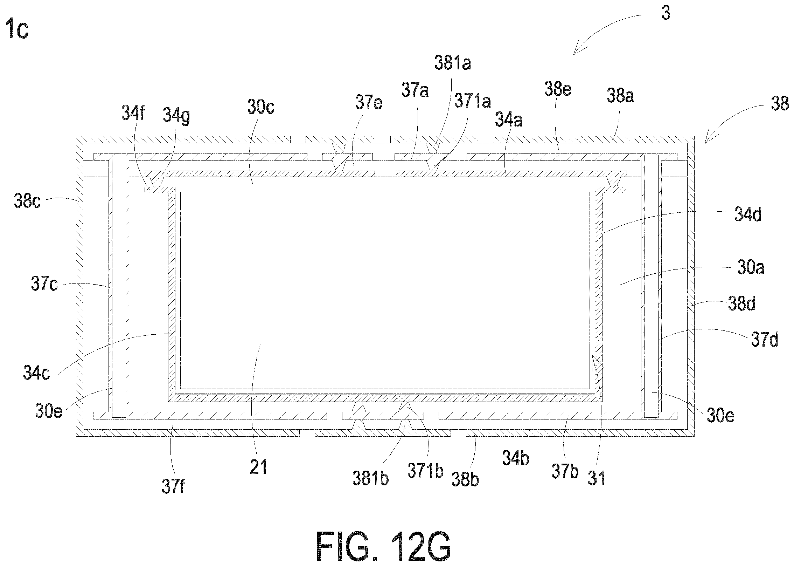

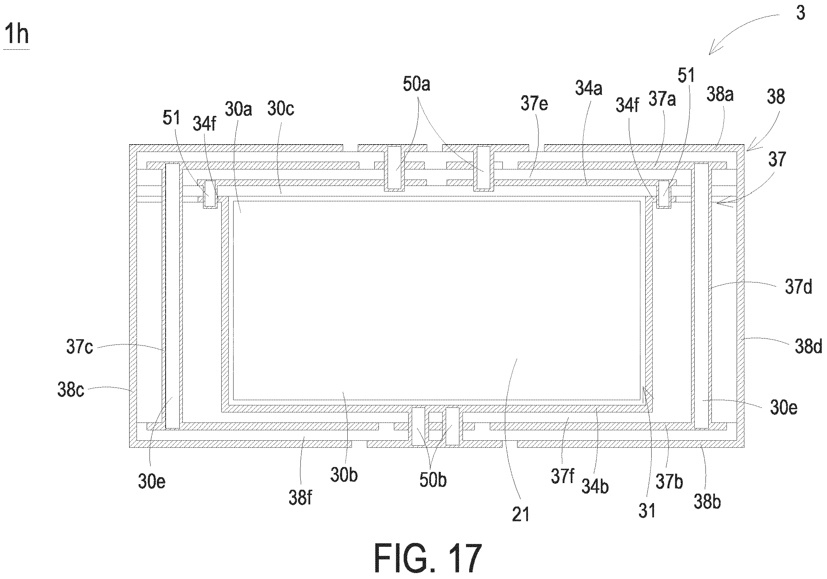

FIG. 17 is a schematic cross-sectional view illustrating a magnetic element according to a ninth embodiment of the present invention. In comparison with the magnetic element 1c of FIG. 12G, the substrate 3 of the magnetic element 1h of this embodiment includes first mechanical blind holes 50a, second mechanical blind holes 50b and third mechanical blind holes 51. The fifth horizontal copper foil 38a and the first horizontal copper foil 34a are connected with each other through the first mechanical blind holes 50a. The sixth horizontal copper foil 38b and the second horizontal copper foil 34b are connected with each other through the second mechanical blind holes 50b. The first horizontal copper foil 34a and the corresponding first horizontal transition structures 34f are connected with each other through the third mechanical blind holes 51. Due to the arrangement of the mechanical blind holes, the allowable thickness of the substrate 3 is increased. Consequently, the applications are expanded.

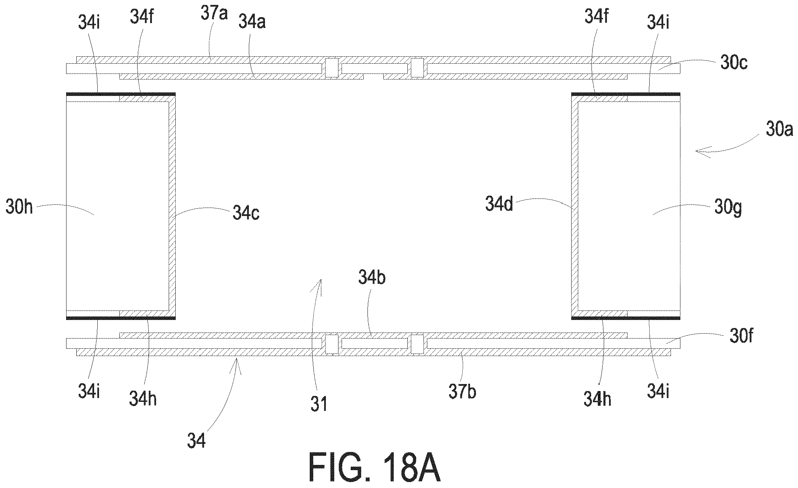

FIGS. 18A to 18F are schematic cross-sectional views illustrating a process of manufacturing a magnetic element according to a tenth embodiment of the present invention.

Please refer to FG. 18A. Firstly, a top plate 30c and a base 30a are provided. The base 30a includes a bottom structure 30f, a first lateral wall 30g and a second lateral wall 30h. The first lateral wall 30g and the second lateral wall 30h are arranged between the top plate 30c and the bottom structure 30f. In this embodiment, two first horizontal transition structures 34f, two sixth horizontal transition structures 34h, a first connection copper foil 34c and a second connection copper foil 34d are formed. One of the two first horizontal transition structures 34f is arranged between the top plate 30c and the first lateral wall 30g. The other first horizontal transition structure 34f is arranged between the top plate 30c and the second lateral wall 30h. One of the two sixth horizontal transition structures 34h is arranged between the bottom structure 30f and the first lateral wall 30g. The other sixth horizontal transition structure 34h is arranged between the bottom structure 30f and the second lateral wall 30h. The first connection copper foil 34c is formed on the inner surface of the first lateral wall 30g and connected between the corresponding first horizontal transition structure 34f and the corresponding sixth horizontal transition structure 34h. The second connection copper foil 34d is formed on the inner surface of the second lateral wall 30h and connected between the corresponding first horizontal transition structure 34f and the corresponding sixth horizontal transition structure 34h.

Please refer to FIG. 18A again. Then, a first horizontal copper foil 34a and a third horizontal copper foil 37a are formed on two sides of the top plate 30c. The first horizontal copper foil 34a is arranged between the top plate 30c and the two first horizontal transition structures 34f. Moreover, a second horizontal copper foil 34b and a fourth horizontal copper foil 37b are formed on two sides of the bottom structure 30f. The second horizontal copper foil 34b is arranged between the bottom structure 30f and the two sixth horizontal transition structures 34h. The top plate 30c, the bottom structure 30f, the first lateral wall 30g and the second lateral wall 30h are laminated as an integral structure through bonding material (not shown) in order to define a first accommodation space. In an embodiment, the first lateral wall 30g and the second lateral wall 30h are combined with the top plate 30c and the bottom structure 30f through connecting ribs 34i.

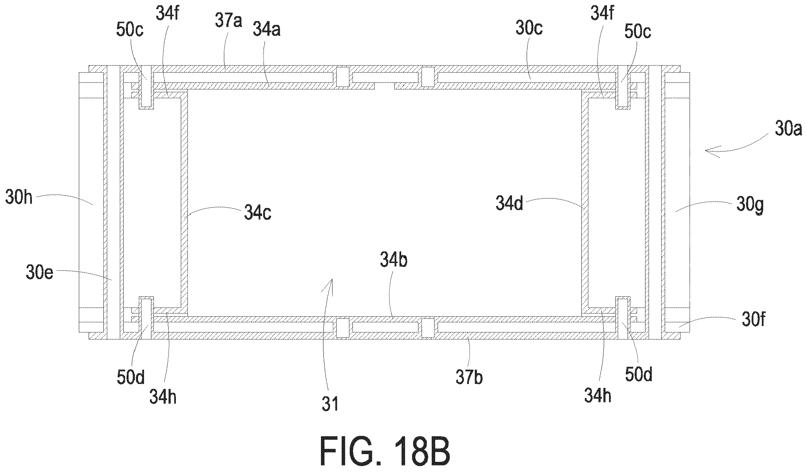

Please refer to FIG. 18B. Then, a plurality of second through holes 30e, a plurality of first blind holes 50c and a plurality of second blind holes 50d are formed. The second through holes 30e are connected between the third horizontal copper foil 37a and the fourth horizontal copper foil 37b. The first blind holes 50c are connected between the third horizontal copper foil 37a, the first horizontal copper foil 34a and the corresponding first horizontal transition structures 34f. The second blind holes 50d are connected between the fourth horizontal copper foil 37b, the second horizontal copper foil 34b and the corresponding sixth horizontal transition structures 34h. In an embodiment, conductive posts are disposed within the second through holes 30e, the first blind holes 50c and the second blind holes 50d.

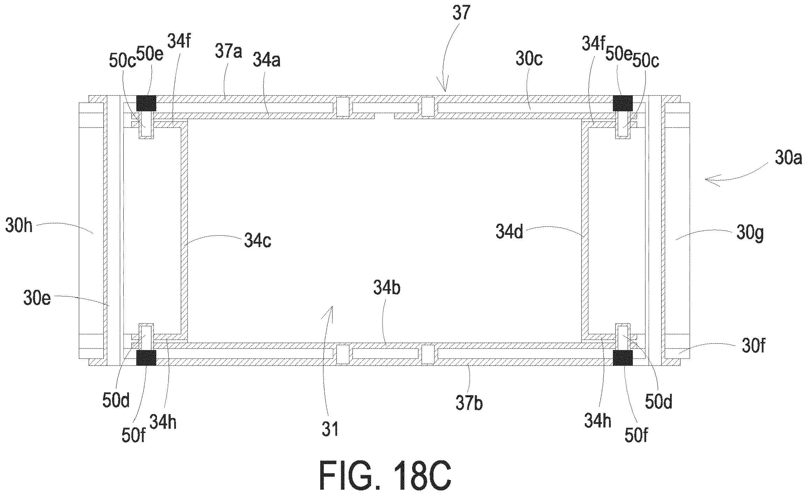

Please refer to FIG. 18C. Then, portions of the conductive posts in the plurality of first blind holes 50c are removed through a back-drilling process. Consequently, a plurality of first back-drill holes 50e are formed, and the third horizontal copper foil 37a and the first horizontal copper foil 34a are not electrically connected with each other. Moreover, portions of the conductive posts in the plurality of second blind holes 50d are removed through a back-drilling process. Consequently, a plurality of second back-drill holes 50f are formed, and the fourth horizontal copper foil 37b and the second horizontal copper foil 34b are not electrically connected with each other. The first horizontal copper foil 34a, the second horizontal copper foil 34b, the first horizontal transition structures 34f, the sixth horizontal transition structures 34h, the first connection copper foil 34c and the second connection copper foil 34d are collaboratively formed as a first metal structure 34. The third horizontal copper foil 37a, the fourth horizontal copper foil 37b and the conductive posts in the plurality of second through holes 30e are collaboratively formed as a second metal structure 37. Alternatively, the plurality of first back-drill holes 50e and the plurality of second back-drill holes 50f are plugged through a hole-plugging process such as a resin hole-plugging process or a green oil hole-plugging process. The first back-drill holes 50e and the second back-drill holes 50f are mechanical blind holes. Consequently, a certain precision level can be assured. For example, the precision level is within +/- 50 µm.

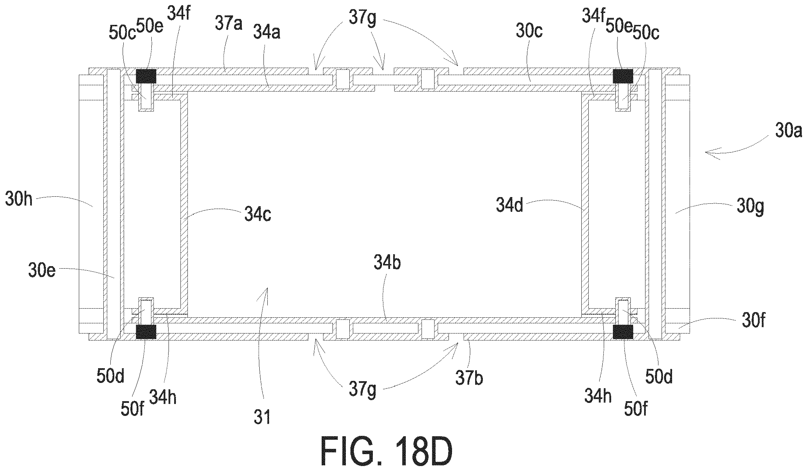

Please refer to FIG. 18D. Then, a metallization process is performed to form etch holes 37g in the third horizontal copper foil 37a and the fourth horizontal copper foil 37b.

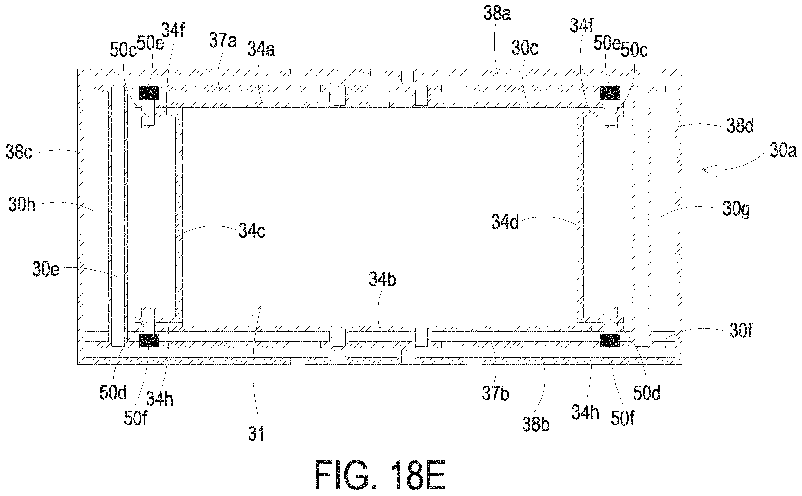

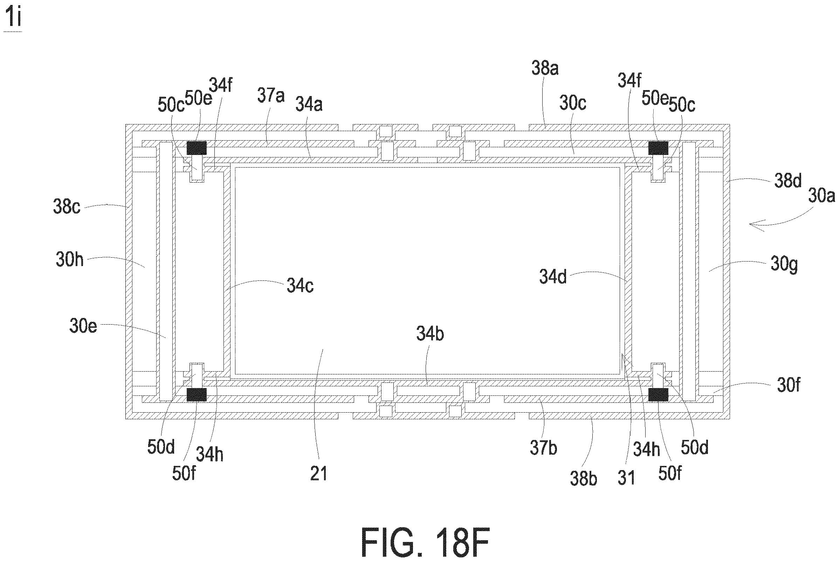

The steps of FIGS. 18E and 18F are similar to the steps of FIGS. 8F and 8G.

In an embodiment, the first metal structure 34 and the second metal structure 37 are formed simultaneously after the first back-drill holes 50e and the second back-drill holes 50f are formed. Consequently, the fabricating process is simplified, and the cost is reduced. Moreover, the first back-drill holes 50e and the second back-drill holes 50f are mechanical through holes or mechanical blind holes. When compared with the laser drilling method for the high density interconnector (HDI) board, the technology of the present invention is the ordinary printed circuit board technology and the production line is very mature. Consequently, the fabricating cost is further reduced. In this embodiment, the first metal structure 34 is formed on the four lateral surfaces of the inner wall of the first accommodation space 31. When compared with the structure of FIG. 17, the portion of the substrate 3 of this embodiment overlying the first magnetic part 31 is largely reduced. In case that the overall thickness of the magnetic element is not changed, the height and the cross-sectional area of the magnetic part can be increased. Consequently, the magnetic loss is reduced, and the efficiency is largely increased.

It is noted that numerous modifications and alterations may be made while retaining the teachings of the invention. For example, in the first embodiment to the tenth embodiment, the substrate 3 is equipped with the first metal structure 34 and the second metal structure 37, but is not equipped with the third metal structure.

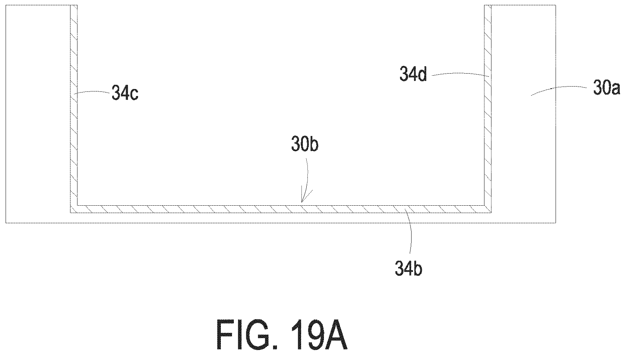

FIGS. 19A to 19F are schematic cross-sectional views illustrating a process of manufacturing a magnetic element according to an eleventh embodiment of the present invention.

Please refer to FG. 19A. Firstly, a base 30a with a recess 30b is provided. Then, a second horizontal copper foil 34b, a first connection copper foil 34c and a second connection copper foil 34d are formed on an inner wall of the recess 30b.

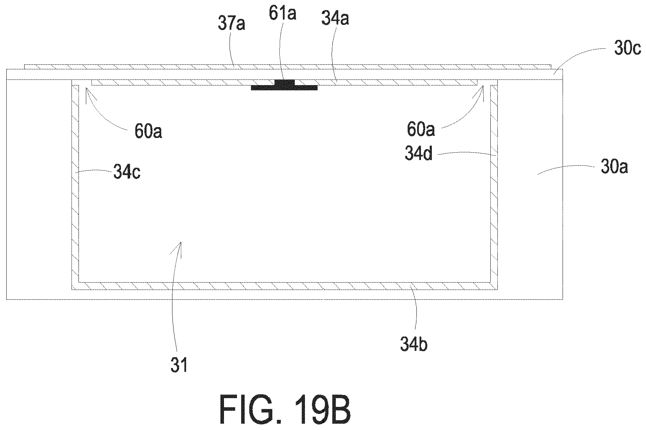

Please refer to FIG. 19B. Then, a top plate 30c, an electroless-plating resistant layer 61a, a first horizontal copper foil 34a and a third horizontal copper foil 37a are provided. The third horizontal copper foil 37a is disposed on a first side of the top plate 30c. The electroless-plating resistant layer 61a and the first horizontal copper foil 34a are disposed on a second side of the top plate 30c. The first horizontal copper foil 34a is divided into two segments by the electroless-plating resistant layer 61a. Then, the top plate 30c and the base 30a are laminated together. Consequently, a first accommodation space 31 is defined by the base 30a and the top plate 30c collaboratively. The first horizontal copper foil 34a, the second horizontal copper foil 34b, the first connection copper foil 34c, the second connection copper foil 34d and the electroless-plating resistant layer 61a are disposed within the first accommodation space 31. There is a gap 60a between a first portion of the first horizontal copper foil 34a and the first connection copper foil 34c. There is another gap 60a between a second portion of the first horizontal copper foil 34a and the second connection copper foil 34d. Due to the electroless-plating resistant layer 61a, the excessive copper is not electroplated on the first horizontal copper foil 34a during the copper electroplating process. Consequently, the two segments of the first horizontal copper foil 34a are located besides two opposite sides of the electroless-plating resistant layer 61a.

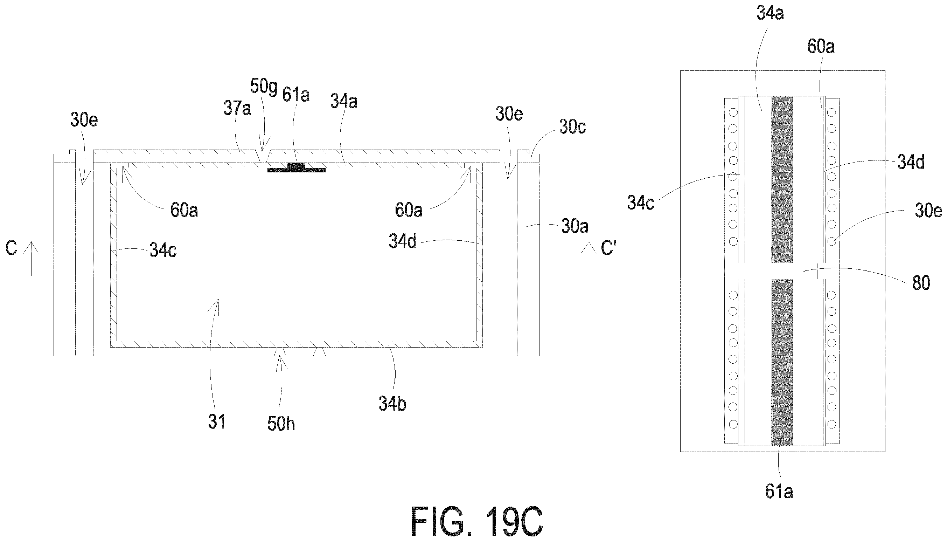

As shown in the left part of FIG. 19C, a plurality of second through holes 30e are formed in the base 30a through a hole-drilling process. The second through holes 30e also run through the top plate 30c and the third horizontal copper foil 37a. For example, the hole-drilling process is a mechanical hole-drilling process. In some embodiments, a third blind hole 50g is formed in the top plate 30c and the third horizontal copper foil 37a, and a fourth blind hole 50h is formed in the base 30a through a hole-drilling process. For example, the hole-drilling process is a laser hole-drilling process. The right part of FIG. 19C is a schematic cross-sectional view of the left part of FIG. 19C and taken along the line C-C'. As shown in the right part of FIG. 19C, the substrate 3 further includes a waist-shaped groove 80. The waist-shaped groove 80 is in communication with the first accommodation space 31.

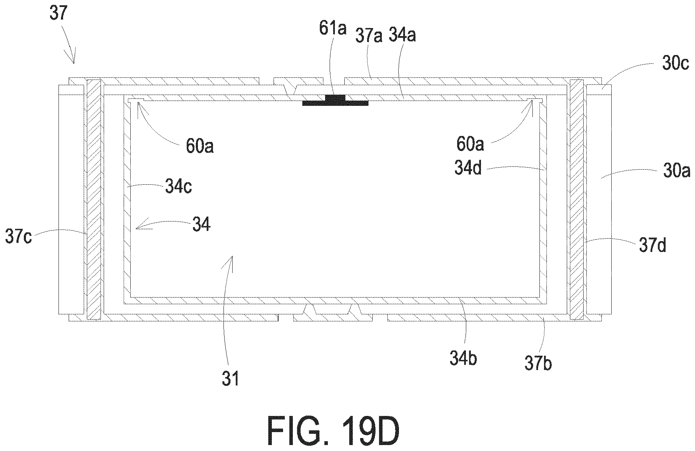

Please refer to FIG. 19D. Then, a fourth horizontal copper foil 37b is formed on the base 30a. The fourth horizontal copper foil 37b and the third horizontal copper foil 37a are opposite to each other with respect to the first accommodation space 31. Moreover, a third connection copper foil 37c and a fourth connection copper foil 37d are formed in the corresponding second through holes 30e. The third connection copper foil 37c is connected with a first end of the third horizontal copper foil 37a and a first end of the fourth horizontal copper foil 37b. The fourth connection copper foil 37d is connected with a second end of the third horizontal copper foil 37a and a second end of the fourth horizontal copper foil 37b. Since the gaps 60 are filled with copper foil, the first horizontal copper foil 34a is connected with the first connection copper foil 34c and the second connection copper foil 34d. The first connection copper foil 34c, the second connection copper foil 34d, the first horizontal copper foil 34a and the second horizontal copper foil 34b are collaboratively defined as a first metal structure 34. The third connection copper foil 37c, the fourth connection copper foil 37d, the third horizontal copper foil 37a and the fourth horizontal copper foil 37b are collaboratively defined as a second metal structure 37. In this embodiment, the entire of the first metal structure 34 is disposed on the inner wall of the first accommodation space 31. Due to the arrangement of the electroless-plating resistant layer 61a, the seed copper is not formed on the position of the electroless-plating resistant layer 61a during the copper electroplating process, and the connection copper foil is not formed on the position of the electroless-plating resistant layer 61a during the copper electroplating process.

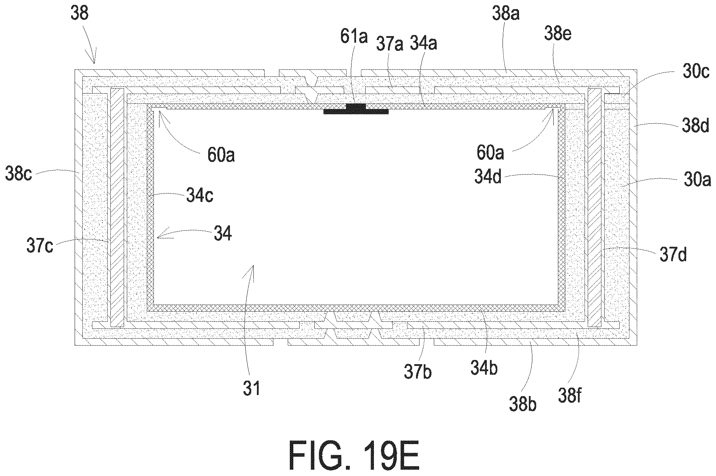

Please refer to FIG. 19E. Then, a fifth horizontal copper foil 38a, a sixth horizontal copper foil 38b, a fifth connection copper foil 38c, a sixth connection copper foil 38d, a third insulation layer 38e and a fourth insulation layer 38f are disposed on the outside of the second metal structure 37. The third insulation layer 38e is arranged between the fifth horizontal copper foil 38a and the third horizontal copper foil 37a. The fourth insulation layer 38f is arranged between the sixth horizontal copper foil 38b and the fourth horizontal copper foil 37b. The fifth connection copper foil 38c is connected between a first end of the fifth horizontal copper foil 38a and a first end of the sixth horizontal copper foil 38b. The sixth connection copper foil 38d is connected between a second end of the fifth horizontal copper foil 38a and a second end of the sixth horizontal copper foil 38b. The fifth horizontal copper foil 38a, the sixth horizontal copper foil 38b, the fifth connection copper foil 38c and the sixth connection copper foil 38d are collaboratively formed as a third metal structure 38. In this embodiment, the third metal structure 38 is formed through a hole drilling process or a metallization process. The first metal structure 34 and the second metal structure 37 are connected with each other through conductive posts. The second metal structure 37 and the third metal structure 38 are connected with each other through conductive posts. The conductive posts are formed through formed through a machining process or a laser drilling process. In some embodiments, each of the fifth connection copper foil 38c and the sixth connection copper foil 38d is formed by cutting a conductive post that are shared by two adjacent substrates 3.

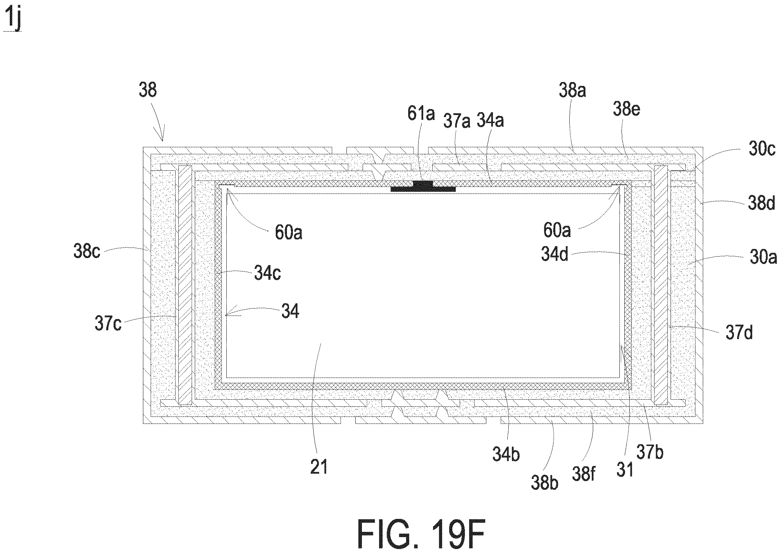

Please refer to FIG. 19F. Then, a first magnetic part 21 is disposed within the first accommodation space 31 of the substrate 3. Consequently, the magnetic element 1j is produced. In an embodiment, the magnetic element 1j is equipped with the first metal structure 34 and the third metal structure 38, but not equipped with the second metal structure 37. In another embodiment, the magnetic element 1j is equipped with the first metal structure 34, but not equipped with the second metal structure 37 and the third metal structure 38.

In this embodiment, the entire of the first metal structure 34 is formed on the inner wall of the first accommodation space 31 of the magnetic element 1j. Consequently, it is not necessary to connect other metal parts with other metal structures (e.g., horizontal transition structures). In addition, it is not necessary to provide an additional insulation structure to separate the first metal structure from other metal structures. Since the width and the height of the first metal structure 34 are smaller, the dimension of the magnetic element 1j can be further reduced, and the power density of the magnetic element 1j can be enhanced. In case that the dimension of the magnetic element 1j is not changed, the dimension of the magnetic core assembly can be increased. Consequently, the magnetic loss can be effectively reduced, and the efficiency of the magnetic element 1j can be increased.

As mentioned above, the entire of the first metal structure 34 is formed on the inner wall of the first accommodation space 31. However, the first horizontal copper foil 34a of the first metal structure 34 is still formed in the first horizontal wiring layer, and the second horizontal copper foil 34b of the first metal structure 34 is still formed in a second horizontal wiring layer.

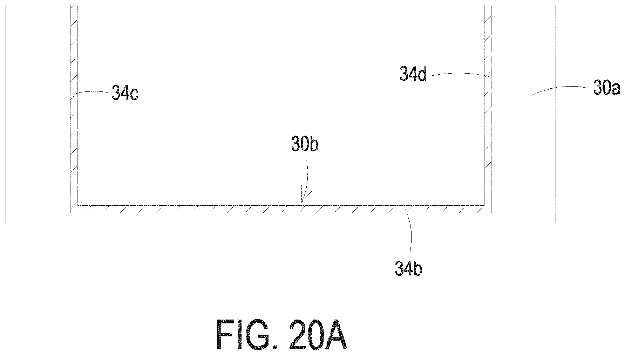

FIGS. 20A to 20E are schematic cross-sectional views illustrating a process of manufacturing a magnetic element according to a twelfth embodiment of the present invention.

Please refer to FG. 20A. Firstly, a base 30a with a recess 30b is provided. Then, a second horizontal copper foil 34b, a first connection copper foil 34c and a second connection copper foil 34d are formed on an inner wall of the recess 30b.

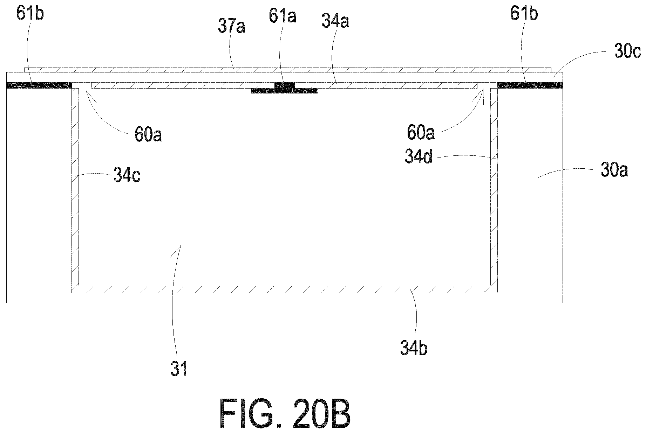

Then, the step of FIG. 20B is performed. The step of FIG. 20B is similar to the step of FIG. 19B. However, as shown in FIG. 20B, the substrate 3 further includes two insulation layers 61b. One of the two insulation layers 61b is arranged between the top plate 30c and a first end of the base 30a. The other insulation layer 61b is arranged between the top plate 30c and a second end of the base 30a.

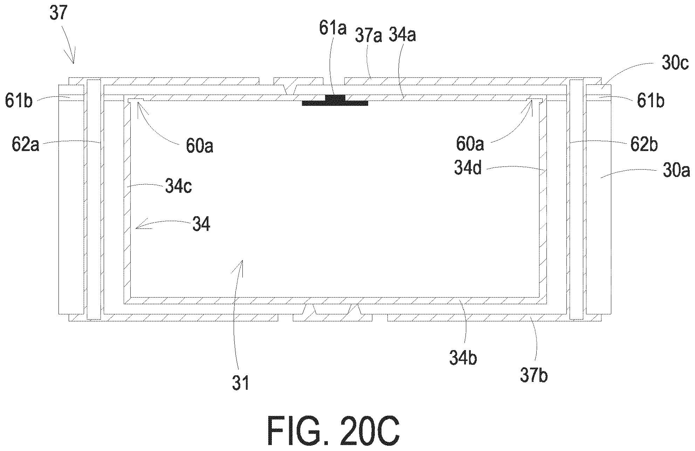

Please refer to FIG. 20C. Then, a fourth horizontal copper foil 37b is formed on the base 30a. The fourth horizontal copper foil 37b and the third horizontal copper foil 37a are opposite to each other with respect to the first accommodation space 31. Then, a first shared conductive post 62a and a second shared conductive post 62b are formed. The first shared conductive post 62a is connected with a first end of the third horizontal copper foil 37a and a first end of the fourth horizontal copper foil 37b, and the first shared conductive post 62a is penetrated through the corresponding insulation layer 61b. The second shared conductive post 62b is connected with a second end of the third horizontal copper foil 37a and a second end of the fourth horizontal copper foil 37b, and the second shared conductive post 62b is penetrated through the corresponding insulation layer 61b.

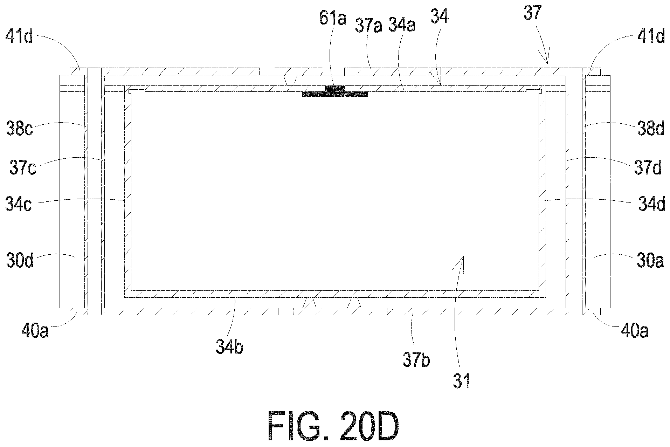

Please refer to FIG. 20D. The first shared conductive post 62a and the second shared conductive post 62b are respectively cut by a mechanical cutting process. Then, the first shared conductive post 62a is cut into a third connection copper foil 37c and a fifth connection copper foil 38c, and the second shared conductive post 62b is cut into a fourth connection copper foil 37d and a sixth connection copper foil 38c. In this step, the two ends of the third horizontal copper foil 37a are cut off, and two fourth horizontal transition structures 41d are formed on the two ends of the third horizontal copper foil 37a. In addition, the two ends of the fourth horizontal copper foil 37b are cut off, and two fifth horizontal transition structures 40a are formed on the two ends of the fourth horizontal copper foil 37b. The first horizontal copper foil 34a, the second horizontal copper foil 34b, the first connection copper foil 34c and the second connection copper foil 34d are collaboratively defined as a first metal structure 34. The third connection copper foil 37c, the fourth connection copper foil 37d, the third horizontal copper foil 37a and the fourth horizontal copper foil 37b are collaboratively defined as a second metal structure 37.

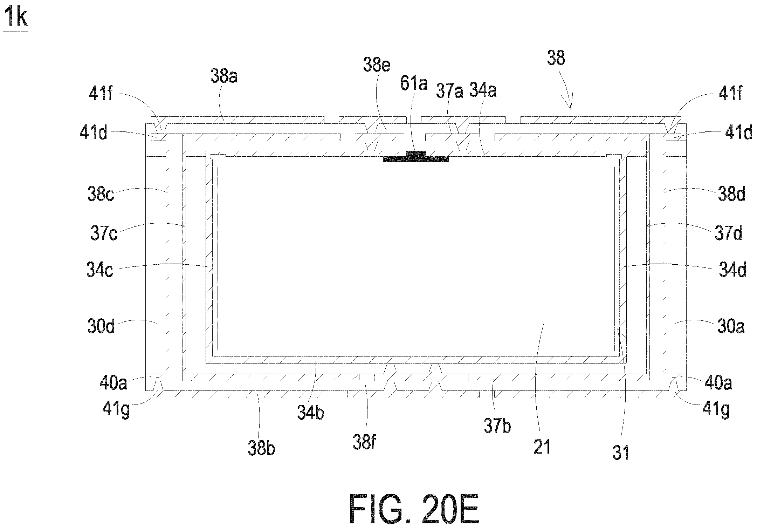

Please refer to FIG. 20E. Then, a fifth horizontal copper foil 38a and a third insulation layer 38e are formed on the third horizontal copper foil 37a. The third insulation layer 38e is arranged between the fifth horizontal copper foil 38a and the third horizontal copper foil 37a. The two ends of the fifth horizontal copper foil 38a are connected with the corresponding fourth horizontal transition structures 41d through two fourth conductive posts 41f respectively. Moreover, a sixth horizontal copper foil 38b and a fourth insulation layer 38f are formed on the fourth horizontal copper foil 37b. The fourth insulation layer 38f is arranged between the sixth horizontal copper foil 38b and the fourth horizontal copper foil 37b. The two ends of the sixth horizontal copper foil 38b are connected with the corresponding fifth horizontal transition structures 40a through corresponding fifth conductive posts 41g respectively. The fifth horizontal copper foil 38a, the sixth horizontal copper foil 38b, the fifth connection copper foil 38c, the sixth connection copper foil 38d, the two fifth horizontal transition structures 40a, the two fourth horizontal transition structures 41d, the two fourth conductive posts 41f and the two fifth conductive posts 41g are collaboratively formed as a third metal structure 38. Then, a first magnetic part 21 is disposed within the first accommodation space 31 of the substrate 3. Consequently, the magnetic element 1k is produced. In this embodiment, the first shared conductive post 62a and the second shared conductive post 62b are cut through a mechanical cutting process.

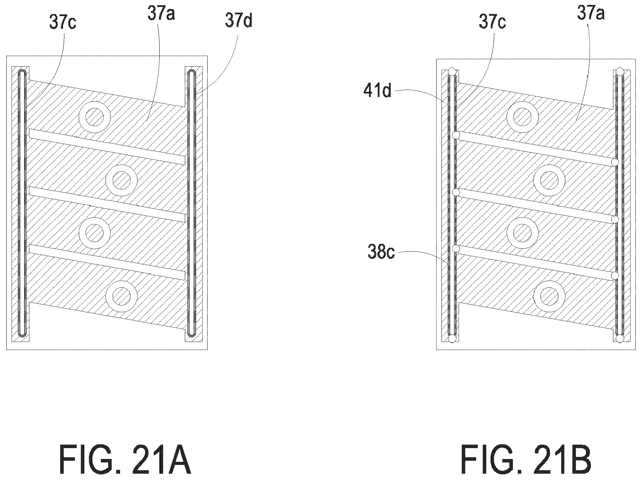

FIG. 21A is a schematic top view of the structure as shown in FIG. 20C. FIG. 21B is a schematic top view of the structure as shown in FIG. 20D. In this embodiment, the third connection copper foil 37c and the fourth connection copper foil 37d of the second metal structure 37 are lateral copper structures. Consequently, the width of the second metal structure 37 of the magnetic element 1k is smaller and the fabricating process is well-established fabricating process. If the panelization technology is used, the benefit of mass production is achieved. Moreover, the third connection copper foil 37c and the fourth connection copper foil 37d of the second metal structure 37 and the fifth connection copper foil 38c and the sixth connection copper foil 38d of the third metal structure 38 are formed through a single electroplating process and a mechanical cutting process. Consequently, the fabricating time and the cost are reduced. In this embodiment, the first metal structure 34 is formed on the four lateral sides of the inner wall of the first accommodation space 31.

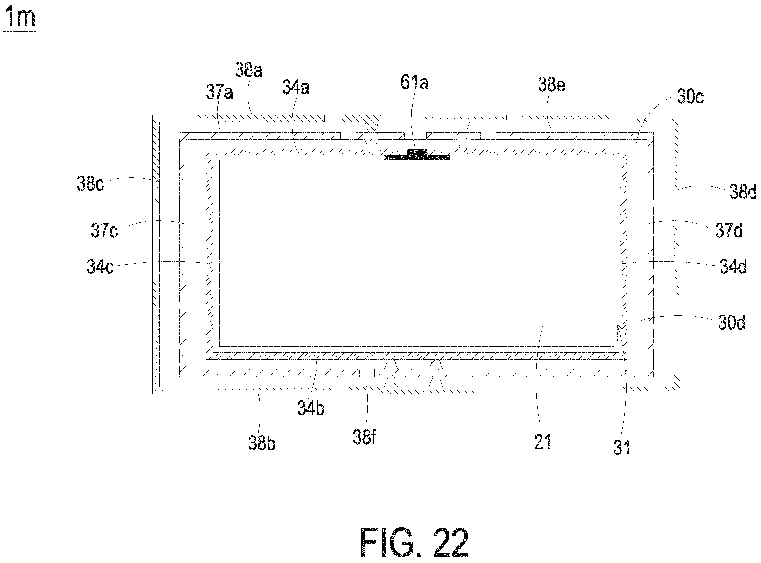

FIG. 22 is a schematic cross-sectional view illustrating a magnetic element according to a thirteenth embodiment of the present invention. In comparison with the magnetic element 1k of FIG. 20E, the substrate 3 of the magnetic element 1m of this embodiment is not equipped with the two fourth horizontal transition structures 41d and the two fifth horizontal transition structures 40a. In this embodiment, the two ends of the fifth horizontal copper foil 38a are directly connected with a first end of the fifth connection copper foil 38c and a first end of the sixth connection copper foil 38d, and the two ends of the sixth horizontal copper foil 38b are directly connected with a second end of the fifth connection copper foil 38c and a second end of the sixth connection copper foil 38d. Since the fourth horizontal transition structures and the fifth horizontal transition structures are omitted, the overall dimension of the substrate 3 is reduced. In some embodiments, the fourth horizontal transition structures and the fifth horizontal transition structures are removed through a slot-milling process.

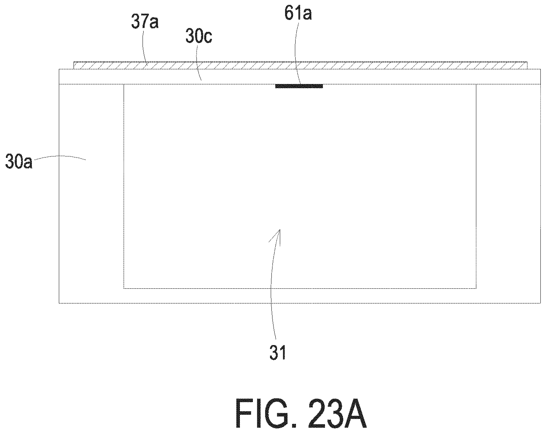

FIGS. 23A to 23F are schematic cross-sectional views illustrating a process of manufacturing a magnetic element according to a fourteenth embodiment of the present invention.

Please refer to FG. 23A. Firstly, a top plate 30c, a base 30a, a third horizontal copper foil 37a and an electroless-plating resistant layer 61a are provided. The top plate 30c is disposed on the base 30a. Consequently, a first accommodation space 31 is defined by the base 30a and the top plate 30c collaboratively. The third horizontal copper foil 37a and the electroless-plating resistant layer 61a are opposite to each other with respect to the top plate 30c. The electroless-plating resistant layer 61a is disposed within the first accommodation space 31.

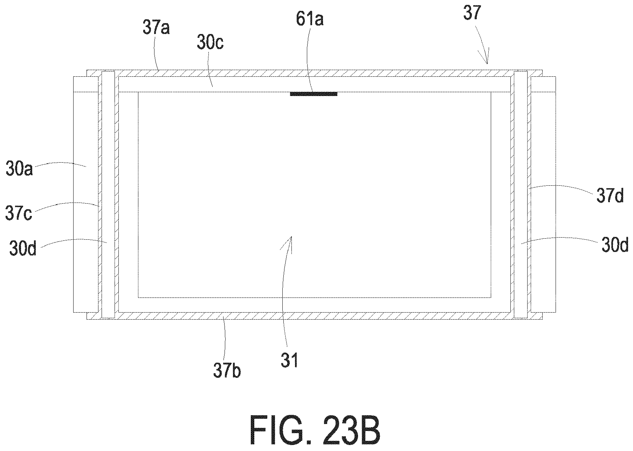

Please refer to FIG. 23B. Then, a fourth horizontal copper foil 37b is formed on the base 30a. The fourth horizontal copper foil 37b and the third horizontal copper foil 37a are opposite to each other with respect to the first accommodation space 31. The base 30a further includes a plurality of first through holes 30d. The first through holes 30d run through the top plate 30c and the base 30a. In addition, the first through holes 30d are arranged between the third horizontal copper foil 37a and the fourth horizontal copper foil 37b. Moreover, the third connection copper foil 37c and the fourth connection copper foil 37d are formed in the corresponding first through holes 30d and penetrated through the top plate 30c and the base 30a. The two ends of the third connection copper foil 37c are connected with a first end of the third horizontal copper foil 37a and a first end of the fourth horizontal copper foil 37b. The two ends of the fourth connection copper foil 37d are connected with a second end of the third horizontal copper foil 37a and a second end of the fourth horizontal copper foil 37b. The third horizontal copper foil 37a, the fourth horizontal copper foil 37b, the third connection copper foil 37c and the fourth connection copper foil 37d are collaboratively defined as a second metal structure 37.

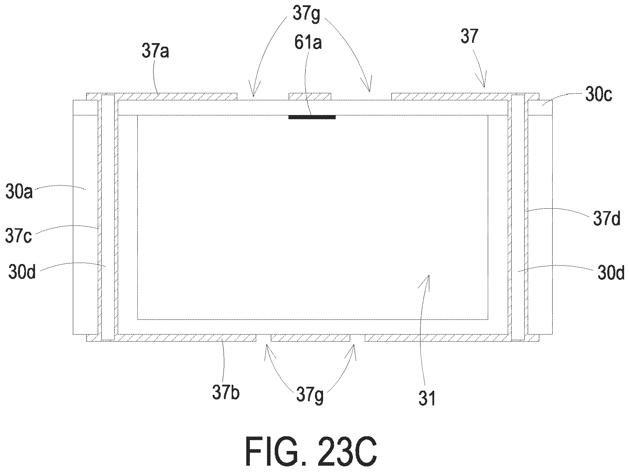

Please refer to FIG. 23C. Then, a metallization process is performed to form etch holes 37g in the third horizontal copper foil 37a and the fourth horizontal copper foil 37b.

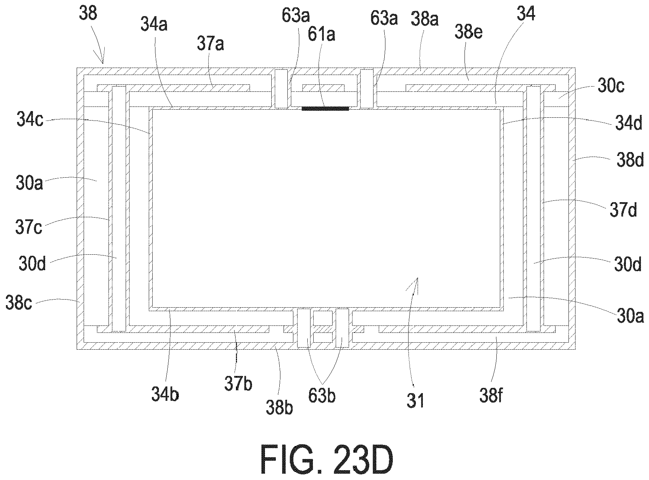

Please refer to FIG. 23D. Then, a third insulation layer 38e is formed on the third horizontal copper foil 37a, and a fourth insulation layer 38f is formed on the fourth horizontal copper foil 37b. Then, a plurality of third through holes 63a and a plurality of fourth through holes 63b are formed. The third through holes 63a run through the third insulation layer 38e and the top plate 30c. The fourth through holes 63b run through the fourth insulation layer 38f and the base 30a. Then, a first horizontal copper foil 34a, a second horizontal copper foil 34b, a first connection copper foil 34c and a second connection copper foil 34d are formed on an inner wall of the first accommodation space 31 through the plurality of third through holes 63a and the plurality of fourth through holes 63b by using a metallization process. The two ends of the first horizontal copper foil 34a are connected with a first end of the first connection copper foil 34c and a first end of the second connection copper foil 34d. The two ends of the second horizontal copper foil 34b are connected with a second end of the first connection copper foil 34c and a second end of the second connection copper foil 34d. The first horizontal copper foil 34a, the second horizontal copper foil 34b, the first connection copper foil 34c and the second connection copper foil 34d are collaboratively defined as a first metal structure 34. The portion of the inner wall of the first accommodation space 31 corresponding to the electroless-plating resistant layer 61a are not plated with the first metal structure 34. In this embodiment, a fifth horizontal copper foil 38a is formed on the third insulation layer 38e, and a sixth horizontal copper foil 38b is formed on the fourth insulation layer 38f. In addition, a fifth connection copper foil 38c and a sixth connection copper foil 38d are formed. The fifth connection copper foil 38c is connected between a first end of the fifth horizontal copper foil 38a and a first end of the sixth horizontal copper foil 38b. The sixth connection copper foil 38d is connected between a second end of the fifth horizontal copper foil 38a and a second end of the sixth horizontal copper foil 38b. The fifth horizontal copper foil 38a, the sixth horizontal copper foil 38b, the fifth connection copper foil 38c and the sixth connection copper foil 38d are collaboratively formed as a third metal structure 38.

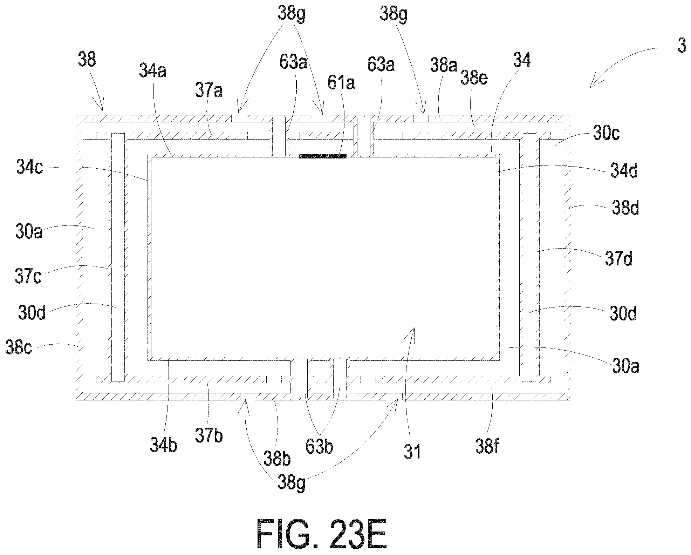

Please refer to FIG. 23E. Then, a metallization process is performed to form etch holes 38g in the fifth horizontal copper foil 38a and the sixth horizontal copper foil 38b.

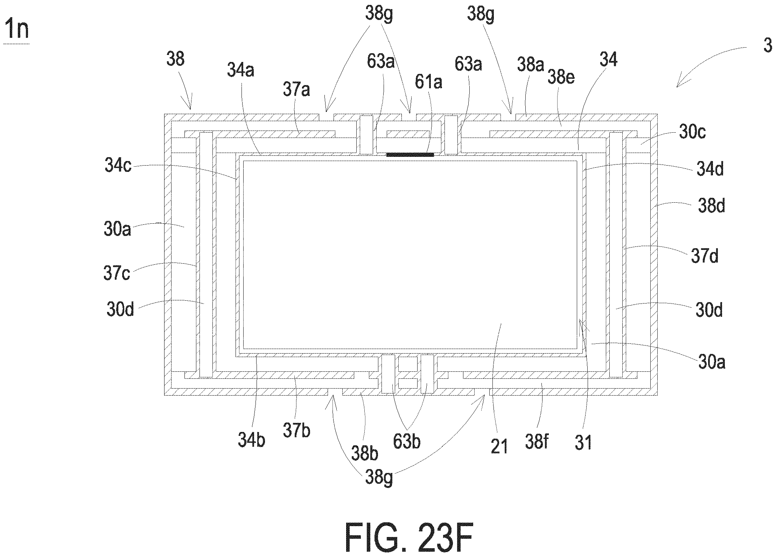

Please refer to FIG. 23F. Then, a first magnetic part 21 is disposed within the first accommodation space 31 of the substrate 3. Consequently, the magnetic element In is produced. In this embodiment, the first metal structure 34 is formed on the four lateral sides of the inner wall of the first accommodation space 31.

In this embodiment, the first metal structure 34 and the third metal structure 38 of the magnetic element In are simultaneously formed through a single electroplating process. Consequently, the fabricating time and the fabricating cost are largely reduced.

It is noted that numerous modifications and alterations may be made while retaining the teachings of the invention. For example, the step of FIG. 19A may be used to manufacture the substrate of FIG. 23F. For example, the second horizontal copper foil 34b, the first connection copper foil 34c and the second connection copper foil 34d are previously formed on the inner wall of the first accommodation space 31. After a subsequent metallization process is performed, the copper foil thickness is further increased. Consequently, the current flow capacity is enhanced.

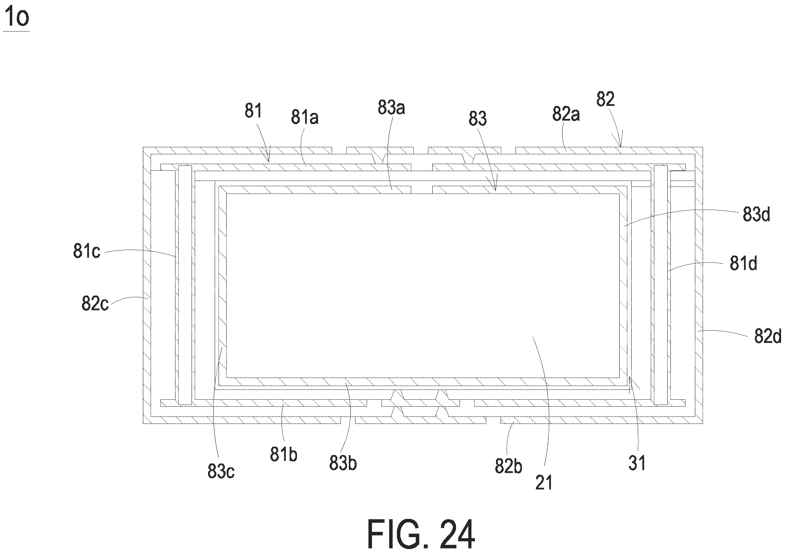

FIG. 24 is a schematic cross-sectional view illustrating a magnetic element according to a fifteenth embodiment of the present invention. In this embodiment, the substrate 3 of the magnetic element 1o includes a first metal structure 81 and a second metal structure 82. The first metal structure 81 includes a third connection copper foil 81c, a fourth connection copper foil 81d, a third horizontal copper foil 81a and a fourth horizontal copper foil 81b. The third connection copper foil 81c, the fourth connection copper foil 81d, the third horizontal copper foil 81a and the fourth horizontal copper foil 81b of the first metal structure 81 are respectively similar to the third connection copper foil 37c, the fourth connection copper foil 37d, the third horizontal copper foil 37a and the fourth horizontal copper foil 37b of the second metal structure 37 as shown in FIG. 19F. The second metal structure 82 includes a fifth horizontal copper foil 82a, a sixth horizontal copper foil 82b, a fifth connection copper foil 82c and a sixth connection copper foil 82d. The fifth horizontal copper foil 82a, the sixth horizontal copper foil 82b, the fifth connection copper foil 82c and the sixth connection copper foil 82d of the second metal structure 82 are respectively similar to the fifth horizontal copper foil 38a, the sixth horizontal copper foil 38b, the fifth connection copper foil 38c and the sixth connection copper foil 38d of the third metal structure 38 as shown in FIG. 19F.

The magnetic element 1o further includes a fourth metal structure 83. The fourth metal structure 83 is attached on the first magnetic part 21. The fourth metal structure 83 includes an eighth horizontal copper foil 83a, a ninth horizontal copper foil 83b, an eighth connection copper foil 83c and a ninth connection copper foil 83d. The eighth horizontal copper foil 83a and the ninth horizontal copper foil 83b are on two opposite sides of the first magnetic part 21. The eighth connection copper foil 83c and the ninth connection copper foil 83d are on the other two opposite sides of the first magnetic part 21. The eighth connection copper foil 83c is connected between a first end of the eighth horizontal copper foil 83a and a first end of the ninth horizontal copper foil 83b. The ninth connection copper foil 83d is connected between a second end of the eighth horizontal copper foil 83a and a second end of the ninth horizontal copper foil 83b. In this embodiment, only a portion of the fourth metal structure 83 is attached on the first magnetic part 21. Consequently, there is a gap between the two segments of the eighth horizontal copper foil 83a.

In the magnetic element 1 to the magnetic element In of the above embodiments 1∼1n), the magnetic parts may be bare magnetic parts. Optionally, a fourth insulation structure is formed on the surface of the bare magnetic part through a spraying process, a dipping process, an electrophoresis process, an electrostatic spraying process, a chemical vapor deposition process, a physical vapor deposition process, a sputtering process, an evaporation process or a printing process. The fourth insulation structure can provide an insulating function. The fourth insulation structure can cover the entire of the magnetic part or a portion of the magnetic part. As shown in FIG. 5, the first magnetic part, the second magnetic part, the third magnetic part and the fourth magnetic part of the magnetic core assembly of the magnetic element are connected with each other in an end-to-end manner. For achieving the requirement inductance, adhesives with glass beads are disposed in the contact region between the first magnetic part and the third magnetic part and the contact region between the first magnetic part and the fourth magnetic part. The inductance may be adjusted according to the dimension of the glass beads. Under this circumstance, the fourth insulation structure may be omitted.

In the magnetic element 1o, the fourth metal structure 83 is attached on the first magnetic part 21. Consequently, it is not necessary to connect other metal parts with other metal structures (e.g., horizontal transition structures). In some embodiments, a thin insulation layer (not shown) is formed on the surface of the first magnetic part through a spraying process, a dipping process, an electrophoresis process, an electrostatic spraying process, a chemical vapor deposition process, a physical vapor deposition process, a sputtering process, an evaporation process or a printing process. Consequently, the insulation between the fourth metal structure 83 and the first magnetic part 21 is achieved. The thickness of the thin insulation layer is smaller than 20µm. Since the width and the height of the fourth metal structure 83 are smaller, the dimension of the magnetic element 1o can be further reduced, and the power density of the magnetic element 1o can be enhanced. In case that the dimension of the magnetic element 1o is not changed, the dimension of the magnetic core assembly can be increased. Consequently, the magnetic loss can be effectively reduced, and the efficiency of the magnetic element 1o can be increased.

It is noted that the features of different embodiments may be combined together according to the practical requirements. Consequently, the dimension of the power module can be further reduced, and the power density can be further enhanced.

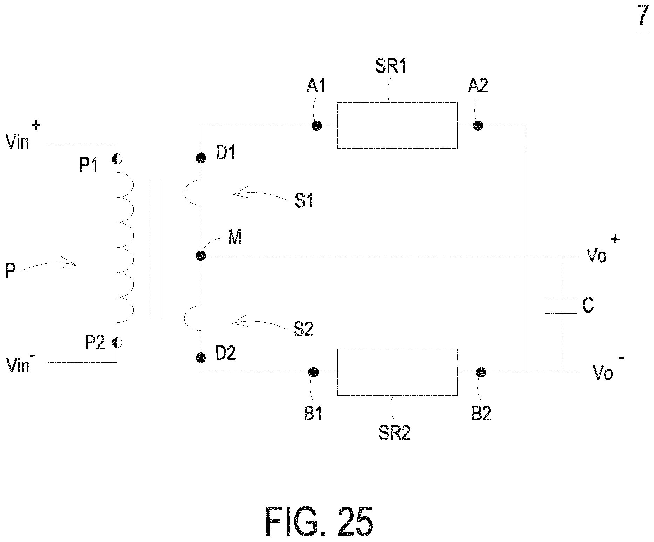

FIG. 25 is a schematic circuit diagram illustrating a power module with the magnetic element of the present invention. For illustration, the magnetic module has the structure as shown in FIG. 8G. It is noted that the magnetic element of any of the above embodiments can be applied to the power module. The power module 7 is connected between an input side and an output side. The input side includes a positive input terminal Vin+ and a negative input terminal Vin-. The output side includes a positive output terminal Vo+ and a negative output terminal Vo-. The power module 7 includes the magnetic element and electronic components. The magnetic element includes a primary winding P, a first secondary winding S1 and a second secondary winding S2. The electronic components include two power switches SR1, SR2 and a capacitor C. A first terminal P1 of the primary winding P is connected with the positive input terminal Vin+. A second terminal P2 of the primary winding P is connected with the negative input terminal Vin-. A first terminal D1 of the first secondary winding S1 is connected with a first terminal A1 of the power switch SR1. A second terminal of the first secondary winding S 1 and a first terminal of the second secondary winding S2 are connected with a node M. A second terminal D2 of the second secondary winding S2 is connected with a first terminal B1 of the power witch SR2. The node M is connected with the positive output terminal Vo+. A second terminal A2 of the power switch SR1 and a second terminal B2 of the power switch SR2 are connected with each other and connected to the negative output terminal Vo-. The capacitor C is connected between the positive output terminal Vo+ and the negative output terminal Vo-. In an embodiment, the first secondary winding S1 is implemented with the first metal structure 34 of the magnetic element 1, the second secondary winding S2 is implemented with the second metal structure 37 of the magnetic element 1, and the primary winding P is implemented with the third metal structure 38 of the magnetic element 1. In some embodiment, the primary winding P, the first secondary winding S1 and the second secondary winding S2 are implemented with the first metal structure 34, the second metal structure 37 and the third metal structure 38 of the magnetic element 1, respectively.

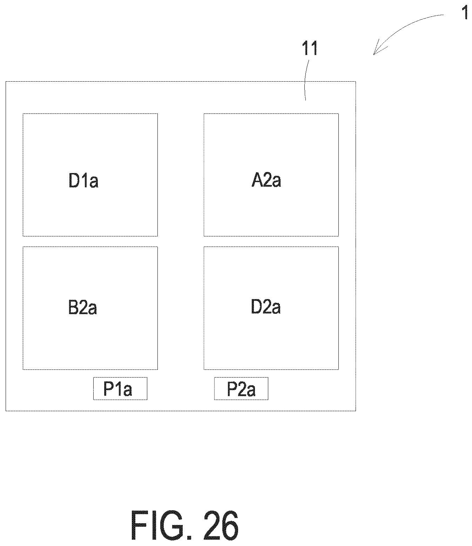

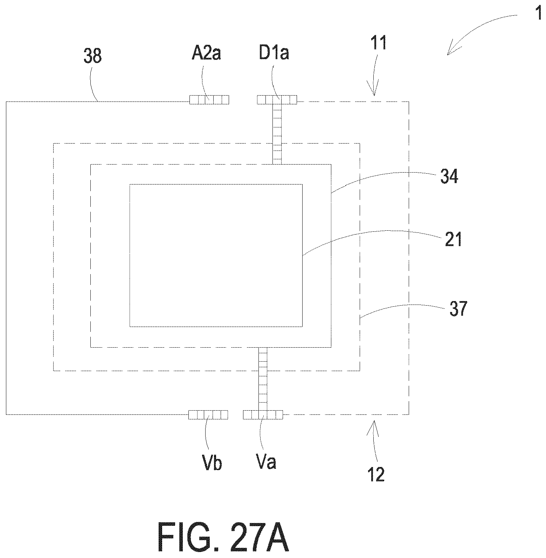

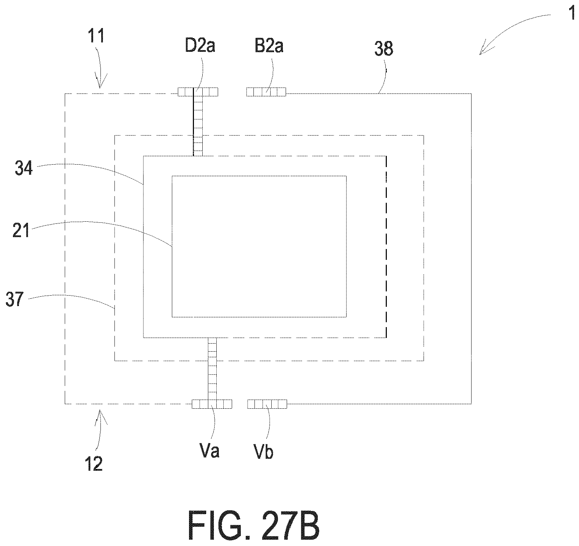

Please refer to FIGS. 25, 26, 27A and 27B. FIG. 26 is a schematic top view illustrating a top surface of the magnetic element as shown in FIG. 8G. FIG. 27A schematically illustrates the primary winding and the secondary winding of the magnetic element as shown in FIG. 26 and taken along a viewpoint. FIG. 27B schematically illustrates the primary winding and the secondary winding of the magnetic element as shown in FIG. 26 and taken along another viewpoint.

As shown in FIG. 26, a first surface mount pin D1a, a third surface mount pin A2a, a fifth surface mount pin D2a, a sixth surface mount pin B2a, a seventh surface mount pin P1a and an eighth surface mount pin P2a are disposed on a top surface 11 of the magnetic element 1. The first surface mount pin D1a is used as the first terminal D1 of the first secondary winding S1 and the first terminal A1 of the power switch SR1 as shown in FIG. 25. The third surface mount pin A2a is used as the second terminal A2 of the power switch SR1 as shown in FIG. 25. The fifth surface mount pin D2a is used as the second terminal D2 of the second secondary winding S2 and the first terminal B1 of the power witch SR2 as shown in FIG. 25. The sixth surface mount pin B2a is used as the second terminal B2 of the power switch SR2 as shown in FIG. 25. The seventh surface mount pin P1a is used as the first terminal P1 of the primary winding P as shown in FIG. 25. The eighth surface mount pin P2a is used as the second terminal P2 of the primary winding P as shown in FIG. 25.

As shown in FIGS. 27A and 27B, a second surface mount pin Va and a fourth surface mount pin Vb are disposed on a bottom surface 12 of the magnetic element 1. The second surface mount pin Va is used as the positive output terminal Vo+ as shown in FIG. 25. The fourth surface mount pin Vb is used as the negative output terminal Vo as shown in FIG. 25.

As shown in FIG. 27A, a first portion of the first metal structure 34 (e.g., the region indicated by solid lines) and a first portion of the third metal structure 38 (e.g., the region indicated by dotted lines) are formed as the first secondary winding S1 (i.e., the second winding). Consequently, the first secondary winding S1 is flat-wounded on the first magnetic part 21. A first end of the first portion of the first metal structure 34 is connected with the first surface mount pin D1a. A second end of the first portion of the first metal structure 34 is connected with the second surface mount pin Va. A first end of the first portion of the third metal structure 38 is connected with the third surface mount pin A2a. A second end of the first portion of the third metal structure 38 is connected with the fourth surface mount pin Vb. As shown in FIG. 27B, a second portion of the first metal structure 34 (e.g., the region indicated by solid lines) and a second portion of the third metal structure 38 (e.g., the region indicated by solid lines) are formed as the second secondary winding S2 (i.e., the third winding). Consequently, the second secondary winding S2 is flat-wounded on the first magnetic part 21. A first end of the second portion of the first metal structure 34 is connected with the fifth surface mount pin D2a. A second end of the second portion of the first metal structure 34 is connected with the second surface mount pin Va. A first end of the second portion of the third metal structure 38 is connected with the sixth surface mount pin B2a. A second end of the second portion of the third metal structure 38 is connected with the fourth surface mount pin Vb.

In an embodiment, the second metal structure 37 is served as the primary winding P as shown in FIG. 25. The second metal structure 37 is connected with the seventh surface mount pin P1a and the eighth surface mount pin P2a. The first secondary winding S1 and the second secondary winding S2 are distributed in a split-level arrangement. Since the symmetry between the first secondary winding S1 and the second secondary winding S2 is improved, the current-sharing efficacy of the currents flowing through the power switches SR1 and SR2 are enhanced.

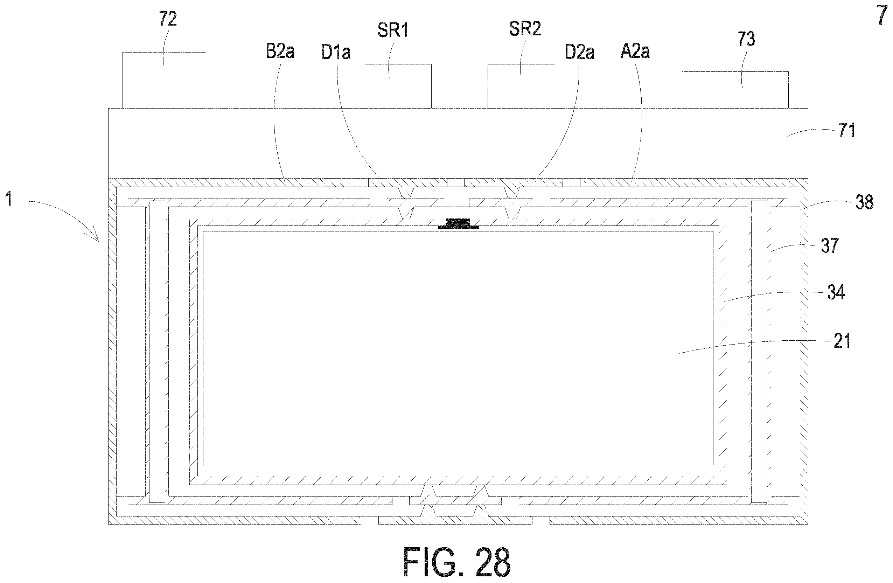

Please refer to FIGS. 25, 26, 27A, 27B and 28. FIG. 28 is a schematic cross-sectional view illustrating a first example of the power module as shown in FIG. 25. For illustration, the magnetic module has the structure as shown in FIG. 8G. It is noted that the magnetic element of any of the above embodiments can be applied to the power module. The power module 7 includes the magnetic element 1, a circuit board 71, primary side components 72, secondary side components 73 and the power switches SR1, SR2. The primary side components 72 and the secondary side components 73 are passive components. The circuit board 71 is disposed on the magnetic element 1. The primary side components 72, the secondary side components 73 and the power switches SR1, SR2 are disposed on the circuit board 71. The first terminal of the power switch SR1 is electrically connected with the first surface mount pin D1a through the circuit board 71. The first terminal of the power switch SR2 is electrically connected with the fifth surface mount pin D2a through the circuit board 71. The second terminal of the power switch SR1 and the second terminal of the power switch SR2 are electrically connected with each other through the circuit board 71.

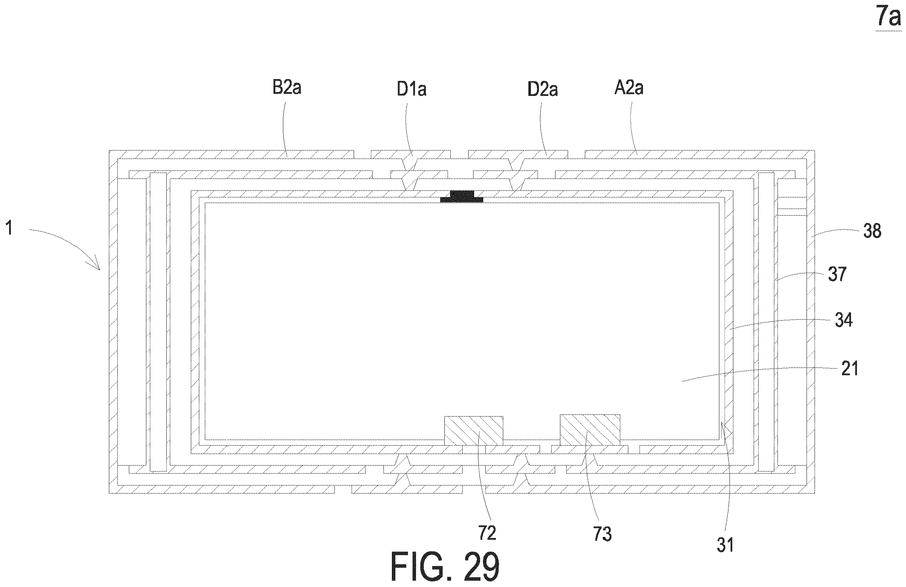

It is noted that numerous modifications and alterations may be made while retaining the teachings of the invention. For example, the number of the power switches may be varied according to the practical requirements. FIG. 29 is a schematic cross-sectional view illustrating a second example of the power module as shown in FIG. 25. In this embodiment, the power module 7a is not equipped with a circuit board. The primary side components 72 and the secondary side components 73 are disposed within the first accommodation space 31. Consequently, the current loop is shorter.

The power module is not restricted to the LLC converter. That is, the power converter may be applied to any other appropriate circuit including a transformer module, e.g., a flyback converter or a bridge circuit. Since the power switches are directly connected with a plurality of output terminals of the magnetic element, the connecting loss is reduced. Moreover, since the primary winding and the secondary windings of the magnetic element are magnetically coupled with each other, the AC impedance and the AC loss are reduced.

From the above descriptions, the present invention provides the magnetic element. The first magnetic part is disposed within the first accommodation space of the substrate. The second magnetic part is disposed within the second accommodation space of the substrate. For a three-layered winding assembly, since the distances between the three layers of the winding assembly and the first magnetic part and the distances between the corresponding layers of the winding assembly and the second magnetic part are nearly equal, the current distribution is more uniform and the overall magnetic loss of the magnetic element is reduced. Moreover, since the first magnetic part and the second magnetic part are arranged independently and respectively disposed within the first accommodation space and the second accommodation space, the first magnetic part and the second magnetic part can be polished separately. Moreover, since the first magnetic part and the second magnetic part are respectively disposed within the first accommodation space and the second accommodation space of the substrate, the first magnetic part and the second magnetic part are not influenced by each other. After the first magnetic part and the second magnetic part are polished separately, the first magnetic part and the second magnetic part are disposed in the corresponding accommodation spaces. In other words, the position precision of the first magnetic part and the position precision of the second magnetic part are not related to each other. Moreover, the position precision between the first magnetic part and the second magnetic part is determined according to the position precision between the first accommodation space and the second accommodation space. Since the dimension precision of the magnetic core assembly of the magnetic element is very high, the magnetic loss of the magnetic element is low and the overall dimension of the magnetic element is reduced.

## Claims

1. A magnetic element (1, 1a, 1b, 1c, 1d, 1e, 1f, 1g, 1h, 1i, 1j, 1k, 1m, 1n, 1o), **characterized by** comprising:
a magnetic core assembly (2) comprising a first magnetic part (21) and a second magnetic part (22) arranged independently; and
a winding assembly comprising a first winding, wherein the first winding is wound around the first magnetic part (21),
wherein at least a portion of a substrate (3) is formed as the first winding, and the substrate (3) comprises a first accommodation space (31), a second accommodation space (32) and a first metal structure (34, 81), wherein at least a portion of the first metal structure (34, 81) is formed as at least a portion of the first winding, at least a portion of the first magnetic part (21) and at least a portion of the second magnetic part (22) are disposed within the first accommodation space (31) and the second accommodation space (32) respectively, and the substrate (3) has an integral structure.

2. The magnetic element (1, 1a, 1b, 1c, 1d, 1e, 1f, 1g, 1h, 1i, 1j, 1k, 1m, 1n, 1o) according to claim 1, wherein the magnetic core assembly (2) further comprises a third magnetic part (23) and a fourth magnetic part (24), wherein the first magnetic part (21) and the second magnetic part (22) are arranged between the third magnetic part (23) and the fourth magnetic part (24), two ends of the third magnetic part (23) are respectively connected with a first end of the first magnetic part (21) and a first end of the second magnetic part (22), and two ends of the fourth magnetic part (24) are respectively connected with a second end of the first magnetic part (21) and a second end of the second magnetic part (22).

3. The magnetic element (1, 1a, 1b, 1c, 1d, 1e, 1f, 1g, 1h, 1i, 1j, 1k, 1m, 1n, 1o) according to claim 2, wherein the substrate (3) further comprises a first opening (35) and a second opening (36), wherein the first opening (35) is located at a first side (301) of the substrate (3), the second opening (36) is located at a second side (302) of the substrate (3), the first accommodation space (31) and the second accommodation space (32) are arranged between the first opening (35) and the second opening (36), the first opening (35) is in communication with the first accommodation space (31) and the second accommodation space (32), the second opening (36) is in communication with the first accommodation space (31) and the second accommodation space (32), at least a portion of the third magnetic part (23) is disposed within the first opening (35), and at least a portion of the fourth magnetic part (24) is disposed within the second opening (36).

4. The magnetic element (1, 1a, 1b, 1c, 1d, 1e, 1f, 1g, 1h, 1i, 1j, 1k, 1m, 1n, 1o) according to claim 2, wherein the third magnetic part (23) and the fourth magnetic part (24) are located outside the substrate (3).

5. The magnetic element (1, 1a, 1b, 1c, 1d, 1e, 1f, 1g, 1h, 1i, 1j, 1k, 1m, 1n, 1o) according to claim 2, wherein the first magnetic part (21), the second magnetic part (22), the third magnetic part (23) and the fourth magnetic part (24) are arranged independently.

6. The magnetic element (1, 1a, 1b, 1c, 1d, 1e, 1f, 1g, 1h, 1i, 1j, 1k, 1m, 1n, 1o) according to claim 2, wherein the first magnetic part (21) and the third magnetic part (23) are integrally formed as an integral structure, and the second magnetic part (22) and the fourth magnetic part (24) are integrally formed as another integral structure.

7. The magnetic element (1, 1a, 1b, 1c, 1d, 1e, 1f, 1g, 1h, 1i, 1j, 1k, 1m, 1n, 1o) according to claim 2, wherein the substrate (3) further comprises a first opening (35), wherein the first opening (35) is located at a first side (301) of the substrate (3), and the first opening (35) is in communication with the first accommodation space (31) and the second accommodation space (32), wherein at least a portion of the third magnetic part (23) is disposed within the first opening (35), a second side (302) of the substrate (3) has no opening, and the fourth magnetic part (24) is pre-embedded in the second side (302) of the substrate (3).

8. The magnetic element (1, 1a, 1b, 1c, 1d, 1e, 1f, 1g, 1h, 1i, 1j, 1k, 1m, 1n) according to claim 1, wherein the substrate (3) comprises a first horizontal wiring layer (m) and a second horizontal wiring layer (n), and the first horizontal wiring layer (m) and the second horizontal wiring layer (n) are opposite to each other with respect to the first magnetic part (21), wherein the first metal structure (34) comprises a first horizontal copper foil (34a), a second horizontal copper foil (34b), a first connection copper foil (34c) and a second connection copper foil (34d), wherein the first horizontal copper foil (34a), the first connection copper foil (34c), the second horizontal copper foil (34b) and the second connection copper foil (34d) are connected with each other and arranged around the first magnetic part (21), wherein the first connection copper foil (34c) and the second connection copper foil (34d) are arranged between the first horizontal copper foil (34a) and the second horizontal copper foil (34b), wherein the first horizontal copper foil (34a) is formed in the first horizontal wiring layer (m), and the second horizontal copper foil (34b) is formed in the second horizontal wiring layer (n).

9. The magnetic element (1, 1a, 1b, 1c, 1d, 1e, 1f, 1g, 1h, 1i, 1j, 1k, 1m, 1n) according to claim 8, wherein at least a portion of the first metal structure (34) is formed on an inner wall of the first accommodation space (31).

10. The magnetic element (1j, 1k, 1m, 1n) according to claim 9, wherein the first metal structure (34) is formed on the inner wall of the first accommodation space (31) completely.

11. The magnetic element (1b, 1c, 1d, 1e, 1f, 1h, 1i) according to claim 8, wherein the substrate (3) further comprises a seventh horizontal wiring layer (s), the seventh horizontal wiring layer (s) is arranged between the first horizontal wiring layer (m) and the second horizontal wiring layer (n), the first metal structure (34) further comprises two first horizontal transition structures (34f), the two first horizontal transition structures (34f) are formed in the seventh horizontal wiring layer (s) and located at two sides of the first magnetic part (21), the two horizontal transition structures are respectively connected with two ends of the first horizontal copper foil (34a) through conductive posts, the two first horizontal transition structures (34f) are connected with the first connection copper foil (34c) and the second connection copper foil (34d), respectively.

12. The magnetic element (1, 1a, 1b, 1c, 1d, 1e, 1f, 1g, 1h, 1i, 1j, 1k, 1m, 1n) according to claim 8, wherein the first metal structure (34) is formed as the first winding completely.

13. The magnetic element (1, 1a, 1b, 1c, 1d, 1e, 1f, 1g, 1h, 1i, 1j, 1k, 1m, 1n) according to claim 8, wherein the substrate (3) further comprises a third horizontal wiring layer (o), a fourth horizontal wiring layer (p) and a second metal structure (37), and the third horizontal wiring layer (o) and the fourth horizontal wiring layer (p) are opposite to each other with respect to the first magnetic part (21), wherein the third horizontal wiring layer (o) is located at a side of the first horizontal wiring layer (m) away from the first accommodation space (31), and the fourth horizontal wiring layer (p) is located at a side of the second horizontal wiring layer (n) away from the first accommodation space (31), wherein the second metal structure (37) comprises a third horizontal copper foil (37a), a fourth horizontal copper foil (37b), a third connection copper foil (37c) and a fourth connection copper foil (37d), wherein the third horizontal copper foil (37a), the third connection copper foil (37c), the fourth horizontal copper foil (37b) and the fourth connection copper foil (37d) are connected with each other and arranged around the first magnetic part (21), wherein the third connection copper foil (37c) and the fourth connection copper foil (37d) are arranged between the third horizontal copper foil (37a) and the fourth horizontal copper foil (37b), the second metal structure (37) is disposed on an outer side of the first metal structure (34), wherein the third horizontal copper foil (37a) is formed in the third horizontal wiring layer (o), and the fourth horizontal copper foil (37b) is formed in the fourth horizontal wiring layer (p).

14. The magnetic element (1, 1a, 1b, 1c, 1d, 1e, 1f, 1g, 1h, 1i, 1j, 1k, 1m, 1n) according to claim 13, wherein the magnetic element (1, 1a, 1b, 1c, 1d, 1e, 1f, 1g, 1h, 1i, 1j, 1k, 1m, 1n) further comprises a second winding, and the second winding is wound around the first magnetic part (21), wherein the first metal structure (34) is formed as the first winding, and the second metal structure (37) is formed as the second winding.

15. The magnetic element (1, 1a, 1b, 1c, 1d, 1e, 1f, 1g, 1h, 1i, 1j, 1k, 1m, 1n) according to claim 13, wherein the magnetic element (1, 1a, 1b, 1c, 1d, 1e, 1f, 1g, 1h, 1i, 1j, 1k, 1m, 1n) further comprises a second winding, and the second winding is wound around the first magnetic part (21), wherein a first portion of the first metal structure (34) and a first portion of the second metal structure (37) are formed as the first winding, and a second portion of the first metal structure (34) and a second portion of the second metal structure (37) are formed as the second winding.

16. The magnetic element (1, 1a, 1b, 1c, 1d, 1e, 1f, 1g, 1h, 1i, 1j, 1k, 1m, 1n) according to claim 13, wherein the substrate (3) further comprises a fifth horizontal wiring layer (q), a sixth horizontal wiring layer (r) and a third metal structure (38), and the fifth horizontal wiring layer (q) and the sixth horizontal wiring layer (r) are opposite to each other with respect to the first magnetic part (21), wherein the fifth horizontal wiring layer (q) is located at a side of the third horizontal wiring layer (o) away from the first accommodation space (31), and the sixth horizontal wiring layer (r) is located at a side of the fourth horizontal wiring layer (p) away from the first accommodation space (31), wherein the third metal structure (38) comprises a fifth horizontal copper foil (38a), a sixth horizontal copper foil (38b), a fifth connection copper foil (38c) and a sixth connection copper foil (38d), wherein the fifth horizontal copper foil (38a), the fifth connection copper foil (38c), the sixth horizontal copper foil (38b) and the sixth connection copper foil (38d) are connected with each other and arranged around the first magnetic part (21), wherein the fifth connection copper foil (38c) and the sixth connection copper foil (38d) are arranged between the fifth horizontal copper foil (38a) and the sixth horizontal copper foil (38b), wherein the third metal structure (38) is located at an outer side of the second metal structure (37), the fifth horizontal copper foil (38a) is formed in the fifth horizontal wiring layer (q), and the sixth horizontal copper foil (38b) is formed in the sixth horizontal wiring layer (r).

17. The magnetic element (1f) according to claim 16, wherein the substrate (3) further comprises a seventh horizontal wiring layer (s), the third metal structure (38) comprises two second horizontal transition structures (41a), two third horizontal transition structures (41b), two fourth horizontal transition structures (41d), two fifth horizontal transition structures (40a) and two sixth horizontal transition structures (34h), the two second horizontal transition structures (41a) are formed in the seventh horizontal wiring layer (s) and opposite to each other with respect to the first magnetic part (21), the two third horizontal transition structures (41b) are formed in the first horizontal wiring layer (m) and opposite to each other with respect to the first magnetic part (21), the two fourth horizontal transition structures (41d) are formed in the third horizontal wiring layer (o) and opposite to each other with respect to the first magnetic part (21), the two fifth horizontal transition structures (40a) are formed in the fourth horizontal wiring layer (p) and opposite to each other with respect to the first magnetic part (21), one of the two second horizontal transition structures (41a), one of the two third horizontal transition structures (41b), one of the two fourth horizontal transition structures (41d) and one end of the fifth horizontal copper foil (38a) are connected with each other through a first conductive part, one of the two fifth horizontal transition structures (40a) and the sixth horizontal copper foil (38b) are connected with each other through a second conductive part, one of the two second horizontal transition structures (41a) and one of the two fifth horizontal transition structures (40a) are connected with two ends of the fifth connection copper foil (38c), the other second horizontal transition structure (41a), the other third horizontal transition structure (41b), the other fourth horizontal transition structure (41d), the other end of the fifth horizontal copper foil (38a) are connected with each other through a third conductive part, the other fifth horizontal transition structure (40a) and the sixth horizontal copper foil (38b) are connected with each other through a fourth conductive part, the other second horizontal transition structure (41a) and the other fifth horizontal transition structure (40a) are connected with two ends of the sixth connection copper foil (38d).

18. The magnetic element (1, 1a, 1b, 1c, 1d, 1e, 1f, 1g, 1h, 1i, 1j, 1k, 1m, 1n) according to claim 16, wherein the magnetic element (1, 1a, 1b, 1c, 1d, 1e, 1f, 1g, 1h, 1i, 1j, 1k, 1m, 1n) further comprises a second winding and a third winding, and the second winding and the third winding are wound around the first magnetic part (21), wherein the first metal structure (34) is formed as the first winding, the second metal structure (37) is formed as the second winding, and the third metal structure (38) is formed as the third winding.

19. The magnetic element (1, 1a, 1b, 1c, 1d, 1e, 1f, 1g, 1h, 1i, 1j, 1k, 1m, 1n) according to claim 16, wherein the magnetic element (1, 1a, 1b, 1c, 1d, 1e, 1f, 1g, 1h, 1i, 1j, 1k, 1m, 1n) further comprises a second winding and a third winding, and the second winding and the third winding are wound around the first magnetic part (21), wherein the second metal structure (37) is formed as the second winding, a first portion of the first metal structure (34) and a first portion of the third metal structure (38) are formed as the first winding, the first portion of the first metal structure (34) and the first portion of the third metal structure (38) are connected with each other through a first conductive post (34g), a second portion of the first metal structure (34) and a second portion of the third metal structure (38) are formed as the third winding, and the second portion of the first metal structure (34) and the second portion of the third metal structure (38) are connected with each other through a second conductive post (41c).

20. The magnetic element (1e) according to claim 9, wherein a portion of the first metal structure (34) is formed on an inner wall of the first accommodation space (31) and divided into a plurality of segments.

21. The magnetic element (1e) according to claim 20, wherein an electroless-plating resistant layer (61a) is arranged between at least two of the plurality of segments of the first metal structure (34).

22. The magnetic element (1a) according to claim 1, wherein an edge of the first magnetic part (21) has a chamfer (21a), and the chamfer (21a) is located beside a corner of the first metal structure (34).

23. The magnetic element (1, 1a, 1b, 1c, 1d, 1e, 1f, 1g, 1h, 1i, 1j, 1k, 1m, 1n, 1o) according to claim 1, wherein the magnetic element (1, 1a, 1b, 1c, 1d, 1e, 1f, 1g, 1h, 1i, 1j, 1k, 1m, 1n, 1o) further comprises a circuit board (71) and at least one power switch (SRI, SR2), wherein the least one power switch (SRI, SR2) is disposed on the circuit board (71), and the at least one power switch (SRI, SR2) is electrically connected with the first winding.

24. The magnetic element(1, 1a, 1b, 1c, 1d, 1e, 1f, 1g, 1h, 1i, 1j, 1k, 1m, 1n, 1o) according to claim 1, wherein the magnetic element(1, 1a, 1b, 1c, 1d, 1e, 1f, 1g, 1h, 1i, 1j, 1k, 1m, 1n, 1o) further comprises a passive component (72, 73), and the passive component (72, 73) is disposed within the first accommodation space (31) or the second accommodation space (32).

25. The magnetic element (1o) according to claim 1, wherein the magnetic element further comprises a fourth metal structure (83), and a portion of the fourth metal structure (83) is attached on a portion of the first magnetic part (21).

26. The magnetic element (1, 1a, 1b, 1c, 1d, 1e, 1f, 1g, 1h, 1i, 1j, 1k, 1m, 1n) according to claim 1, wherein the magnetic element (1, 1a, 1b, 1c, 1d, 1e, 1f, 1g, 1h, 1i, 1j, 1k, 1m, 1n) further comprises an insulation structure, and the insulation structure is attached on the first magnetic part (21).

27. A method of manufacturing a magnetic element (1, 1a, 1b, 1c, 1d, 1e, 1f, 1g, 1h, 1i, 1j, 1k, 1m, 1n, 1o), **characterized by** the method comprising steps of:
(a) providing a substrate (3), wherein the substrate (3) has an integral structure, at least a portion of the substrate (3) is formed as a winding assembly of the magnetic element (1, 1a, 1b, 1c, 1d, 1e, 1f, 1g, 1h, 1i, 1j, 1k, 1m, 1n, 1o), and the substrate (3) comprises a first accommodation space (31), a second accommodation space (32) and a first metal structure (34, 81), wherein at least a portion of the first metal structure (34, 81) is formed as at least a portion of a first winding of the winding assembly; and
(b) providing a magnetic core assembly (2) comprising a first magnetic part (21) and a second magnetic part (22), wherein the first magnetic part (21) and the second magnetic part (22) are arranged independently, at least a portion of the first magnetic part (21) and at least a portion of the second magnetic part (22) are disposed within the first accommodation space (31) and the second accommodation space (32), respectively, and the first winding is wound around the first magnetic part (21).

28. The method according to claim 27, wherein the substrate (3) is formed by using a method comprising steps of:
(c1) providing a base (30a) with a recess (30b);
(c2) forming a first connection copper foil (34c), a second connection copper foil (34d) and a second horizontal copper foil (34b) on an inner wall of the recess (30b), wherein two ends of the second horizontal copper foil (34b) are respectively connected with a first end of the first connection copper foil (34c) and a first end of the second connection copper foil (34d);
(c3) forming two first horizontal transition structures (34f) on an outer side of the recess (30b), wherein one of the two first horizontal transition structures (34f) is connected with a second end of the first connection copper foil (34c), and the other first horizontal transition structure (34f) is connected with a second end of the second connection copper foil (34d);
(c4) providing a top plate (30c) on the base (30a) to cover the recess (30b), wherein the first accommodation space (31) is defined by the base (30a) and the top plate (30c) collaboratively, and the two first horizontal transition structures (34f) are disposed between the top plate (30c) and the base (30a);
(c5) forming a first horizontal copper foil (34a) on the top plate (30c), wherein two ends of the first horizontal copper foil (34a) are respectively connected with corresponding one of the two first horizontal transition structures (34f) through a conductive post, wherein the first connection copper foil (34c), the second connection copper foil (34d), the second horizontal copper foil (34b), the two first horizontal transition structures (34f), the first horizontal copper foil (34a) and the conductive post are collaboratively defined as the first metal structure (34);
(c6) forming a third horizontal copper foil (37a) on the top plate (30c), and forming a fourth horizontal copper foil (37b) on the base (30a), wherein the third horizontal copper foil (37a) and the fourth horizontal copper foil (37b) are opposite to each other with respect to the first accommodation space (31);
(c7) forming a third connection copper foil (37c) and a fourth connection copper foil (37d) in the base (30a), wherein the third connection copper foil (37c) is connected between a first end of the third horizontal copper foil (37a) and a first end of the fourth horizontal copper foil (37b), the fourth connection copper foil (37d) is connected between a second end of the third horizontal copper foil (37a) and a second end of the fourth horizontal copper foil (37b), wherein the third connection copper foil (37c), the fourth connection copper foil (37d), the third horizontal copper foil (37a) and the fourth horizontal copper foil (37b) are collaboratively defined as a second metal structure (37); and
(c8) forming a fifth horizontal copper foil (38a), a sixth horizontal copper foil (38b), a fifth connection copper foil (38c) and a sixth connection copper foil (38d) on an outside of the second metal structure (37), wherein the fifth connection copper foil (38c) is connected between a first end of the fifth horizontal copper foil (38a) and a first end of the sixth horizontal copper foil (38b), and the sixth connection copper foil (38d) is connected between a second end of the fifth horizontal copper foil (38a) and a second end of the sixth horizontal copper foil (38b), wherein the fifth horizontal copper foil (38a), the sixth horizontal copper foil (38b), the fifth connection copper foil (38c) and the sixth connection copper foil (38d) are collaboratively formed as a third metal structure (38), and the first metal structure (34), the second metal structure (37), the third metal structure (38), the base (30a) and the top plate (30c) are collaboratively formed as the substrate (3).

29. The method according to claim 27, wherein the substrate (3) is formed by using a method comprising steps of:
(c1) providing a base (30a) with a recess (30b);
(c2) providing a top plate (30c) on the base (30a) to cover the recess (30b), wherein the first accommodation space (31) is defined by the base (30a) and the top plate (30c) collaboratively;
(c3) forming a first horizontal copper foil (34a) on the top plate (30c) and forming a second horizontal copper foil (34b) on the base (30a), wherein the first horizontal copper foil (34a) and the second horizontal copper foil (34b) are opposite to each other with respect to the first accommodation space (31);
(c4) forming a first connection copper foil (34c) and a second connection copper foil (34d) in the base (30a), wherein the first connection copper foil (34c) is connected between a first end of the first horizontal copper foil (34a) and a first end of the second horizontal copper foil (34b), and the second connection copper foil (34d) is connected between a second end of the first horizontal copper foil (34a) and a second end of the second horizontal copper foil (34b), wherein the first connection copper foil (34c), the second connection copper foil (34d), the first horizontal copper foil (34a) and the second horizontal copper foil (34b) are collaboratively defined as the first metal structure (34);
(c5) forming a third horizontal copper foil (37a) on the top plate (30c) and forming a fourth horizontal copper foil (37b) on the base (30a), wherein the third horizontal copper foil (37a) and the fourth horizontal copper foil (37b) are opposite to each other with respect to the first accommodation space (31);
(c6) forming a third connection copper foil (37c) and a fourth connection copper foil (37d) in the base (30a), wherein the third connection copper foil (37c) is connected between a first end of the third horizontal copper foil (37a) and a first end of the fourth horizontal copper foil (37b), and the fourth connection copper foil (37d) is connected between a second end of the third horizontal copper foil (37a) and a second end of the fourth horizontal copper foil (37b), wherein the third horizontal copper foil (37a), the fourth horizontal copper foil (37b), the third connection copper foil (37c) and the fourth connection copper foil (37d) are collaboratively defined as a second metal structure (37); and
(c7) forming a fifth horizontal copper foil (38a), a sixth horizontal copper foil (38b), a fifth connection copper foil (38c) and a sixth connection copper foil (38d) on an outside of the second metal structure (37) to cover the second metal layer, wherein the fifth connection copper foil (38c) is connected between a first end of the fifth horizontal copper foil (38a) and a first end of the sixth horizontal copper foil (38b), and the sixth connection copper foil (38d) is connected between a second end of the fifth horizontal copper foil (38a) and a second end of the sixth horizontal copper foil (38b), wherein the fifth horizontal copper foil (38a), the sixth horizontal copper foil (38b), the fifth connection copper foil (38c) and the sixth connection copper foil (38d) are collaboratively formed as a third metal structure (38), and the first metal structure (34), the second metal structure (37), the third metal structure (38), the base (30a) and the top plate (30c) are collaboratively formed as the substrate (3).

30. The method according to claim 27, wherein the substrate (3) comprises a top plate (30c) and a base (30a), the base (30a) comprises a bottom structure (30f) and a plurality of lateral walls, the plurality of lateral walls comprises a first lateral wall (30g) and a second lateral wall (30h), the plurality of lateral walls are arranged between the top plate (30c) and the base (30a), wherein the substrate (3) is formed by using a method comprising steps of:
(c1) forming two first horizontal transition structures (34f), two second horizontal transition structures (41a), a first connection copper foil (34c) and a second connection copper foil (34d), wherein one of the two first horizontal transition structures (34f) is arranged between the top plate (30c) and the first lateral wall (30g), the other first horizontal transition structure (34f) is arranged between the top plate (30c) and the second lateral wall (30h), one of the two second horizontal transition structures (41a) is arranged between the base (30a) and the first lateral wall (30g), the other second horizontal transition structure (41a) is arranged between the base (30a) and the second lateral wall (30h), the first connection copper foil (34c) is disposed on an inner wall of the first lateral wall (30g) and connected between one of the two first horizontal transition structures (34f) and one of the two second horizontal transition structures (41a), and the second connection copper foil (34d) is disposed on the inner wall of the first lateral wall (30g) and connected between the other first horizontal transition structure (34f) and the other second horizontal transition structure (41a);
(c2) forming a first horizontal copper foil (34a) and a third horizontal copper foil (37a) on two sides of the top plate (30c), wherein the first horizontal copper foil (34a) is arranged between the top plate (30c) and the two first horizontal transition structures (34f);
(c3) forming a second horizontal copper foil (34b) and a fourth horizontal copper foil (37b) on two sides of the base (30a), wherein the first horizontal copper foil (34a), the second horizontal copper foil (34b), the two first horizontal transition structures (34f), the two second horizontal transition structures (41a), the first connection copper foil (34c) and the second connection copper foil (34d) are collaboratively defined as the first metal structure (34);
(c4) forming a plurality of through holes, a plurality of first blind holes (50c) and a plurality of second blind holes (50d), wherein each of the plurality of through holes is connected between the third horizontal copper foil (37a) and the fourth horizontal copper foil (37b), each of the plurality of first blind holes (50c) is connected between the third horizontal copper foil (37a), the first horizontal copper foil (34a) and the corresponding first horizontal transition structure (34f), and each of the plurality of second blind holes (50d) is connected between the fourth horizontal copper foil (37b), the second horizontal copper foil (34b) and the corresponding second horizontal transition structure (41a);
(c5) forming a plurality of first conductive posts (34g), a plurality of second conductive posts (41c) and a plurality of third conductive posts (41e), wherein each of the plurality of first conductive posts (34g) is disposed in corresponding one of the plurality of through holes, each of the plurality of second conductive posts (41c) is disposed in corresponding one of the plurality of first blind holes (50c), and each of the plurality of third conductive posts (41e) is disposed in corresponding one of the plurality of second blind holes (50d);
(c6) removing portions of the plurality of second conductive posts (41c) through a back-drilling process and forming a plurality of first back-drill holes (50e), removing portions of the plurality of third conductive posts (41e) through the back-drilling process and forming a plurality of second back-drill holes (50f), wherein the third horizontal copper foil (37a) and the first horizontal copper foil (34a) are not electrically connected with each other, and the fourth horizontal copper foil (37b) and the second horizontal copper foil (34b) are not electrically connected with each other, wherein the third horizontal copper foil (37a), the fourth horizontal copper foil (37b) and the plurality of first conductive posts (34g) are collaboratively defined as a second metal structure (37); and
(c7) forming a fifth horizontal copper foil (38a), a sixth horizontal copper foil (38b), a fifth connection copper foil (38c) and a sixth connection copper foil (38d) on an outside of the second metal structure (37), wherein the fifth connection copper foil (38c) is connected between a first end of the fifth horizontal copper foil (38a) and a first end of the sixth horizontal copper foil (38b), and the sixth connection copper foil (38d) is connected between a second end of the fifth horizontal copper foil (38a) and a second end of the sixth horizontal copper foil (38b), wherein the fifth horizontal copper foil (38a), the sixth horizontal copper foil (38b), the fifth connection copper foil (38c) and the sixth connection copper foil (38d) are collaboratively formed as a third metal structure (38), and the first metal structure (34), the second metal structure (37), the third metal structure (38), the base (30a) and the top plate (30c) are collaboratively formed as the substrate (3).

31. The method according to claim 27, wherein the substrate (3) is formed by using a method comprising steps of:
(c1) providing a base (30a) with a recess (30b) and forming a second horizontal copper foil (34b), a first connection copper foil (34c) and a second connection copper foil (34d) on an inner wall of the recess (30b);
(c2) providing a top plate (30c) on the base (30a) to cover the recess (30b), forming a third horizontal copper foil (37a) on a first side of the top plate (30c), and forming an electroless-plating resistant layer (61a) and a first horizontal copper foil (34a) on a second side of the top plate (30c), wherein the first accommodation space (31) is defined by the base (30a) and the top plate (30c) collaboratively, the first horizontal copper foil (34a), the second horizontal copper foil (34b), the first connection copper foil (34c), the second connection copper foil (34d) and the electroless-plating resistant layer (61a) are disposed within the first accommodation space (31), a first gap is formed between a first portion of the first horizontal copper foil (34a) and the first connection copper foil (34c), and a second gap is formed between a second portion of the first horizontal copper foil (34a) and the second connection copper foil (34d);
(c3) forming a fourth horizontal copper foil (37b) on the base (30a) and forming a third connection copper foil (37c) and a fourth connection copper foil (37d) in the base (30a), wherein the third horizontal copper foil (37a) and the fourth horizontal copper foil (37b) are opposite to each other with respect to the first accommodation space (31), the third connection copper foil (37c) is connected between a first end of the third horizontal copper foil (37a) and a first end of the fourth horizontal copper foil (37b), and the fourth connection copper foil (37d) is connected between a second end of the third horizontal copper foil (37a) and a second end of the fourth horizontal copper foil (37b), wherein the third horizontal copper foil (37a), the fourth horizontal copper foil (37b), the third connection copper foil (37c) and the fourth connection copper foil (37d) are collaboratively defined as a second metal structure (37);
(c4) filling the first gap and the second gap with copper foils, respectively, so that the first horizontal copper foil (34a) is connected with the first connection copper foil (34c) and the second connection copper foil (34d), wherein the first connection copper foil (34c), the second connection copper foil (34d), the first horizontal copper foil (34a) and the second horizontal copper foil (34b) are collaboratively defined as the first metal structure (34); and
(c5) forming a fifth horizontal copper foil (38a), a sixth horizontal copper foil (38b), a fifth connection copper foil (38c) and a sixth connection copper foil (38d) on an outside of the second metal structure (37) to cover the second metal structure (37), wherein the fifth connection copper foil (38c) is connected between a first end of the fifth horizontal copper foil (38a) and a first end of the sixth horizontal copper foil (38b), and the sixth connection copper foil (38d) is connected between a second end of the fifth horizontal copper foil (38a) and a second end of the sixth horizontal copper foil (38b), wherein the fifth horizontal copper foil (38a), the sixth horizontal copper foil (38b), the fifth connection copper foil (38c) and the sixth connection copper foil (38d) are collaboratively formed as a third metal structure (38), and the first metal structure (34), the second metal structure (37), the third metal structure (38), the base (30a) and the top plate (30c) are collaboratively formed as the substrate (3).
